# EUROPEAN PATENT SPECIFICATION

(11) **EP 1 514 357 B1**
(45) Date of publication and mention of the grant of the patent: **22.08.2012**
(21) Application number: 02746646.5
(22) Date of filing: 21.06.2002
(51) Int. Cl.: H03M 11/00, G06K 9/18, G06F 17/27, G06F 3/023

(54) **EXPLICIT CHARACTER FILTERING OF AMBIGUOUS TEXT ENTRY**
EXPLIZITE ZEICHENFILTERUNG MEHRDEUTIGER TEXTEINGABEN
FILTRAGE EXPLICITE DE LETTRES D'UNE ENTREE DE TEXTE AMBIGUE

(30) Priority: 20.06.2002 US 176933
(43) Date of publication of application: 16.03.2005
(73) Proprietor: America Online Incorporated, Dulles, VA 20166 (US)
(72) Inventor: BRADFORD, Ethan, Robert, Seattle, WA 98103 (US); HULLFISH, Keith, Charles, Snohomish, WA 98296 (US); KAY, David, J., Seattle, WA 98103 (US); MEURS, Pim Van, Seattle, WA 98125 (US); LONGE, Michael, R., Seattle, WA 98117 (US)
(74) Representative: Schoppe, Fritz
(86) International application number: PCT/US2002/019926
(87) International publication number: WO 2004/001979

(56) References cited:
- WO-A-00/35091
- US-A- 4 544 276
- US-A- 4 791 556
- US-A- 5 586 198
- US-A- 5 623 261
- US-A- 5 642 522
- US-A- 5 818 437
- US-A- 5 828 991
- US-A- 5 847 697
- US-B1- 6 172 625
- US-B1- 6 307 548
- 'Novice-to-novice: keybords, consoles and VT cruising' LINUX JOURNAL vol. 1996, no. 31, November 1996, pages 1 - 9, XP002957735

## Description

### BACKGROUND OF THE INVENTION

### TECHNICAL FIELD

The invention relates to text input technology. More specifically, the invention relates to text entry solutions to wireless communication devices with limited keypads.

### DESCRIPTION OF THE PRIOR ART

For many years, portable computers have been getting smaller and smaller. The principal size-limiting component in the effort to produce a smaller portable computer has been the keyboard. If standard typewriter-size keys are used, the portable computer must be at least as large as the keyboard. Miniature keyboards have been used on portable computers, but the miniature keyboard keys have been found to be too small to be easily or quickly manipulated by a user.

Incorporating a full-size keyboard in a portable computer also hinders true portable use of the computer. Most portable computers cannot be operated without placing the computer on a flat work surface to allow the user to type with both hands. A user cannot easily use a portable computer while standing or moving. In the latest generation of small portable computers, called Personal Digital Assistants (PDAs) or palm-sized computers, companies have attempted to address this problem by incorporating handwriting recognition software in the device. A user may directly enter text by writing on a touch-sensitive panel or screen. This handwritten text is then converted by the recognition software into digital data. Unfortunately, in addition to the fact that printing or writing with a pen is in general slower than typing, the accuracy and speed of the handwriting recognition software has to date been less than satisfactory. In the case of the Japanese language, with its large number of complex characters, the problem becomes especially difficult. To make matters worse, today's handheld computing devices which require text input are becoming smaller still. Recent advances in two-way paging, cellular telephones, and other portable wireless technologies has led to a demand for small and portable two-way messaging systems, and especially for systems which can both send and receive electronic mail ("e-mail").

It would therefore be advantageous to develop a keyboard for entry of text into a computer device that is both small and operable with one hand while the user is holding the device with the other hand. Prior development work has considered use of a keyboard that has a reduced number of keys. As suggested by the keypad layout of a touch-tone telephone, many of the reduced keyboards have used a 3-by-4 array of keys. A number of the keys in the array are associated with multiple characters. There is therefore a need for a method for the user to indicate which of the characters associated with a given key is the desired character.

One suggested approach for unambiguously specifying hiragana characters entered on a reduced keyboard requires the user to enter two or more keystrokes to specify each kana. The keystrokes may be entered either simultaneously (chording) or in sequence (multiple-stroke specification). Neither chording nor multiple-stroke specification has produced a keyboard having adequate simplicity and efficiency of use. Multiple-stroke specification is inefficient, and chording is often complicated to learn and use.

Each syllable in the Japanese syllabary consists of either a single vowel, or a consonant followed by a vowel. There are two exceptions: the syllable which has no vowel, and the "small" 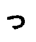 which is used to indicate the "doubling" or "hardening" of the pronunciation of the following consonant. These syllables can be written as hiragana (commonly used when writing native Japanese words) or katakana (commonly used when writing words of foreign origin). The term kana is used to refer to either hiragana or katakana. The syllabary is commonly represented as a table of rows and columns (shown in Table 1), wherein each row may have up to five entries in columns corresponding to the five Japanese vowels 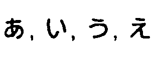 , and 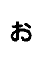 . Each row corresponds to an initial consonant, although a given consonant may undergo sound changes for certain entries in a row (e.g. s(a) 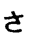 => sh(i) 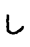 ; t(a) 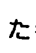 => ts(u) 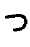 ; etc.). The first row consists of five syllables corresponding to each of the five vowels with no initial consonant. The 8^{th} row consists of the palatalized vowels 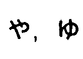 , and 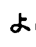 and (YI and YE are not used in modern Japanese). The diacritic marks " and ° are used to indicate changes in the pronunciation of the consonant, generally indicating a change from an unvoiced to a voiced consonant. Table 2 shows the basic syllables formed by adding the diacritic marks " and ° to syllables in Table 1. Smaller versions of the syllables 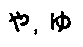 and 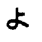 are also used in combination with syllables in the second, or " 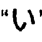 " columns of Tables 1 and 2 to represent syllables consisting of the corresponding consonant and the palatalized vowel (e.g. 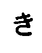 followed by "small" 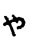 to represent 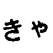 ). These syllables with palatalized vowels are thus written as a pair of kana, as shown in Table 3, which includes forms written with diacritic marks.

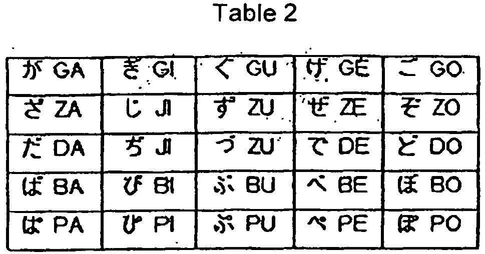

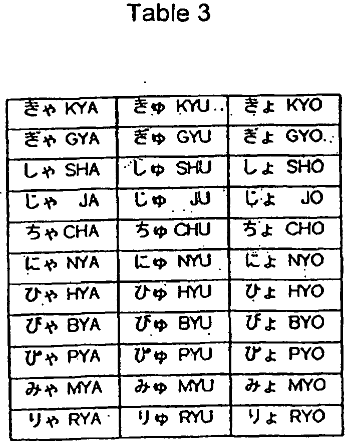

Lexicographic order in Japanese is generally represented by the sequence of syllables in the first column (corresponding to the vowel A) of Table 1: 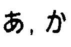 , 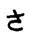 , 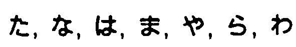 , and 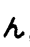 , where each of these syllables (except 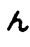 ) represents a sub-class of up to five syllables composed from the vowels 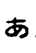 , 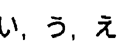 , and 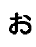 , in that order. Currently, products such as cellular telephones that require Japanese text input generally use a multiple-stroke specification method wherein each of nine keys is associated with each of the first nine rows ( 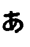 through 5). Multiple strokes on a key are used to indicate which of the syllables of the corresponding row is intended, wherein each additional stroke on a key sequentially changes the character to be output to the character appearing in the next column of Table 1 or 2. A separating key or a timeout method is used to allow entry of consecutive characters associated with the same key. A tenth key is used for the syllables 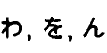 , and the katakana "bo" symbol, which indicates a vowel-only syllable that repeats the vowel of the preceding syllable. The "small" 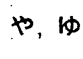 , and 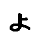 are also associated with the 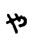 key, requiring additional keystrokes to be selected. An additional key is commonly used to add the diacritic marks following a syllable.

Entering Japanese hiragana (or katakana) using a reduced keyboard continues to be a challenging problem. With the current multi-stroking approach as described above, generating a single kana syllable requires an average of at least three keystrokes. Syllables with palatalized vowels which are represented by two characters (i.e. those in Table 3 consisting of a syllable from the second, or " 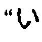 ", column of Tables 1 and 2, followed by a "small" 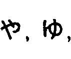 or 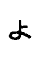 ) can require up to eight keystrokes to generate. It would therefore be desirable to develop a reduced keyboard system that tends to minimize the number of keystrokes required to enter hiragana, and is also simple and intuitive to use.

Typing standard Japanese text, which includes Chinese characters (kanji) in addition to kana, on a reduced keyboard is an even more challenging problem. Entering text on a standard computer with a full keyboard and a large display is generally achieved by first typing the pronunciation of the desired text using the letters of the Latin alphabet (called "romaji" in Japanese) corresponding to each hiragana syllable as shown in Tables 1 - 3. As the letters are typed, the input is automatically converted to the corresponding hiragana syllables and displayed on the screen. In many cases, the user then needs to convert the text which is initially displayed as hiragana into the specific textual interpretation desired. The hiragana that are displayed represent the phonetic reading of the combination of kanji and hiragana that the user actually wants to enter, and which conveys the user's intended meaning. Due to the large number of homophones in the Japanese language, there can be a number of possible meaningful combinations of kanji and hiragana that correspond to the hiragana input by the user. On a standard computer, a number of these alternative conversions can be displayed where, for example, each alternative is associated with a numeric key so that pressing the key converts the input hiragana to the displayed kanji interpretation. Additional complications arise when trying to implement this process on a small hand-held device due to the limited display size and the small number of keys available.

An alternative approach for specifying hiragana entered on a reduced keyboard allows the user to enter each hiragana with a single keystroke. Each key of the reduced keyboard is associated with multiple hiragana characters. As a user enters a sequence of keys, there is therefore ambiguity in the resulting output since each keystroke may indicate one of several hiragana. The system must therefore provide a means by which the user can efficiently indicate which of the possible interpretations of each keystroke was intended. Several approaches have been suggested for resolving the ambiguity of the keystroke sequence.

A number of suggested approaches for determining the correct character sequence that corresponds to an ambiguous keystroke sequence are summarized in the article "Probabilistic Character Disambiguation for Reduced Keyboards Using Small Text Samples," published in the Journal of the International Society for Augmentative and Alternative Communication by John L. Arnott and Muhammad Y. Javad (hereinafter the "Amott article"). The Arnott article notes that the majority of disambiguation approaches employ known statistics of character sequences in the relevant language to resolve character ambiguity in a given context. That is, existing disambiguating systems statistically analyze ambiguous keystroke groupings as they are being entered by a user to determine the appropriate interpretation of the keystrokes. The Arnott article also notes that several disambiguating systems have attempted to use word level disambiguation to decode text from a reduced keyboard. Word level disambiguation processes complete words by comparing the entire sequence of received keystrokes with possible matches in a dictionary after the receipt of an unambiguous character signifying the end of the word. The Arnott article discusses many of the disadvantages of word-level disambiguation. For example, word level disambiguation oftentimes fails to decode a word correctly, because of the limitations in identifying unusual words and the inability to decode words that are not contained in the dictionary. Because of the decoding limitations, word level disambiguation does not give error-free decoding of unconstrained English text with an efficiency of one keystroke per character. The Arnott article therefore concentrates on character level disambiguation rather than word level disambiguation, and indicates that character level disambiguation appears to be the most promising disambiguation technique. However, in contrast to alphabetic languages, each hiragana character in Japanese represents a syllable, rather than a single letter that represents what is essentially a phoneme. For this reason, character level disambiguation is inefficient in the Japanese language because there are almost no constraints on possible sequences of hiragana, and the probability distribution of hiragana sequences is not skewed enough for this approach to be effective.

Still another suggested approach is disclosed in a textbook entitled Principles of Computer Speech, authored by I. H. Witten, and published by Academic Press in 1982 (hereinafter the "Witten approach"). Witten discusses a system for reducing ambiguity from text entered using a telephone touch pad. Witten recognizes that for approximately 92% of the words in a 24,500 word English dictionary, no ambiguity will arise when comparing the keystroke sequence with the dictionary. When ambiguities do arise, however, Witten notes that they must be resolved interactively by the system presenting the ambiguity to the user and asking the user to make a selection between the number of ambiguous entries. A user must therefore respond to the system's prediction at the end of each word. Such a response slows the efficiency of the system and increases the number of keystrokes required to enter a given segment of text.

In the case of the Japanese language, users of word processing software are accustomed to having to select from a number of ambiguous interpretations following the entry of a word due to the large number of homophones in the language. The same sequence of kana can frequently be converted to two or more different kanji interpretations. Thus, after entering a sequence of kana, the user is generally required to select the desired kanji conversion from a set of possible choices, and often is also required to somehow confirm that the correct conversion was selected. When the hiragana are entered using a reduced keyboard, there is also ambiguity as to what the user actually intends as the sequence of hiragana to be converted to kanji. As a result, the number of possible interpretations is greatly increased.

Disambiguating an ambiguous keystroke sequence continues to be a challenging problem. As noted in the publications discussed above, satisfactory solutions that minimize the number of keystrokes required to enter a segment of text have failed to achieve the necessary efficiencies to be acceptable for use in a portable computer. It would therefore be desirable to develop a disambiguating system that resolves the ambiguity of entered keystrokes while minimizing the total number of keystrokes required, within the context of a simple and easy to understand user interface. Such a system would thereby maximize the efficiency of text entry.

An effective reduced keyboard input system for the Japanese language must satisfy all of the following criteria. First, the arrangement of the syllables of the Japanese language (kana) on the keyboard, and the method by which they are generated, must be easy for a native speaker to understand and learn to use. Second, the system must tend to minimize the number of keystrokes required to enter text in order to enhance the efficiency of the reduced keyboard system. Third, the system must reduce the cognitive load on the user by reducing the amount of attention and decision-making required during the input process. Fourth, the approach should minimize the amount of memory and processing resources needed to implement a practical system.

Kisaichi et al. [JP 8-314920; US 5,786,776; EP 0 732 646 A2] disclose an approach wherein the keys 1 - 0 of a telephone keypad are labeled with the hiragana syllables{ 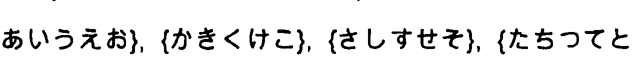 }, { 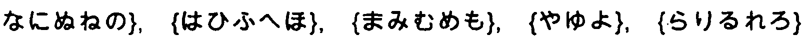 }, and { 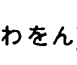 }, respectively. This corresponds to what is the de facto standard for Japanese telephone keypads wherein the keys 1 - 9 of the telephone keypad are labeled with the hiragana syllables 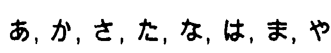 , and 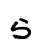 , respectively. The single hiragana appearing on each key represents the complete set of hiragana assigned to that key, corresponding to the entire row of hiragana appearing in Table 1 in which the single hiragana appears in the first column. The 0 key is often labeled explicitly with { 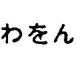 }.

Kisaichi et al. disclose a word-level disambiguation approach, wherein the user ambiguously inputs a sequence of characters (hiragana) by pressing the key with which each character is associated a single time. At the end of each input sequence, the user presses a "Conversion/Next Candidate" key to display the first textual interpretation of one of the possible sequences of hiragana associated with the input key sequence. Kisaichi et al. disclose a dictionary structure wherein all textual interpretations of a given input key sequence are stored consecutively in a contiguous block of memory. Each additional press of the "Conversion/Next Candidate" key displays the next textual interpretation stored in the dictionary, if one exists. If no more textual interpretations exist, an error message is displayed and optional anomaly processing may be performed. When the desired textual interpretation is displayed, a special "Confirmation" key must be pressed to confirm that the desired text has been displayed before the user can go on to enter the next text object.

There are a number of difficulties with the approach disclosed by Kisaichi et al. One is that, due to the fact that there is ambiguity both in specification of the hiragana string and in the conversion of each possible hiragana candidate string, there tend to be a very large number of possible textual interpretations of a given key sequence. This can require the user to step through a large number of interpretations using the "Conversion/Next Candidate" key in order to find the desired interpretation. Further, in stepping through the possible interpretations, the user sees various kanji and/or hiragana strings that correspond to a variety of hiragana strings due to the ambiguity in the input. This can be distracting, and require additional attention from the user in trying to find the desired interpretation. In addition, the database of textual interpretations is arranged such that all data consists only of complete words, and all data for all key sequences of a given length is also stored consecutively in a contiguous block of memory. Kisaichi et al. do not disclose any approach to enable the display of an appropriate stem corresponding to a longer, yet uncompleted word at those points in an input sequence that do not correspond to any completed word. At such points in the input, the system of Kisaichi et al. can only display a default indication of each key entered, such as a numeral or a default letter or character. This is confusing to the user, and fails to provide feedback which is effective in helping the user to confirm that the intended keys have been entered. Finally, the user is required to press the "Confirmation" key for each word input, having to enter an additional keystroke for each input. Thus, the system disclosed by Kisaichi et al. fails to satisfy the criteria discussed above.

Another significant challenge facing any application of word-level disambiguation is successfully implementing it on the kinds of hardware platforms on which its use is most advantageous. As mentioned above, such devices include two-way pagers, cellular telephones, and other hand-held wireless communications devices. These systems are battery powered, and consequently are designed to be as frugal as possible in hardware design and resource utilization. Applications designed to run on such systems must minimize both processor bandwidth utilization and memory requirements. These two factors tend in general to be inversely related. Since word-level disambiguation systems require a large database of words to function, and must respond quickly to input keystrokes to provide a satisfactory user interface, it would be a great advantage to be able to compress the required database without significantly impacting the processing time required to utilize it. In the case of the Japanese language, additional information must be included in the database to support the conversion of sequences of kana to the kanji intended by the user.

Another challenge facing any application of word-level disambiguation is providing sufficient feedback to the user about the keystrokes being input. With an ordinary typewriter or word processor, each keystroke represents a unique character which can be displayed to the user as soon as it is entered. But with word-level disambiguation this is often not possible, since each keystroke represents multiple characters, and any sequence of keystrokes may match multiple words or word stems. It would therefore be desirable to develop a disambiguating system that minimizes the ambiguity of entered keystrokes, and also maximizes the efficiency with which the user can resolve any ambiguity which does arise during text entry. One way to increase the user's efficiency is to provide appropriate feedback following each keystroke, which includes displaying the most likely word following each keystroke, and in cases where the current keystroke sequence does not correspond to a completed word, displaying the most likely stem of a yet uncompleted word. In order to create an effective reduced keyboard input system for the Japanese language, a system has been designed that does meet all of the criteria mentioned above. First, the arrangement of the syllables of the Japanese language (kana) on the keyboard, and the method by which they are generated, are easy for a native speaker to understand and learn to use. Second, the system tends to minimize the number of keystrokes required to enter text. Third, the system reduces the cognitive load on the user by reducing the amount of attention and decision-making required during the input process, and by the provision of appropriate feedback. Fourth, the approach disclosed herein tends to minimize the amount of memory and processing resources required to implement a practical system.

For many years, portable computers have been getting smaller and smaller. The principal size-limiting component in the effort to produce a smaller portable computer has been the keyboard. If standard typewriter-size keys are used, the portable computer must be at least as large as the keyboard. Miniature keyboards have been used on portable computers, but the miniature keyboard keys have been found to be too small to be easily or quickly manipulated by a user. Incorporating a full-size keyboard in a portable computer also hinders true portable use of the computer. Most portable computers cannot be operated without placing the computer on a flat work surface to allow the user to type with both hands. A user cannot easily use a portable computer while standing or moving.

In the latest generation of small portable computers, called Personal Digital Assistants (PDAs), companies have attempted to address this problem by incorporating handwriting recognition software in the PDA. A user may directly enter text by writing on a touch-sensitive panel or screen. This handwritten text is then converted by the recognition software into digital data. Unfortunately, in addition to the fact that printing or writing with a pen is in general slower than typing, the accuracy and speed of the handwriting recognition software has to date been less than satisfactory.

Presently, a tremendous growth in the wireless industry has spawned reliable, convenient, and very popular mobile communications devices available to the average consumer, such as cell phones, two-way pagers, PDAs, etc. These handheld wireless communications and computing devices requiring text input are becoming smaller still. Recent advances in two-way paging, cellular telephones, and other portable wireless technologies have led to a demand for small and portable two-way messaging systems, and especially for systems which can both send and receive electronic mail ("e-mail"). Some wireless communications device manufacturers also desire to provide to consumers devices with which the consumer can operate with the same hand that is holding the device.

### Disambiguation Background.

Prior development work has considered use of a keyboard that has a reduced number of keys. As suggested by the keypad layout of a touch-tone telephone, many of the reduced keyboards have used a 3-by-4 array of keys. Each key in the array of keys contains multiple characters. There is therefore ambiguity as a user enters a sequence of keys, since each keystroke may indicate one of several letters. Several approaches have been suggested for resolving the ambiguity of the keystroke sequence, referred to as disambiguation.

One suggested approach for unambiguously specifying characters entered on a reduced keyboard requires the user to enter, on average, two or more keystrokes to specify each letter. The keystrokes may be entered either simultaneously (chording) or in sequence (multiple-stroke specification). Neither chording nor multiple-stroke specification has produced a keyboard having adequate simplicity and efficiency of use. Multiple-stroke specification is inefficient, and chording is complicated to learn and use.

Other suggested approaches for determining the correct character sequence that corresponds to an ambiguous keystroke sequence are summarized in the article "Probabilistic Character Disambiguation for Reduced Keyboards Using Small Text Samples," published in the Journal of the International Society for Augmentative and Alternative Communication by John L. Arnott and Muhammad Y. Javad (hereinafter the "Arnott article"). The Arnott article notes that the majority of disambiguation approaches employ known statistics of character sequences in the relevant language to resolve character ambiguity in a given context.

Another suggested approach based on word-level disambiguation is disclosed in a textbook entitled Principles of Computer Speech, authored by I. H. Witten, and published by Academic Press in 1982 (hereinafter the "Witten approach"). Witten discusses a system for reducing ambiguity from text entered using a telephone touch pad. Witten recognizes that for approximately 92% of the words in a 24,500 word dictionary, no ambiguity will arise when comparing the keystroke sequence with the dictionary. When ambiguities do arise, however, Witten notes that they must be resolved interactively by the system presenting the ambiguity to the user and asking the user to make a selection between the number of ambiguous entries. A user must therefore respond to the system's prediction at the end of each word. Such a response slows the efficiency of the system and increases the number of keystrokes required to enter a given segment of text.

H. A. Gutowitz, *Touch-Typable Devices Based. on Ambiguous Codes and Methods to Design Such Devices,* WO 00/35091 (June 15, 2000) discloses that the design of typable devices, and, in particular, touch-type devices embodying ambiguous codes presents numerous ergonomical problems and proposes some solutions for such problems. Gutowitz teaches methods for the selection of ambiguous codes from the classes of strongly-touch-typable ambiguous codes and substantially optimal ambiguous codes for touch-typable devices such as computers, PDA's, and the like, and other information appliances, given design constraints, such as the size, shape and computational capacity of the device, the typical uses of the device, and conventional constraints such as alphabetic ordering or Qwerty ordering.

Eatoni Ergonomics Inc. provides a system called WordWise, (Copyright 2001 Eatoni Ergonomics Inc.), adapted from a regular keyboard, and where a capital letter is typed on a regular keyboard, and an auxiliary key, such as the shift key, is held down while the key with the intended letter is pressed. The key idea behind WordWise is to choose one letter from each of the groups of letters on each of the keys on the telephone keypad. Such chosen letters are typed by holding down an auxiliary key while pressing the key with the intended letter. WordWise does not use a vocabulary database/dictionary to search for words to resolve ambiguous, unambiguous, or a combination thereof entries.

Zi Corporation teaches a predictive text method, eZiText^{(R)} (2002 Zi Corporation), but does not teach nor anywhere suggest explicit text filtering in ambiguous mode,nor in combination with 2-key explicit entry, stem-locking, or n-gram searches.

US-A-5818437 relates to a reduced keyboard disambiguating computer. The keyboard has twelve keys, nine of them labeled with numerous letters and other symbols, and those nine plus one more are labeled each with one of the ten digits. Textual entry keystrokes are ambiguous. The user strikes a delimiting "select" key at the end of each word, delimiting a keystroke sequence which could match any of many words with the same number of letters. The keystroke sequence is processed with a complete dictionary, and words which match the sequence of keystrokes are presented to the user in order of decreasing frequency of use. The user selects the desired word. The letters are assigned to the keys in a non-sequential order which reduces chances of ambiguities. The same "select" key is pressed to select the desired word, and spacing between words and punctuation is automatically computed. For words which are not in the dictionary, two keystrokes are entered to specify each letter. The system simultaneously interprets all keystroke sequences as both one stroke per letter and as two strokes per letter. The user selects the desired interpretation. The system also presents to the user the number which is represented by the sequence of keystrokes for possible selection by the user.

US-B1-6307548 discloses a reduced keyboard disambiguating system. The keyboard has twelve to sixteen keys, nine of them labeled with numerous letters and other symbols, and those nine plus one more are associated each with one of the ten digits. Textual entry keystrokes are ambiguous. The user strikes a delimiting "Select" key, or a key with an unambiguous character interpretation, at the end of each word, delimiting a keystroke sequence that could match any of a plurality of words associated with the same keystroke sequence. Each input keystroke sequence is processed with a complete vocabulary, and words which match the sequence of keystrokes are presented to the user in order of decreasing frequency of use. The vocabulary is stored in a special format that supports significant data compression without requiring additional processing. In addition, stems of longer words whose initial letters match the sequence of keystrokes are also presented to the user in order of decreasing frequency of use. If the frequency of the words associated with a stem is high enough, that stem is displayed as the default word object. Activations of an ambiguous key associated with a plurality of punctuation characters are disambiguated from the context of the surrounding keystrokes.

According to US-B 1-6172625, a microprocessor receives an ambiguous input from a key and disambiguates the ambiguous input using a dictionary. The dictionary is stored in an efficient manner by being partitioned according to the first three letters of a word. A sequence of three letters in the dictionary is stored as eight bits of data, the first three letters of a word being stored using three pairs of bits, such that each pair of bits represents one of no more than four alternative letters.

US-A-4544276 discloses a method and an apparatus for typing Japanese text. The method is characterized by operator manipulation of a keyboard to produce input signals to a microprocessor. The input signals are in the form of kana, English alphabet, numerals, and punctuation, as well as delimiting signals which may be used in combination with kana input to produce corresponding text material in kanji. The microprocessor is responsive to combinations of the kana input signals and delimiting code signals to produce adjusting outputs which call up from memory signals which produce the desired kanji output. A CRT display is provided for displaying keyboard signals and, when called for, kanji symbols from memory. Where it is desired to type kanji symbols which cannot be called up by the operator through the use of kana and delimiting coding signals, alternative procedures using word analysis and graphic inputs are provided.

US-A-5642522 relates to a technique of using an electronic dictionary in conjunction with electronically-encoded running text that gives the user the most relevant information rather than belaboring the user with all possible information about a selected word. The technique maps the selected word from its inflected form to its citation form, analyzes the selected word in the context of neighboring and surrounding words to resolve ambiguities, and displays the information that is determined to be the most likely to be relevant. The dictionary preferably has information about multi-word combinations that include the selected word, and the context determination typically entails checking whether the selected word is part of a predefined multi-word combination.

US-A.5847697 discloses a character generator for a keyboard where the keyboard has keys for entry of characters. Each key is assigned a character and each of at least some of the keys are multiple-character keys assigned multiple characters. The character generator includes a generator for generating one of the characters assigned to each of a sequence of character keys that are entered on the keyboard, there being an ambiguity as to the correct character to be generated when any multiple-character key is entered in the sequence of keys. An ambiguity resolver operates in response to the sequence of character keys that have been entered for resolving the correct character for any of the multiple-character keys in the sequence of keys that are entered.

US-A-4791556 discloses a system for operating a computing machine is provided with a plurality of executable functions, each being identified by a respectively associated function symbol. The data stored in a memory of the computing machine is organized into files, each such file further containing additional data which corresponds to one of the function symbols, and a selected file name which identifies the file with respect to which the executable function is to operate. One of the function symbols in the file is selected, and execution thereof is subsequently commanded. The machine may be returned to a state which permits selection of a further executable function. Thus, the system forms a coupling between a transaction process and an execution process, in the form of a loop.

### A Need for Improvements to Current Disambiguation Methodologies.

Disambiguating an ambiguous keystroke sequence continues to be a challenging problem. A specific challenge facing disambiguation is providing sufficient feedback to the user about the keystrokes being input. With an ordinary typewriter or word processor, each keystroke represents a unique character which can be displayed to the user as soon as it is entered. But with word-level disambiguation, for example, this is often not possible, because each entry represents multiple characters, and any sequence of entries may match multiple objects, such as, words or word stems, for example. Such ambiguity is especially a problem when, for example, the user makes a spelling or entry error and the user is not certain of such error until the complete sequence is entered and the desired result is not presented. In another example, previous systems utilizing word-level disambiguation fail to provide any feedback until a predetermined selection, such as a specific key selection, is made that is recognizable by the system as a termination selection, e.g. the space key.

Moreover, some alphabets, such as Thai and Arabic, contain more letters than the alphabet for English, which leads to even greater ambiguity on a reduced number of keys. Efficient input of these languages demands a mechanism for reducing that ambiguity when needed.

Therefore, it would be advantageous to provide a disambiguating system which reduces the apparent ambiguity on the display during entry and improves the user's ability to detect and correct spelling and/or entry errors.

It would also be advantageous to provide a disambiguating system which reduces ambiguity and increases efficiency by providing explicit filtering capabilities such that a list of candidate words, word stems, sequence of symbols, and the like, is narrowed, and the user can subsequently be offered a word completion or sequence completion quicker. More specifically, it would be advantageous to allow locking in a current state of interpretation of a part of or all of previously entered characters including, but not limited to an object and/or word stems, and explicitly entered characters, thereby preventing reinterpretation of previous entries.

It would also be advantageous to build around explicitly entered characters as anchors, for the end of or beginning of new objects, words, or word stems.

It would also be advantageous to offer reasonable guesses for extending objects or words by n-gram analysis of preceding explicitly entered characters.

It would also be advantageous to reduce ambiguity and increase efficiency during the process of disambiguating a linguistic object, such as a word or word stem, for example, by preventing reinterpretation of previous entries.

It would also be advantageous to recognize common delimiters entered ambiguously or explicitly as suggesting a point connecting two separate sets of characters to suggest where the interpretation of keystrokes could be restarted.

### SUMMARY OF THE INVENTION

The present invention relates to a method and apparatus for explicit filtering in ambiguous text entry. The invention provides embodiments including various explicit text entry methodologies, such as 2-key and long pressing. The invention also provides means for matching words in a database using build around methodology, stem locking methodology, word completion methodology, and n-gram searches.

### BRIEF DESCRIPTION OF THE DRAWINGS

The foregoing aspects and many of the attendant advantages of this invention will become more readily appreciated as the same becomes better understood by reference to the following detailed description, when taken in conjunction with the accompanying drawings, wherein:

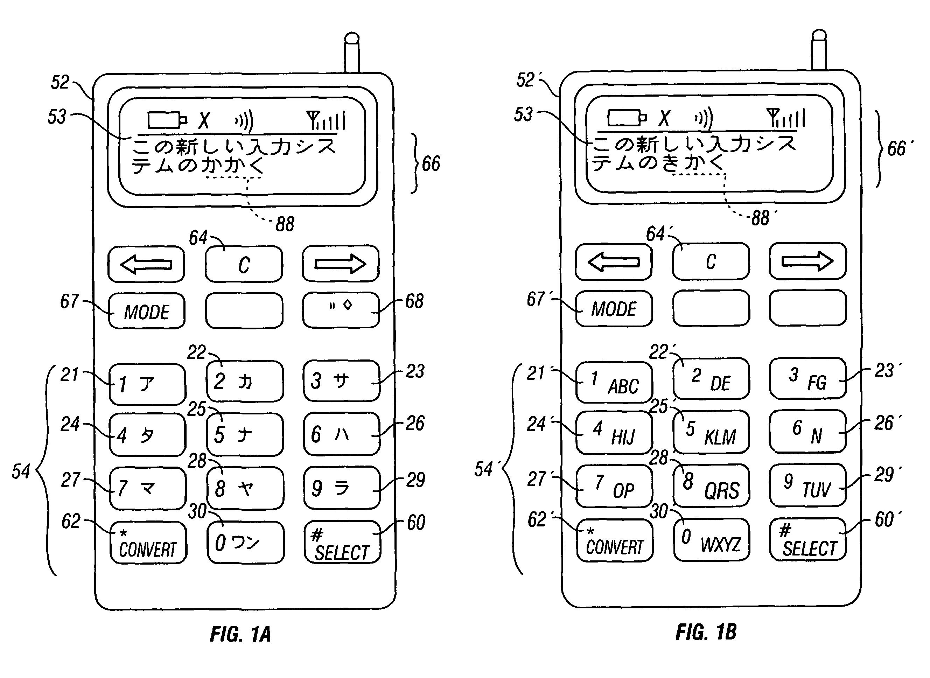

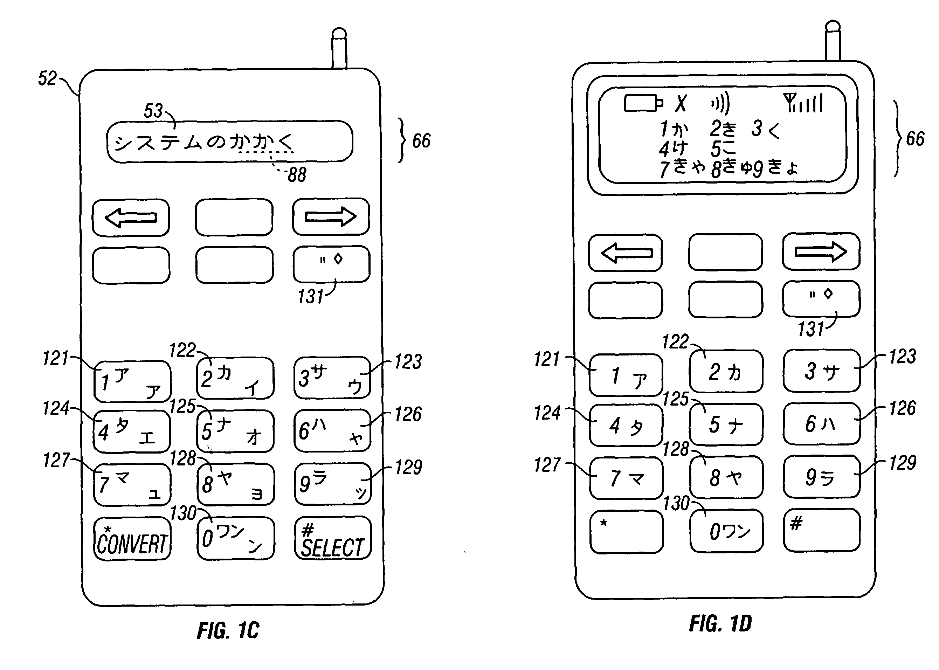

FIGURE 1 a is a schematic view of an embodiment of a cellular telephone incorporating a reduced keyboard disambiguating system of the present invention;
FIGURE 1 b is a schematic view of a cellular telephone keypad, similar to FIGURE 1 a, but wherein each of a plurality of keys is associated with one or more romaji characters;
FIGURE 1c is a schematic view of a cellular telephone keypad incorporating an embodiment of the reduced keyboard system of the present invention with limited or no display capabilities;
FIGURE 1d is a schematic view of a cellular telephone keypad incorporating an embodiment of the reduced keyboard system of the present invention with display capabilities, showing the display following an activation of key 2 as the first of an ordered pair of keystrokes in the unambiguous two-stroke method;
FIGURE 2a is a hardware block diagram of the reduced keyboard disambiguating system of FIGURE 1a;
FIGURE 2b is a schematic view of an embodiment of a portable computer touchscreen incorporating a reduced keyboard system of the present invention, showing the keypad displayed prior to the first keystroke of an ordered pair of keystrokes in the unambiguous two-stroke method;
FIGURE 2c is a schematic view of the touchscreen of FIGURE 2b, showing the keypad displayed following an activation of the key associated with the syllables _, _, _, _, and _ as the first of an ordered pair of keystrokes;
FIGURE 3 is a flow chart of an embodiment of word-level disambiguating software for a reduced keyboard disambiguating system for the Japanese language;
FIGURE 4 is a schematic view of an alternate embodiment of a portable computer touchscreen incorporating a reduced keyboard system of the present invention;
FIGURE 5 is a schematic view of yet another alternate embodiment of a portable computer touchscreen incorporating a reduced keyboard system of the present invention having nine keys;
FIGURE 6 compares the physical association of symbols to keys with an instance of a logical association including additional accented variations of the characters appearing on the physical key;
FIGURE 7 is an example of a table associating logical symbols to key indices;
FIGURE 8A depicts an internal arrangement of data in a node of a tree of a vocabulary module;
FIGURE 8B depicts the semantic components of an embodiment of a primary instruction to build a Yomikata text object;
FIGURE 8C depicts the semantic components of an embodiment of four different types of secondary instructions used to build Midashigo text objects;
FIGURE 8D depicts the semantic components of another preferred embodiment of two of the four different types of secondary instructions used to build Midashigo text objects;
FIGURE 9 depicts four examples of possible internal data items in the structure of nodes in an embodiment;
FIGURE 10 depicts the preferred tree structure of an uncompressed vocabulary module;
FIGURE 11 depicts example states of object lists, which are the preferred embodiment for intermediate storage of objects in the process of being retrieved from the vocabulary modules;
FIGURE 12 is a flowchart of a preferred embodiment of a software process for retrieving text objects from a vocabulary module given a list of key presses;
FIGURE 13 is a flowchart of an embodiment of a software process for traversing the tree structure of the vocabulary module given a single key press and altering the state of the object lists;
FIGURE 14 is a flowchart of an embodiment of a software process for building a folded, compressed vocabulary module;
FIGURE 15 is a flowchart of an embodiment of a software process for folding the tree data structure of a vocabulary module;
FIGURE 16 is a flowchart of an embodiment of a software process for locating a second node in a tree of a vocabulary module which has the greatest redundancy in comparison to a given node;
FIGURE 17 is a flowchart of an embodiment of a software process for computing the redundancy between two nodes of a tree in a vocabulary module;
FIGURE 18 is a chart showing the partial contents of the database of the present invention for a sequence of three consecutive keystrokes on a key, which is ambiguously associated with the syllables _, _, _, _, and _;
FIGURE 19 shows three representative examples of system operation, showing the contents of the text display of the system illustrated in FIGURE 1a following each keystroke on a sequence of keys entered while inputting text;
Fig. 20 is a hardware block diagram of the explicit character filtering system according of the invention;
Fig. 21 is a picture of a wireless handheld device showing each letter of the English alphabet associated with a key according to the invention;
Fig. 22 is an example chart of European letters and some special symbols shown on the 0-9 keys and their respective Shift keys according to the invention;
Fig. 23 is a sample screenshot of one 2-key matrix input method according to the invention;
Fig. 24 is a flow chart of 2-key explicit entry for the explicit character filtering in ambiguous text entry system of Fig. 20;
Fig. 25 is a flow chart for explicitly filtering in ambiguous mode according to a preferred embodiment of the invention;
Fig. 26 is a flow chart of a method for generating words not stored in the database according to the invention;
Fig. 27 shows an example of explicit entry by long-pressing on a key according to the invention; and
Fig. 28 is a flow chart depicting a build around example according to the invention.

### DETAILED DESCRIPTION OF THE INVENTION

### REDUCED KEYBOARD TEXT INPUT SYSTEM FOR THE JAPANESE LANGUAGE

### I. System Construction and Basic Operation

With reference to FIGURE 1 a, a reduced keyboard disambiguating system formed in accordance with the present invention is depicted as incorporated in a portable cellular telephone 52 having a display 53. Portable cellular telephone 52 contains a reduced keyboard 54 implemented on the standard telephone keys. For purposes of this application, the term "keyboard" is defined broadly to include any input device including a touch screen having defined areas for keys, discrete mechanical keys, membrane keys, etc. An arrangement of the kana on each key in the keyboard 54 is depicted in FIGURE 1a, corresponding to what has become a de facto standard for Japanese telephones. Note that keyboard 54 thus has a reduced number of data entry keys as compared to a standard QWERTY keyboard, or a keyboard which includes at least 46 keys, where one key is assigned for each of the kana in the basic Japanese syllabary shown in Table 1.

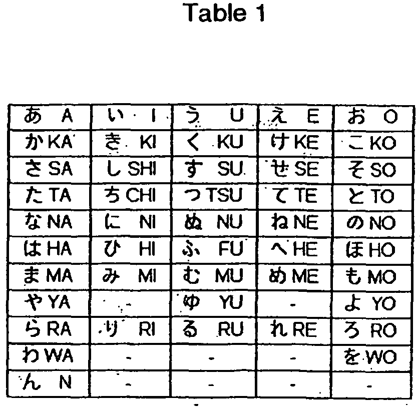

More specifically, the preferred keyboard shown in this embodiment contains ten data keys numbered 1 through 0 arranged in a 3-by-4 array, together with a Select key 60, and a Convert key 62. Optionally, the keyboard may also include a Clear key 64 to delete previous keystrokes; a Mode key 67 for entering modes to type unambiguous characters, numbers, and symbols; and a Diacritic key 68 to add dakuten and handakuten to previously entered kana.

Data are input into the disambiguation system via keystrokes on the reduced keyboard 54. In a first preferred embodiment, as a user enters a keystroke sequence using the keyboard, text is displayed on the telephone display 53. When the system is implemented on a device with limited display space, such as the cellular telephones depicted in FIGURES 1a-d, only the currently selected or most likely word object is displayed at the insertion point 88 in the text being generated. As keys are pressed in sequence to enter a desired word, the most likely word corresponding to the input sequence is displayed in some distinguishing format. In the preferred embodiment depicted in FIGURE 1a, the current word is displayed with a dotted underline. As explained in more detail below, after the Select key 60 or Convert key 62 is pressed, the dotted underline is changed to a solid underline.

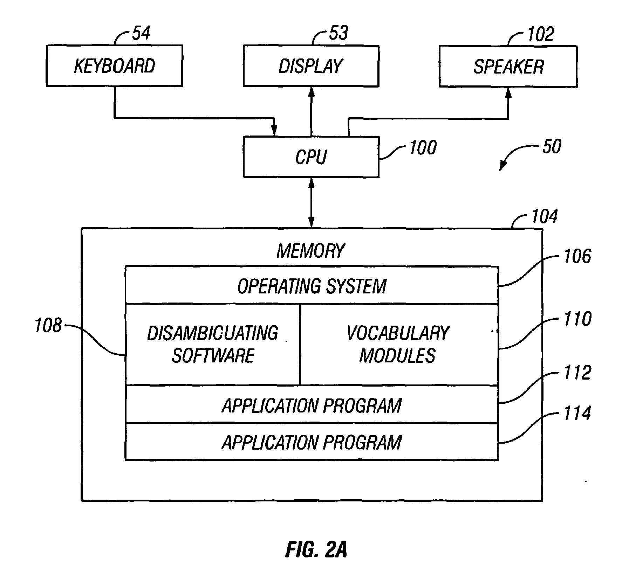

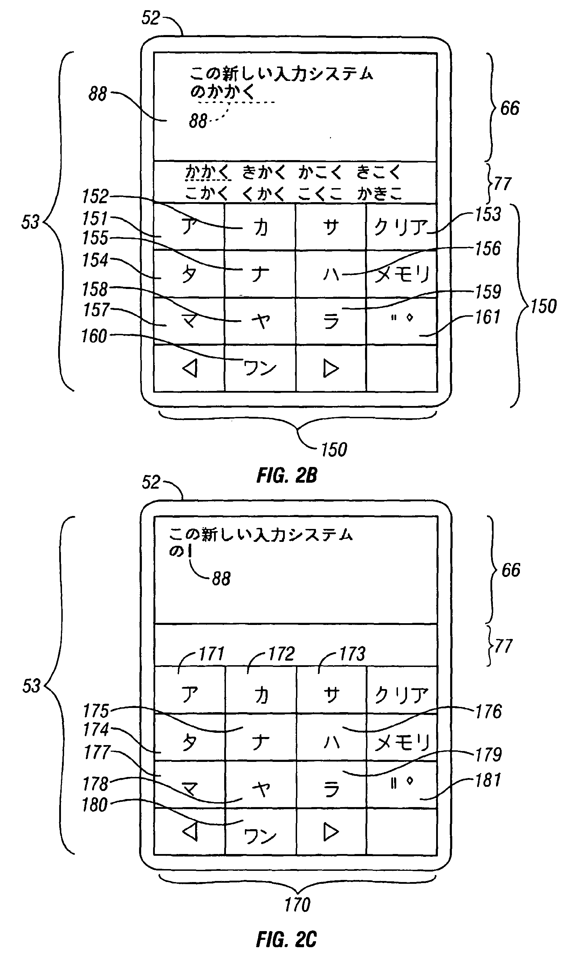

In a second preferred embodiment illustrated in FIGURES 2b and 2c, two regions are defined on the display 53 to display information to the user. A text region 66 displays the text entered by the user just as described for the first embodiment described above, serving as a buffer for text input and editing. As shown in FIGURES 2b and 2c, a selection list region 77, typically located below the text region 66, shows a list of words and other interpretations corresponding to the keystroke sequence entered by a user. The selection list region aids the user in resolving the ambiguity in the entered keystrokes by simultaneously showing both the most frequently occurring interpretation of the input keystroke sequence, and other less frequently occurring alternate interpretations displayed in descending order of frequency.

A block diagram of the reduced keyboard disambiguating system hardware is provided in FIGURE 2a. The keyboard 54 and the display 53 are coupled to a processor 100 through appropriate interfacing circuitry. Optionally, a speaker 102 is also coupled to the processor. The processor 100 receives input from the keyboard, and manages all output to the display and speaker. Processor 100 is coupled to a memory 104. The memory includes a combination of temporary storage media, such as random access memory (RAM), and permanent storage media, such as read-only memory (ROM), floppy disks, hard disks, or CD-ROMs. Memory 104 contains all software routines to govern system operation. Preferably, the memory contains an operating system 106, disambiguating software 108, and associated vocabulary modules 110 that are discussed in additional detail below. Optionally, the memory may contain one or more application programs 112, 114. Examples of application programs include word processors, software dictionaries, and foreign language translators. Speech synthesis software may also be provided as an application program, allowing the reduced keyboard disambiguating system to function as a communication aid.

Returning to FIGURE 1 a, the reduced keyboard disambiguating system allows a user to quickly enter text or other data using only a single hand. Data are entered using the reduced keyboard 54. Each of the data keys 1 through 0 has multiple meanings, represented on the top of the key by characters, numbers, and other symbols. (For the purposes of this disclosure, each data key will be identified by the number and character(s) appearing on the data key, e.g., 3_ to identify the upper right data key.) Since individual keys have multiple meanings, keystroke sequences are ambiguous as to their meaning. As the user enters data, the various keystroke interpretations are therefore displayed in multiple regions on the display to aid the user in resolving any ambiguity. On large-screen devices, a selection list of possible interpretations of the entered keystrokes is also displayed to the user in the selection list region. The first entry in the selection list is selected as a default interpretation and displayed in the text region 66 at an insertion point 88. In the preferred embodiment, this entry is displayed with a dotted underline drawn beneath it at the insertion point 88 (and in the selection list region on large-screen devices). The formatting signifies that this object is implicitly selected by virtue of being the most frequently occurring object in the current selection list. If the display includes a selection list region as in FIGURE 2b, this formatting also establishes a visual relationship between object at the insertion point 88 and the same object displayed in the selection list region 77. In FIGURE 1a, no selection list is displayed, and only the default object (the object that would be displayed first in the selection list prior to any activation of the Select key), or the currently selected object if one has been explicitly selected, is displayed at the insertion point 88.

The selection list of the possible interpretations of the entered keystrokes may be ordered in a number of ways. In a normal mode of operation, the keystrokes are initially interpreted as the entry of kana to spell a Yomikata corresponding to the desired word (hereinafter the "word interpretation"). For example, as shown in FIGURE 2b, a keystroke sequence 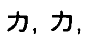 , and 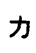 has been entered by a user. As keys are entered, a vocabulary module look-up is simultaneously performed to locate Yomikata that match the keystroke sequence. The Yomikata are returned from the vocabulary module according to frequency of use, with the most commonly used Yomikata listed first. Using the example keystroke sequence, the Yomikata " 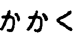 ", " 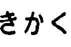 " and 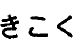 are identified from the vocabulary module as being the three most probable Yomikata corresponding to the keystroke sequence. Of the eight identified Yomikata in this selection list, " 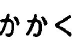 " is the most frequently used, so it is taken as the default interpretation and provisionally posted as hiragana text at the insertion point 88. As shown in FIGURE 1a, prior to pressing the Select key 60, this first Yomikata is taken as the default interpretation and is posted at the insertion point 88 using a distinctive format. This format indicates that a subsequent keystroke on one of the data keys will be appended to the current key sequence rather than start a new sequence. For example, as in FIGURE 1 a, the distinctive formatting consists of displaying the Yomikata as hiragana text with a dotted underline. The list of other potential matching Yomikata is kept in memory, sorted according to their relative frequency.

In the preferred embodiment, following entry of the keystroke sequence corresponding to the desired Yomikata, the user simply presses the Select key 60. The dotted underline beneath the default Yomikata " 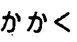 " displayed at the insertion point 88 is replaced with a solid underline. If the default Yomikata displayed is not the desired Yomikata, the Select key 60 is pressed repeatedly until the desired Yomikata appears. In one preferred embodiment, after all of the Yomikata in memory that match the key sequence have been displayed through repeated activation of the Select key 60, the key sequence is interpreted as a number, where each keystroke generates the digit appearing on the label of the key. This allows numbers to be generated without a separate numeric mode, and also serves as an easily recognizable indicator of the end of the selection list of Yomikata interpretations. The next press of the Select key 60 cycles back to the first Yomikata in the selection list.

Once the desired Yomikata is displayed, if the desired Midashigo (textual interpretation) is in fact identical to the Yomikata that is already displayed in hiragana text, the user proceeds to press the data key corresponding to the first kana of the next Yomikata to be entered. On the other hand, if the desired Midashigo consists of kanji, kanji plus hiragana, katakana, or some combination thereof, the user presses the Convert key 62. This causes the displayed Yomikata to be replaced with the most frequently occurring Midashigo that is associated with that Yomikata in the vocabulary module. Repeated presses of the Convert key 62 replace the displayed Midashigo with other associated Midashigo in descending order of frequency. In one preferred embodiment, after all of the Midashigo in memory that are associated with the selected Yomikata have been displayed through repeated activation of the Convert key 62, the selected Yomikata is displayed as katakana. This allows katakana words to be generated without a separate mode, and also serves as an easily recognizable indicator of the end of the selection list of Midashigo interpretations. In another preferred embodiment, if the user wishes to choose a Midashigo that is associated with the first (default) Yomikata associated with the input key sequence, the Convert key 62 can be pressed immediately to obtain the desired Midashigo without first pressing the Select key 60.

After one or more presses of either or both the Select key 60 and the Convert key 62, any data key that is pressed removes the special formatting (solid underline in the preferred embodiment) of the displayed Yomikata or Midashigo, and becomes the first keystroke of a new key sequence to be interpreted by the system. No special keystroke is required to confirm the interpretation of the preceding keystroke sequence.

In the preferred embodiment described above, pressing the Select key 60 cycles forward through the Yomikata in memory that are associated with the current key sequence (in descending order of frequency). In another preferred embodiment, pressing-and-holding the Select key 60 past a predetermined time threshold cycles backward through the Yomikata in memory in ascending order of frequency. Thus, when the numeric interpretation is included at the end of the sequence of associated Yomikata in memory as described above, a press-and-hold of the Select key 60 prior to any regular press of the Select key 60 cycles backward immediately to the numeric interpretation. Repeatedly pressing-and-holding the Select key 60 then cycles back up through the associated Yomikata in ascending order of frequency. Likewise, pressing-and-holding the Convert key 62 cycles backward through the Midashigo associated with the currently selected Yomikata in ascending order of frequency. Similarly, a first press-and-hold of the Convert key 62 prior to any regular press of the Convert key 62 cycles backward immediately to the katakana interpretation.

Still referring to FIGURE 1a, in another preferred embodiment, when entering data keys, the Clear key 64 can be pressed to delete the previously entered data key. If all data keys in the current key sequence are thus deleted, pressing the Clear key 64 deletes the character on the text display 53 to the left of the insertion point 88, where a standard text cursor is displayed when the current selection list is empty. After one or more presses of either or both the Select key 60 and the Convert key 62, pressing the Clear key 64 replaces the currently selected textual interpretation at the insertion point 88 with the default Yomikata interpretation of the current key sequence, but does not delete any of the data keys from the key sequence. In other words, the first press of the Clear key 64 after any number of presses of the Select key 60 and/or the Convert key 62 effectively "deletes" all of the activations of the Select key 60 and the Convert key 62, returning the system to the state immediately prior to the first press of either the Select key 60 or the Convert key 62. In another preferred embodiment, after one or more presses of the Convert key 62, pressing the Select key 60 replaces the currently selected Midashigo at the insertion point 88 with the Yomikata with which the Midashigo is associated. Further presses of the Select key 60 continue to cycle forward from that point through the other Yomikata in memory that are associated with the current key sequence (in descending order of frequency).

In another preferred embodiment, activation of any other means which explicitly generates an unambiguous character (such as entering a special Symbols mode and pressing a key that is unambiguously associated with a single specific character) serves to terminate the current key sequence. As a result, any special formatting (dotted or solid underline in the preferred embodiment) of the displayed Yomikata or Midashigo at the insertion point 88 is removed, and the specific unambiguous character is appended to the output word at a new insertion point 88.

Provisionally posting the selected Yomikata or Midashigo to the text region at the insertion point 88 allows the user to maintain their attention on the text region without having to refer to the selection list. At the user's option, the system can also be configured such that, upon receipt of the first press of the Select key 60 (or Convert key 62), the Yomikata (or Midashigo) provisionally posted at the insertion point 88 can expand (vertically or horizontally) to display a copy of the current selection list. The user may select the maximum number of words to be displayed in this copy of the selection list. Alternatively, the user may elect to have the selection list always displayed at the insertion point 88, even prior to the first activation of the Select key. The disambiguating system interprets the start of the next word (signaled by the activation of an ambiguous data key or the generation of an explicit unambiguous character) as an affirmation that the currently selected entry is the desired entry. The selected word therefore remains at the insertion point 88 as the choice of the user, the underline disappears completely and the word is redisplayed in normal text without special formatting.

In the majority of text entry, keystroke sequences are intended by the user as kana forming a Yomikata. It will be appreciated, however, that the multiple characters and symbols associated with each key allow the individual keystrokes and keystroke sequences to have several interpretations. In the preferred reduced keyboard disambiguating system, various different interpretations are automatically determined and displayed to the user at the same time as the keystroke sequence is interpreted and displayed to the user as a list of words.

For example, the keystroke sequence is interpreted in terms of the word stems corresponding to possible valid sequences of kana that a user may be entering (hereinafter the "stem interpretation"). Unlike word interpretations, word stems are incomplete words. By indicating the possible interpretations of the last keystrokes, the word stems allow the user to easily confirm that the correct keystrokes have been entered, or to resume typing when his or her attention has been diverted in the middle of the word. There are key sequences which correspond to the partial entry of a long word or phrase, but which do not correspond to any completed word or phrase. In such cases, the most useful feedback that can be provided to the user is to show the kana that correspond to the stem of the word that has been entered up to that point. In the example shown in FIGURE 2b, the keystroke sequence 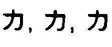 can be interpreted as forming the valid stem " 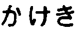 " (leading to the word " 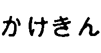 ". The stem interpretations are therefore provided as entries in the selection list. Preferably, the stem interpretations are sorted according to the composite frequency of the set of all possible words that can be generated from each stem by additional keystrokes on the data keys. The maximum number and the minimum composite frequency of such entries to be displayed may be selected by the user or configured in the system, so that some stem interpretations may not be displayed. When listing a stem interpretation in the selection list, the stem is omitted if a stem interpretation duplicates a word that appears in the selection list. When the stem is omitted, however, the word corresponding to the omitted stem may be marked with a symbol to show that there are also longer words which have this word as their stem. Stem interpretations provide feedback to the user by confirming that the correct keystrokes have been entered to lead to the entry of a desired word.

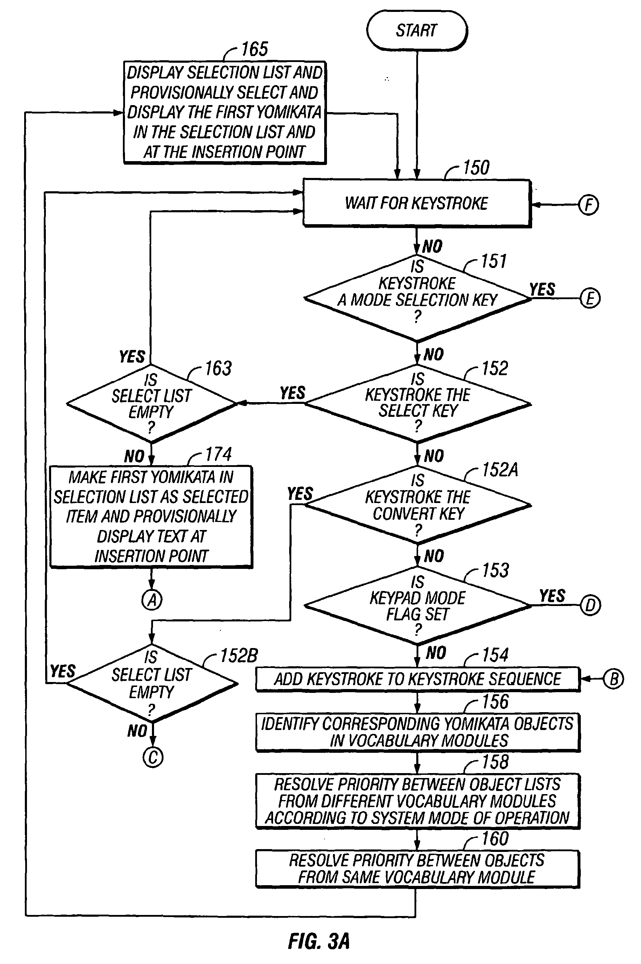

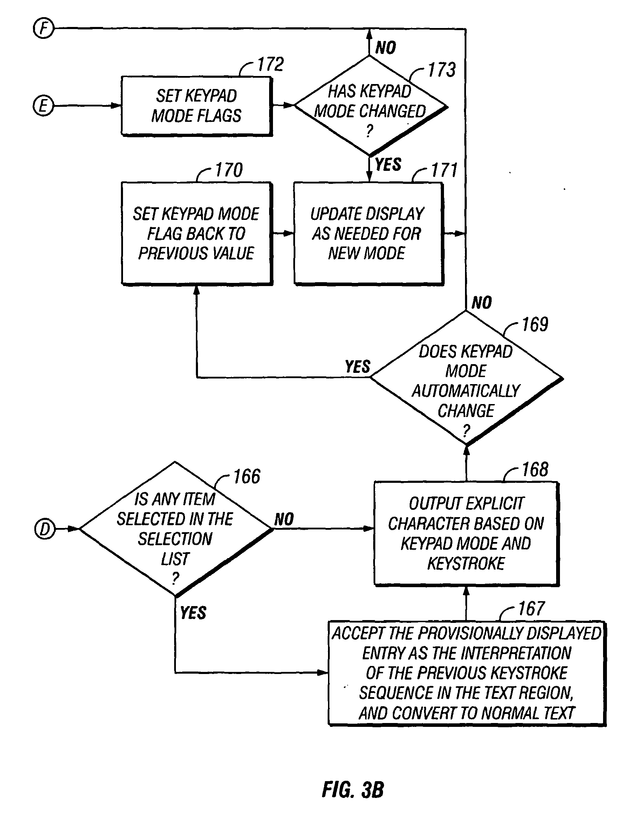

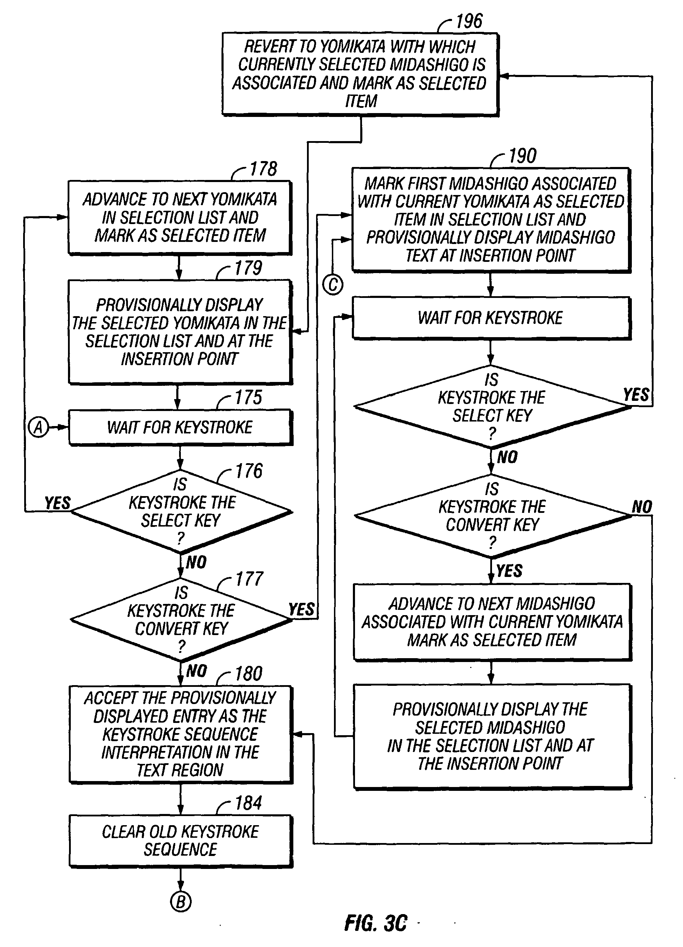

FIGURE 3 is a flow chart of a main routine of the disambiguation software that processes a selection list and determines what is to be displayed at the insertion point 88 to aid the user in disambiguating ambiguous keystroke sequences. At a block 150, the system waits to receive a keystroke from the keyboard 54. Upon receipt of a keystroke, at a decision block 151, a test is made to determine if the received keystroke is a mode selection key. If so, at a block 172 the system sets a flag to indicate the current system mode. At a decision block 173, a test is made to determine if the system mode has changed. If so, at a block 171 the display is updated as needed to reflect the current system mode. If block 151 determines the keystroke is not a mode selection key, then at a decision block 152, a test is made to determine if the received keystroke is the Select key. If the keystroke is not the Select key, then at decision block 152A, a test is made to determine if the received keystroke is the Convert key. If the keystroke is not the Convert key, then at decision block 153, a test is made to determine if the system is in a special explicit character mode such as the explicit Symbols mode. If so, at decision block 166 a test is performed to determine if any provisionally selected item is present in the selection list. If so, at a block 167 the item is accepted and is output as normal text. Then, at a block 168, the explicit character corresponding to the keystroke is output to the text area. Then, at decision block 169, a test is made to determine if the system mode should be automatically changed, as in the case of Symbols mode. If so, execution proceeds to block 170 and the system mode is returned to the previously active mode, otherwise execution returns to block 150.

If at block 153 no explicit character mode is active, at a block 154 the keystroke is added to a stored keystroke sequence. At block 156, objects corresponding to the keystroke sequence are identified from the vocabulary modules in the system. Vocabulary modules are libraries of objects that are associated with keystroke sequences. An object is any piece of stored data that is to be retrieved based on the received keystroke sequence. For example, objects within the vocabulary modules may include numbers, characters, words, components of words, stems, phrases, or system functions and macros. Each of these objects is briefly described in the following table:

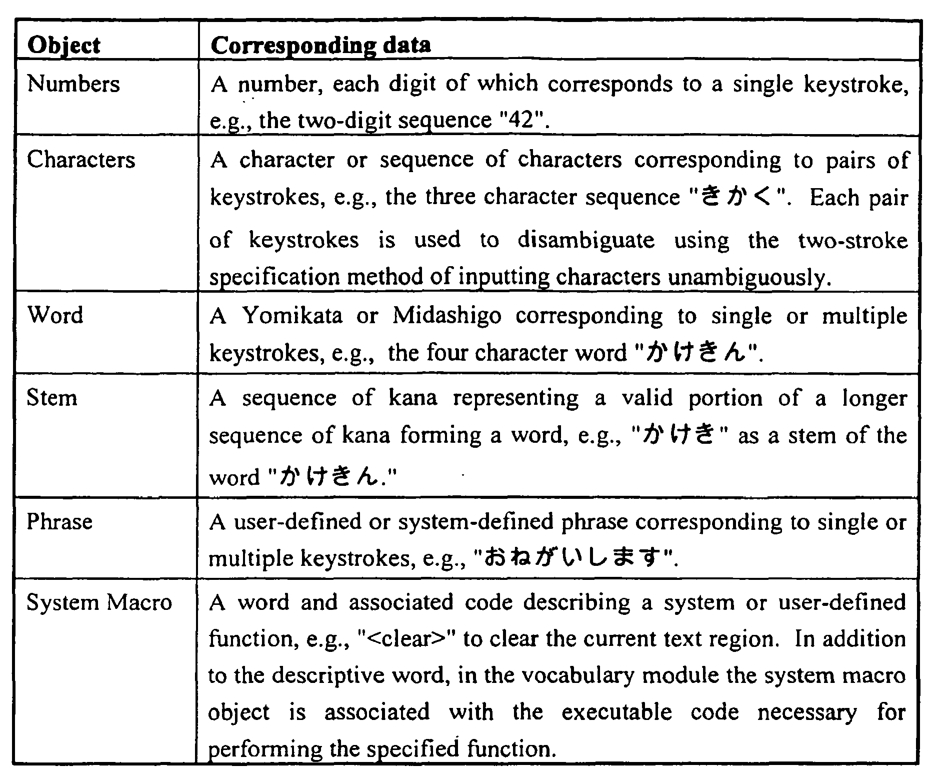

While the preferred vocabulary objects are discussed above, it will be appreciated that other objects may be contemplated. For example, a graphic object may be associated with a stored graphic image, or a speech object may be associated with a stored segment of speech. A spelling object may also be envisioned that would link the keystroke sequence of commonly misspelled words and typing errors with the correct spelling of the word. To simplify processing, each vocabulary module preferably contains similar objects. It will be appreciated, however, that various objects may be mixed within a vocabulary module.

Returning to FIGURE 3, at block 156 those objects that correspond to the received keystroke sequence are identified in each vocabulary module. At blocks 158-165 the objects found by looking up the keystroke sequence in the vocabulary modules are prioritized to determine the order in which objects are displayed to the user. To determine the sequence of objects displayed in the selection list, priorities are established between each vocabulary module and also between the returned objects from each vocabulary module.

To prioritize the object lists identified from the various vocabulary modules, at block 158 the mode of operation of the reduced keyboard disambiguating system is examined. As discussed above, in a normal mode of operation the word interpretations (Yomikata and Midashigo) are displayed first in the selection list. The object list from a word vocabulary module would therefore be assigned a higher priority than the object list from the other vocabulary modules. Conversely, if the disambiguating system were in the numeric mode of operation, the numeric interpretations would be assigned a higher priority than the other vocabulary modules. The mode of the disambiguating system therefore dictates the priority between vocabulary module object lists. It will be appreciated that in certain modes, the object lists from certain vocabulary modules may be omitted from the selection list entirely.

Object lists generated from vocabulary modules may contain only a single entry, or they may contain multiple entries. At block 160, the priority between the objects from the same vocabulary module is therefore resolved if the object list contains multiple entries. The objects that match a particular keystroke sequence that are looked-up in a given vocabulary module are also given a priority that determines their relative presentation with respect to each other. As noted above, preferably the default presentation order is by decreasing frequency of use in a representative corpus of usage. The priority data associated with each object is therefore used to order the objects in the selection list.

Many of the properties associated with the presentation of the objects looked-up in a vocabulary module are user-programmable by accessing appropriate system menus. For example, the user can specify the order of individual objects or classes of objects in the selection list. The user may also set the priority level that determines the priority between vocabulary modules and between the objects identified from each vocabulary module.

After the priorities between the objects have been resolved, at a block 165 a selection list is constructed from the identified objects and presented to the user. As a default interpretation of the ambiguous keystroke sequence entered by the user, the first entry in the selection list is provisionally posted and highlighted at the insertion point 88 in the text region 53 as illustrated in FIGURES 1a and 1c. The disambiguating software routine then returns to block 150 to wait for the next keystroke.

If the detected keystroke is the Select key 60, the "yes" branch is taken from decision block 152 to decision block 163, where a test determines if the current selection list is empty. If so, then execution returns to block 150. If at decision block 163 the selection list is not empty, the "no" branch is taken to a block 174. At block 174, the dotted-underline under the default Yomikata displayed at the insertion point 88 where it has been provisionally posted is changed to a solid-underline. At a block 175, the system then waits to detect the next keystroke entered by the user. Upon receipt of a keystroke, at a decision block 176, a test is made to determine if the next keystroke is the Select key. If the next keystroke is the Select key, at a block 178 the system advances to the next Yomikata in the selection list and marks it as the currently selected item. At block 179, the currently selected entry is provisionally displayed at the insertion point with a solid-underline. The routine then returns to block 175 to detect the next keystroke entered by the user. It will be appreciated that the loop formed by blocks 175-179 allows the user to select various Yomikata interpretations of the entered ambiguous keystroke sequence having a lesser frequency of use by depressing the Select key multiple times.

If the next keystroke is not the Select key, at a decision block 177, a test is made to determine if the next keystroke is the Convert key. If the detected keystroke is the Convert key, the "yes" branch is taken from decision block 177 to block 190 where the first Midashigo associated with the current Yomikata is marked as the selected item and the Midashigo text is provisionally displayed at insertion point 88 with a solid-underline. At a block 191, the system then waits to detect the next keystroke entered by the user. Upon receipt of a keystroke, at a decision block 192, a test is made to determine if the next keystroke is the Select key. If the next keystroke is the Select key, at a block 196 the system changes the currently selected item back to the Yomikata with which the currently selected Midashigo is associated, and marks it as the currently selected item, and then proceeds at block 179 as before. If at decision block 192 the next keystroke is not the Select key, at a decision block 193, a test is made to determine if the next keystroke is the Convert key. If it is the Convert key, then at a block 194 the currently selected object is advanced to the next Midashigo associated with current Yomikata, and marked as the selected item. At block 195, the now selected Midashigo is provisionally displayed at the insertion point 88 with a solid-underline. The system then returns to block 191 to wait to detect the next keystroke entered by the user.

If at decision blocks 177 or 193 the next keystroke is not the Convert key, the routine continues to a block 180 where the provisionally displayed entry is selected as the keystroke sequence interpretation and is converted to normal text formatting in the text region. At a block 184, the old keystroke sequence is cleared from the system memory, since the receipt of an ambiguous keystroke following the Select key or the Convert key indicates to the system the start of a new ambiguous sequence. The newly received keystroke is then used to start the new keystroke sequence at block 154. Because the Yomikata interpretation having the highest frequency of use is presented as the default choice, the main routine of the disambiguation software allows a user to continuously enter text with a minimum number of instances which require additional activations of the Select key.

FIGURE 1b is a schematic view of a cellular telephone keypad, similar to FIGURE 1a. A reduced keyboard 54' includes a plurality of data entry keys 21'-30'. One or more of the data entry keys are associated with a plurality of romaji characters (Latin letters used to phonetically spell the pronunciations of Japanese kana characters), and are labeled with each of the romaji characters associated with the key. An input sequence is generated each time an input is selected by user manipulation of the input device. The generated input sequence has a textual interpretation that is ambiguous due to the plurality of romaji characters associated with one or more of the data entry keys. This embodiment of the system is conceptually very similar to that shown in FIGURE 1 a, but does not require a diacritic key 68 since the kana with diacritic marks are specified in romaji through the use of different Latin letters. For example the kana 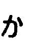 is specified in romaji as "KA," while the same kana with the diacritic dakuten attached ( 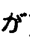 ) is specified in romaji as "GA."

In a normal mode of operation, the keystrokes are initially interpreted as the entry of a sequence of romaji corresponding to the kana to spell a Yomikata which corresponds to the desired word interpretation. For example, as shown in FIGURE 1b, a keystroke sequence 5 KLM, 4 HIJ, 5 KLM, 1 ABC, 5 KLM and 9 TUV has been entered by a user. As keys are entered, a vocabulary module look-up is simultaneously performed to locate Yomikata that match the keystroke sequence. The Yomikata are returned from the vocabulary module according to frequency of use, with the most commonly used Yomikata listed first. Using the example keystroke sequence, the Yomikata KIKAKU (" 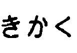 ") and MIKAKU (" 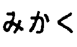 ") are identified from the vocabulary module as being the two most probable Yomikata corresponding to the keystroke sequence. Of the two identified Yomikata in this selection list, KIKAKU " 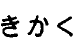 " is the most frequently used, so it is taken as the default interpretation and provisionally posted as hiragana text at the insertion point 88'. As shown in FIGURE 1b, prior to pressing the Select key 60', this first Yomikata is taken as the default interpretation and is posted at the insertion point 88' using a distinctive format. Specifying a Yomikata in romaji requires on average approximately twice as many characters (and consequently twice as many key selections) as the corresponding specification in kana. Consequently, the system shown in FIGURE 1b will generally result in fewer ambiguous choices than that shown in FIGURE 1a, since statistically more information is specified when twice as many keystrokes are entered that are distributed among the same number of inputs keys (ten).

### II. Unambiguous Text Entry Method

The present invention also provides a method for a reduced keyboard for the Japanese language which allows the user to unambiguously specify each desired kana as an ordered pair of keystrokes. The Japanese syllabary includes 108 syllables (counting the "small" 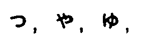 , and 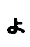 as separate syllables from the full-sized 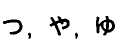 , and 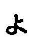 , since they are written and pronounced in a distinct fashion). There are some additional seldom used syllables, such as the "small" versions of the vowel syllables 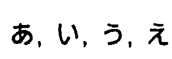 , and 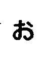 that are primarily used only in katakana. These seldom used syllables may also be easily generated by the system when used in conjunction with a display as discussed below. Of the 108 standard syllables, 37 are generated by simply adding one of the diacritic marks " or ° to one of the other 71 syllables. These 71 syllables without diacritic marks can be logically organized into a single matrix of nine or ten rows and eight to ten columns, as explained in detail below. A plurality of the keys on the keyboard of the present invention are labeled with two kana, one representing the consonant associated with a given row of the matrix, and second kana representing the vowel associated with a given column of the matrix.

The organization is logical and intuitive for a native speaker of Japanese for 106 of the 108 syllables, and the method for generating the remaining two syllables (small 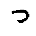 , and 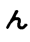 ) is simple and easily learned. Every syllable is generated by a single pair of keystrokes, including syllables with palatalized vowels that are represented by two separate kana (for example, KYA, KYU, and KYO). This results in significantly fewer keystrokes than is required by the currently used multiple-stroke method for entering kana on a reduced keyboard. Thus, the present invention provides a reduced keyboard that is easily understood and quickly learned by native speakers of Japanese, and that is efficient in terms of reducing the length of input keystroke sequences.

In the preferred embodiment, 71 syllables of the Japanese syllabary are organized in the matrix shown in Table 4a. In the general case which includes all 69 syllables appearing in the first eight columns of Table 4a, the first keystroke of the corresponding ordered pair determines the consonant of the syllable to be output, and the second keystroke determines the vowel. The two remaining syllables ("small" 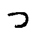 and h) are exceptional cases discussed below. The remaining 37 syllables not shown in Table 4a are output by generating the corresponding base syllable appearing in the matrix of Table 4a, then adding a diacritic mark using a separate key. FIGURE 1c shows a schematic view of a cellular telephone with limited or no display capabilities which has a keypad incorporating an embodiment of the reduced keyboard system of the present invention for the Japanese language. Each of the ten keys 121 through 130 is labeled with one of the kana labels from the row headers in the column labeled "Key 1" in Table 4a (hereinafter a "row label kana") in the upper left region of the key, and with one of the kana labels from the column headers in the row labeled "Key 2" in Table 4a (hereinafter a "column label kana") in the lower right region of the key. In the preferred embodiment, a syllable appearing in Table 4a is generated when the two key sequence is entered wherein the first key is the key labeled at the upper left with the row label kana corresponding to the row in which the syllable appears, and the second key is the key labeled at the lower right with the column label kana corresponding to the column in which the syllable appears. The ten row label kana appear in their standard lexicographic sequence at the upper left of the ten keys 121 - 130 of the keyboard shown in FIGURE 1c. The first five column label kana appear in their standard lexicographic sequence at the lower right of the first five keys 121 - 125 of the keyboard, followed by the "small" 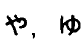 , and 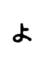 (also in standard lexicographic sequence) on the next three keys 126 - 128. Finally, the "small" 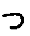 appears on the next key 129 followed by 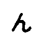 on key 130. A diacritic mark may be added to any syllable by activating the Diacritic key 131 once to generate the diacritic " and twice in succession to generate the diacritic °. When a diacritic is added to a syllable with a palatalized vowel (represented by two output kana consisting of a syllable from the " 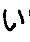 " column of Table 4 followed by a "small" 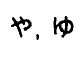 , or 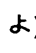 ), the diacritic is added to the output at its correct location immediately following the first of the two kana.

Thus, for the 69 syllables appearing in the first eight columns of Table 4a, the first keystroke of the corresponding ordered pair determines the consonant of the syllable to be output, and the second keystroke determines the vowel. In another preferred embodiment, a display is used to provide feedback to the user. Upon receipt of the first keystroke of an ordered pair, the system displays the various syllables that can be generated by each key that is valid as the second keystroke of an ordered pair. The association between which key generates which syllable can be indicated by labeling each syllable with the number (or other identifier) associated with the key that generates the syllable. Alternatively, the syllables can be displayed (with or without a numeric label) in a geometric arrangement that corresponds with the arrangement of the corresponding keys. For example, in the case of a device such as a cellular telephone with a text display, the syllables can be displayed in a three-by-three matrix corresponding to the arrangement of the 1 through 9 keys of the telephone keypad. When a display is used in this fashion, even rarely used syllables such as the "small" versions of the vowel syllables 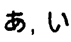 , 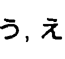 , and 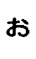 can be easily generated. For example, using the matrix shown in Table 4b, upon pressing the first key of an ordered pair wherein the first key corresponds to the vowel-only syllables in the top row of Table 4b, the display shows the normal-sized versions of the vowel syllables 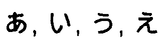 , and 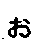 associated with a second keystroke on keys 1 through 5, and the "small" versions of the vowel syllables 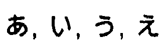 , and 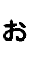 associated with keys 6 through 0.

FIGURE 1d shows a schematic view of a cellular telephone that includes text display capabilities, with a keypad incorporating an embodiment of the reduced keyboard system of the present invention for the Japanese language. Each of the ten keys 121 through 130 is labeled only with one of the row label kana from Table 4b in a central region of the key. The ten row label kana appear in their standard lexicographic sequence on the ten keys 121 - 130 of the keyboard shown in FIGURE 1d. FIGURE 1d shows the appearance of the display following the activation of key 122 (ambiguously associated with 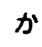 , 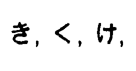 , and 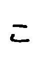 ) as the first key of an ordered pair of keystrokes. In the preferred embodiment, the syllables appearing in the corresponding row of Table 4b are displayed when the key labeled with the row label kana is activated. The display shows the association between the kana that will be generated and each key that may be pressed as a second key of an ordered pair of keystrokes to generate the kana. The columns in Table 4b are labeled with the numbers which also appear on each key of the cellular telephone shown in FIGURE 1d. Note that in this preferred embodiment, the three syllables with palatalized vowels ( 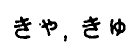 , and 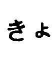 ) are associated with keys 127-129 (labeled with the digits 7, 8 and 9) and thus these can be displayed in a single row of the display. This makes it easier for the user to associate these related syllables to the keys that will generate them, since the association can be made not only in terms of the number labels on keys and displayed syllables, but also in terms of the same three-by-three matrix arrangement of syllables on the display and keys in the keypad. As before, a diacritic mark is added to any syllable by activating the Diacritic key 131 once to generate the diacritic " and twice in succession to generate the diacritic °. When a diacritic is added to a syllable with a palatalized vowel (associated with a second keystroke on keys 127-129 in the example shown in FIGURE 1d), the diacritic is added to the output at its correct location immediately following the first of the two kana.

FIGURES 2b and 2c show the preferred embodiment of the present system as it might appear when implemented as a keyboard displayed on a portable computer touchscreen. FIGURE 2b shows the keyboard 150 as it is displayed prior to the first keystroke of an ordered pair of keystrokes. FIGURE 2c shows the keyboard 170 as it is displayed following an activation of the key 152 of FIGURE 2b associated with the syllables 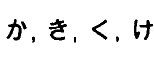 , and 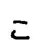 as the first of an ordered pair of keystrokes. In FIGURE 2c the keys 171-179 are labeled with the kana that will be generated for output when the keys are activated, respectively. This arrangement of keys and syllables relies on the same three-by-three matrix arrangement as is shown on the display in FIGURE 1d, associating syllables with keys of the keypad using the same conceptual organization of syllables shown in Table 4b.

In another preferred embodiment, the entry of a two key sequence corresponding to an empty cell in Table 4a or 4b produces no output, and at the user's option, generates an audible error signal. In an alternate embodiment, the cell corresponding to a double hit on key 129 in FIGURE 1c (labeled with the column label kana "small" 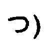 ) also generates a "small" 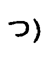 . In another alternate embodiment, all of the cells in the column labeled with the column label kana "small" 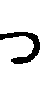 also generate a "small" 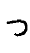 . Likewise, in another alternate embodiment, all of the cells in the column labeled with the column label kana 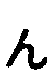 generate an 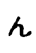 . It will be evident to one of ordinary skill in the art that various modifications can be made to the matrix of Tables 4a and 4b without departing from the scope of the invention. For example, the "small" 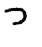 and 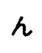 are exceptional cases that may be specified in a wide variety of ways such as by assigning them to a separate key which is activated once to generate a "small" 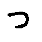 and twice in succession to generate an 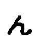 . The more important aspect of the present invention is the manner of specification of the syllables in the first eight columns of Table 4a (or columns 1-5 and 7-9 of Table 4b).

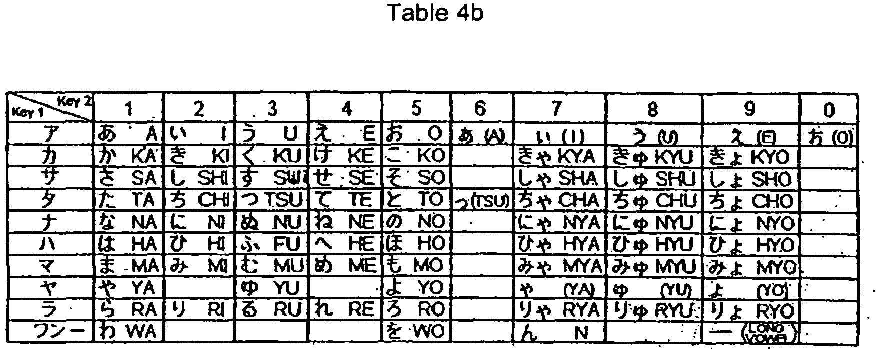

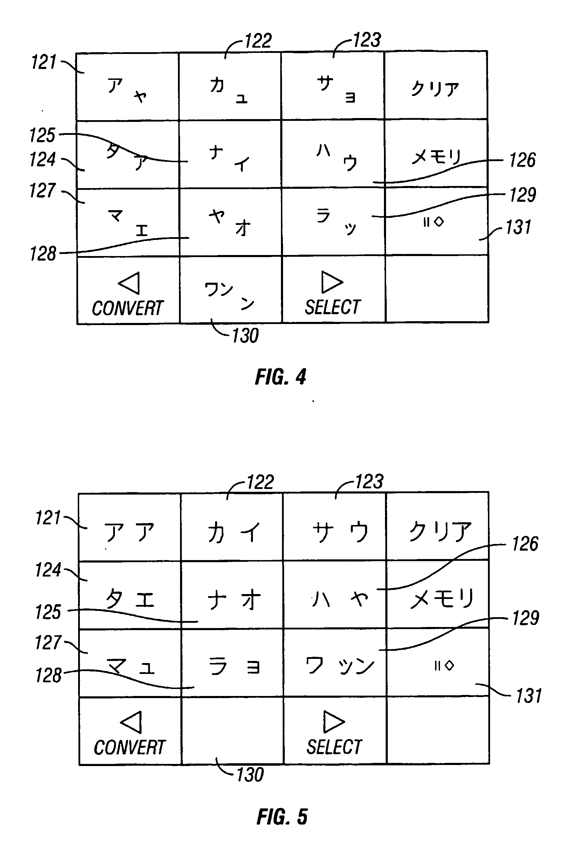

It will be evident to one of ordinary skill in the art that, although the assignment of row label kana and column label kana to the keys in the preferred embodiment shown in FIGURE 1c is the most natural, alternate embodiments are also possible in which row label kana and column label kana are assigned to keys in other combinations without departing from the scope of the invention. FIGURES 4 and 5 show some of the many possible alternate embodiments in which row label kana and column label kana are assigned to keys in an alternate arrangement.

In an alternate embodiment, the system of the present invention can also be implemented on a keyboard with only nine keys as shown in FIGURE 5. Sixty-eight (68) of the 71 distinct syllables of Table 4a can also be organized as shown in Table 5, in which the row corresponding to the row label 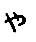 has been eliminated. In such a nine key system, the three syllables 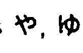 , and 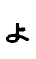 are generated from ordered pair key sequences in which the first key is the row label 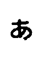 corresponding to cells in the first row of the table. The syllables "small" 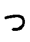 and 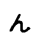 are generated by key sequences corresponding to cells in the last column, which includes the last two columns of Table 4a merged together.

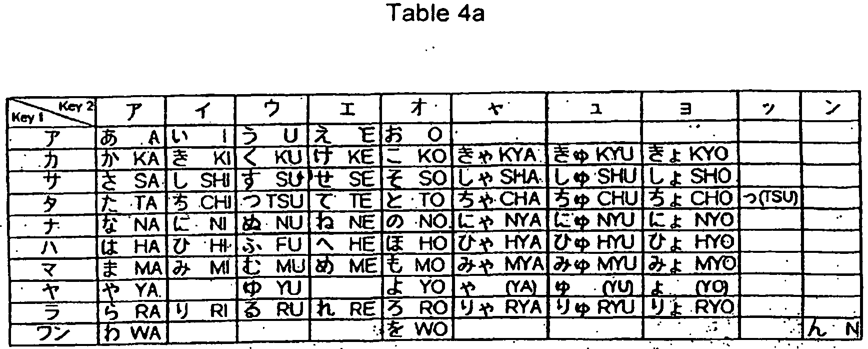

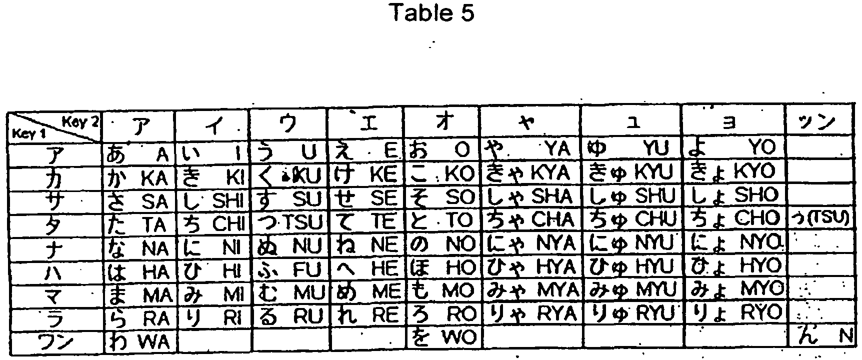

In another aspect of the present invention, the system provides an indication to the user as to whether the next keystroke will be processed as the first keystroke of an ordered pair (determining the consonant of the syllable to be output), or as the second keystroke of an ordered pair (determining the vowel of the syllable to be output). For example, this indication can be implemented as a pair of labeled LEDs that are alternately lit. Alternatively, two distinct icons can be shown alternately on a display. It will be evident to one of ordinary skill in the art that many other alternate embodiments of such an indication are also possible without departing from the scope of the invention.

The combined effects of the assignment of appropriate labels to keys as shown in FIGURES 1c and 2b; the generation of syllables from ordered pairs of keystrokes; the provision of appropriate feedback following a first keystroke of an ordered pair as shown in FIGURES 1d and 2c; the natural correspondence between the organization of key labels and the standard ordering and arrangement of the Japanese syllabary; and the inclusion of an indication to the user as to whether the next keystroke corresponds to row label kana specifying the consonant of a syllable or a column label kana specifying the vowel results in a system which is both efficient for unambiguously inputting text and which is easily understood and quickly learned by native speakers of Japanese. High speed unambiguous entry of text is therefore achieved using a keyboard having a small number of full-size keys that is easy to learn and use.

### III. Text Entry Method Combining Ambiguous and Unambiguous Keystrokes

In yet another aspect of the invention, both ambiguous and unambiguous specification of syllables are combined to achieve greater efficiencies in the input method. In one preferred embodiment, at the user's option the first syllable of a word to be entered is unambiguously specified using the two-keystroke method disclosed above. Note that in the case of syllables with palatalized vowels, these first two keystrokes result in the specification of two hiragana characters (including the 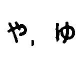 , or 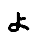 that indicates the palatalized vowel). The remaining syllables of a word or phrase are specified ambiguously with a single keystroke for each syllable. In the case of words as short as one or two syllables, this combined method can significantly reduce the ambiguity of the input sequence, and consequently reduce the number of candidate readings that the user may need to examine in order to find the desired reading. In another alternate embodiment, the multiple-stroke specification method as known in the art may be used to unambiguously specify only the first syllable of a word or phrase, and the remainder of the syllables are specified ambiguously.

In yet another alternate embodiment using the ambiguous specification method of the present invention, the two-stroke method may be used to specify any desired syllable in a word or phrase (rather than only the first). For example, pressing and holding a key past a certain time threshold can indicate that the immediately following keystroke is the second of two keystrokes to unambiguously specify the desired syllable. This approach has two benefits. One is that any syllable (rather than only the first syllable of a word or phrase) may be unambiguously specified. The second is that the user can choose to unambiguously specify a syllable only when it is thought that this will increase the efficiency of input. For some less common words and phrases (and especially for shorter words), the default presentation of the most commonly used words and phrases may require a number of activations of the Select key to select the desired Yomikata when all syllables are specified ambiguously. In such cases, unambiguously specifying at least one syllable can result in significantly fewer keystrokes being required to generate the desired Yomikata, since the user need only select among those Yomikata which share the same unambiguously specified syllable(s) at the same position(s).

### IV. Database Structure to Support Disambiguation of Ambiguous Keystrokes

The database of words and phrases that is used to disambiguate input sequences is stored in a vocabulary module using one or more tree data structures. Words corresponding to a particular keystroke sequence are constructed from data stored in a tree structure in the form of instructions which modify the set of words and word stems associated with the immediately preceding keystroke sequence. Thus, as each new keystroke in a sequence is processed, the set of instructions associated with that keystroke are used to create a new set of words and word stems associated with the keystroke sequence which has the new keystroke appended to it. In this way, words and word stems are not stored explicitly in the database, they are constructed based on the key sequence used to access them.

In the case of the Japanese language, the tree data structure includes two types of instructions. Primary instructions create the Yomikata of the words and phrases stored in a vocabulary module which consist of sequences of kana corresponding to the pronunciation of the words and phrases. Corresponding to each Yomikata is a list of secondary instructions which create the Midashigo associated with each Yomikata. Each Yomikata is created by a primary instruction which modifies one of the Yomikata associated with the immediately preceding keystroke sequence. Likewise, each Midashigo is created by a secondary instruction which modifies one of the Midashigo associated with the Yomikata which was modified by the primary instruction with which the secondary instruction is associated.

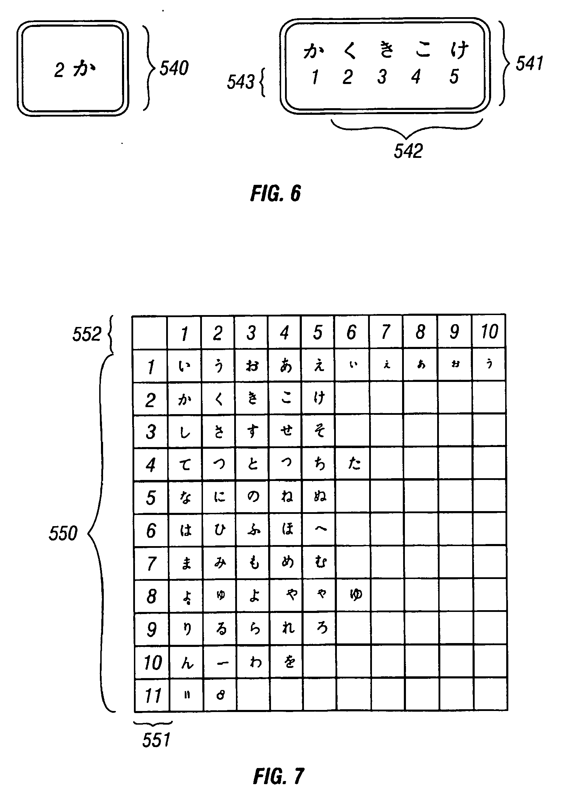

Since each primary instruction refers to a known key, the information as to which particular kana is to be appended is preferably stored as a logical index into the set of kana associated with the key. A representative diagram of a single key 540 is depicted in FIGURE 6. The internal, logical representation of the keys in the preferred embodiment need not mirror the physical arrangement. For example 541 is a preferred logical description of a key associated with the "2 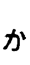 " key in a Japanese vocabulary module. Four additional symbols 542 ( 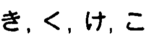 ) are also associated with the key. Also, the symbols are preferably indexed 543 by order of their decreasing frequency of use in a Japanese lexicon ( 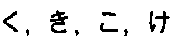 ). By extension, FIGURE 7 is a preferred table relating the indices of logical symbols to key indices to be used in disambiguation of key presses into Japanese words. FIGURE 7 shows a table corresponding to the preferred embodiment illustrated in FIGURE 1a, which has a separate Diacritic key 68 that is used to specify when the preceding character is to appear with dakuten or handakuten. Pressing the Diacritic key 68 is ambiguous with respect to whether dakuten or handakuten is to be appended to the preceding kana. In an alternate embodiment, the Diacritic key 68 is unambiguous and is pressed once for dakuten and twice in succession to specify handakuten. In another preferred embodiment, all forms of a given kana (with and without dakuten or handakuten), are associated with the same key, and would also appear in the same row of the Logical Symbol Index Table. This allows the system using the database to be set up so that the use of the Diacritic key 68 is optional. In such a system, if the option to require the use of the Diacritic key 68 is turned off, instructions which specify the addition of a kana with diacritics are skipped over until the Diacritic key 68 has been pressed once (for dakuten) or twice (for handakuten).

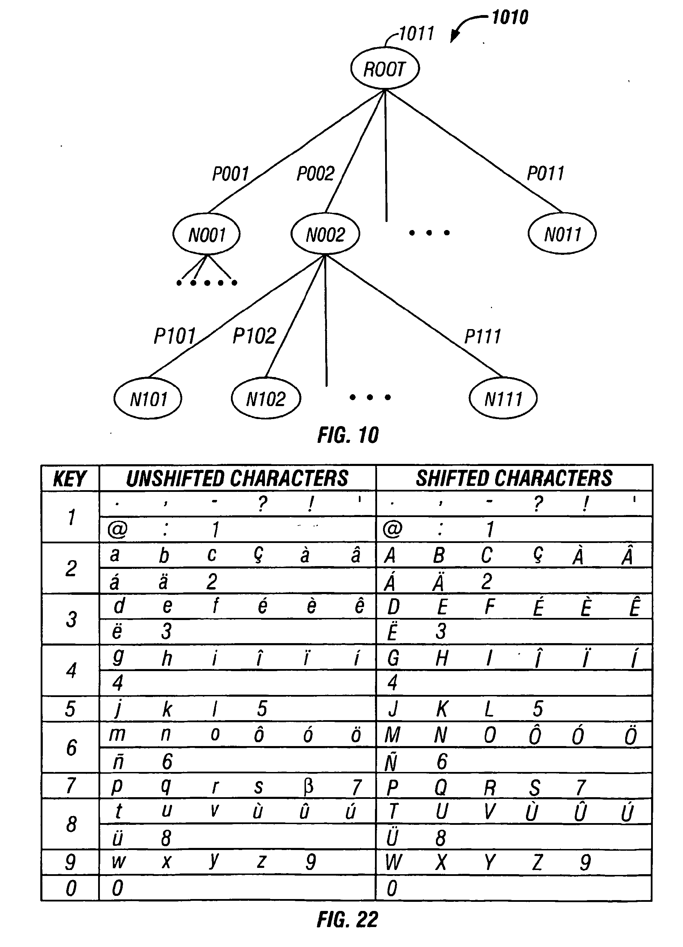

A representative diagram of a tree in a word object vocabulary module 1010 is depicted in FIGURE 10. A tree data structure is used to organize the objects in a vocabulary module based on a corresponding keystroke sequence. As shown in FIGURE 10, each node N001, N002, ... N011 in the vocabulary module tree represents a particular keystroke sequence. The nodes in the tree are connected by paths P001, P002, ... P011. Since there are eleven ambiguous data keys in the preferred embodiment of the disambiguating system, each parent node in the vocabulary module tree may be connected with eleven children nodes. Nodes connected by paths indicate valid keystroke sequences, while the lack of a path from a node indicates an invalid keystroke sequence, i.e., one which does not correspond to any stored word. Note that, in the case of an invalid input keystroke sequence, the system of the preferred embodiment would still be able to construct and display a numeric interpretation of the input key sequence. The appearance of a numeric interpretation at the insertion point (without any press of the Select key) indicates to the user that the vocabulary module contains no word corresponding to the input key sequence.

A vocabulary module tree is traversed based on a received keystroke sequence. For example, pressing the second data key from the root node 1011 causes data associated with the first key to be fetched from inside the root node 1011 and evaluated, then the path P002 to node N002 is traversed. Pressing the second data key a second time causes data associated with the second key to be fetched from node N002 and evaluated, then the path P102 to node N102 is traversed. As will be described in greater detail below, each node is associated with a number of objects corresponding to the keystroke sequence. As each keystroke is received and the corresponding node is processed, an object list is generated of the objects corresponding to the keystroke sequence. The object list from each vocabulary module is used by the main routine of the disambiguating system to generate a selection list.

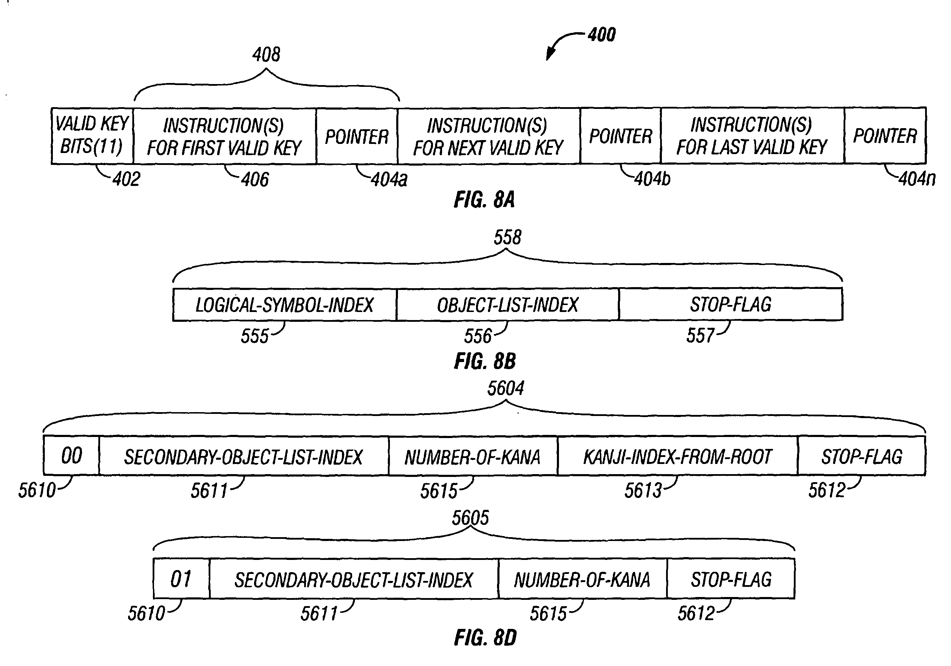

FIGURE 8A is a block diagram of a preferred data structure 400 associated with each node. The data structure contains information that links each parent node to children nodes in the vocabulary module tree. The data structure also contains information (instructions) to identify the objects associated with the particular keystroke sequences represented by the node.

The first field in the node data structure 400 is a valid keys bits field 402 that indicates the number and identity of children nodes that are connected to the parent node and which of the eleven possible keys are associated with information (instructions) to identify (construct) the objects associated with the particular keystroke sequences represented by the node. Since there are eleven data keys in the preferred embodiment, at most eleven children nodes may be connected to any parent node, and eleven valid keys bits are therefore provided in the valid keys bits field to indicate the presence or absence of child nodes. Each valid keys bit is associated with a pointer field 404a, 404b, ... 404n that contains a pointer to the respective child node data structure in the vocabulary module. Since a child node is only present if the keystroke associated with the child node is a valid continuation of the keystroke sequence associated with the parent node, the number of pointer fields varies for each node. For example, valid keys bits field 402 may indicate that only six of the possible eleven keystrokes lead to a valid child node. Because there are only six valid paths, only six pointer fields are included in the data structure for the parent node. The valid keys bits field 402 is used to ascertain the identity of the pointer fields contained within the node data structure. If a keystroke does not lead to a valid child node, the associated pointer field is omitted from the node data structure in order to conserve the amount of memory space required to store the vocabulary module.

Associated with each node are a number of objects that correspond to the keystroke sequence represented by the node. Each of the objects is described by an instruction in 406 in a packet 408 attached to a particular valid key as indicated by the pattern of bits in the valid keys bits field 402 contained in the node data structure.

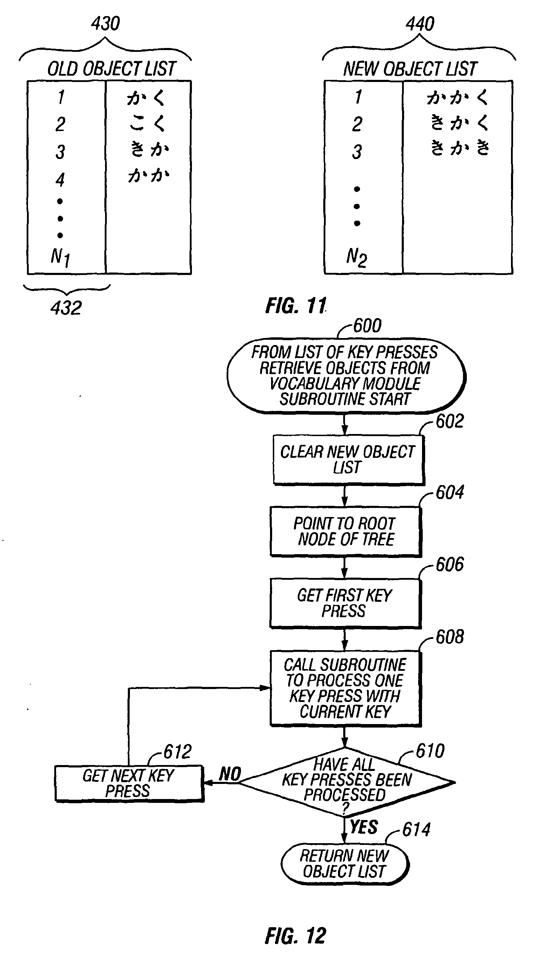

Each instruction in each packet 406 describes one of the objects corresponding to the keystroke sequence represented by each node. Describing an object requires maintaining two object lists. FIGURE 11 depicts representative object lists created dynamically by the disambiguating software process from a parent and a child in a vocabulary module tree. Object list 430 is an object list containing objects 1-N₁ associated with a node representing two keystrokes. Object list 440 is an object list containing objects 1-N₂ associated with a node representing three keystrokes. Each object list contains a list of all objects that are associated with each node. Object list 430 is associated with a parent node representing the keystroke sequence 2 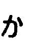 2 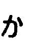 from the keyboard of FIGURE 1a. Object list 440 is associated with a child node representing the keystroke sequence 2 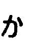 2 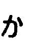 2 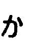 . It will be appreciated that the size of the object list is varied to account for the actual number of objects associated with each node.

Each Yomikata object associated with a child node is constructed by a primary instruction that adds a kana character onto an object that was constructed by the parent node. Each instruction in the packet of instructions 406 in FIGURE 8A therefore contains an OBJECT-LIST-INDEX field 556 shown in FIGURE 8B that identifies from a parent node object list an object that is used to construct the child node object. For example, with reference to FIGURE 11, the third object " 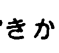 " in the old object list 430 is used to construct the second object " 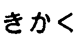 " in the new object list 440. The previous object identifier field OBJECT-LIST-INDEX 556 therefore provides a link to the entries in the old object list to identify the old object used to construct the new object.

The instruction 558 contains a LOGICAL-SYMBOL-INDEX field 555 to indicate the symbol to add to the identified object in order to construct the new object. The LOGICAL-SYMBOL-INDEX fields therefore specify the letters from final key in the node's key sequence which will be appended to construct the new objects. The letter is specified by a table such as that depicted in FIGURE 7. For example, with reference to FIGURE 11, the first object " 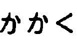 " in the new object list 440 is constructed by using the fourth object " 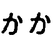 " in the old object list 430 and adding an additional keystroke to specify the <. In the logical symbol index table of FIGURE 7, "<" is the second logical letter on the 2 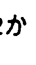 key, therefore the LOGICAL-SYMBOL-INDEX field of the instruction which generated the object " 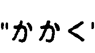 " is set to 2 to indicate the second letter in the table. Encoding the objects in this manner makes use of the known key sequence associated with each node and the known association of letters to keys to greatly reduce the amount of storage space required for each vocabulary module.

The vocabulary encoding technique also allows access to vocabulary module entries without searching. On receipt of each new valid keystroke the system executes the instructions associated with the key at the current node to construct a new object list from the old, then follows a single pointer to the appropriate child node. Also, rather than having to store every object in the vocabulary module, a new object is defined using the logical-symbol-index field to add onto an old interpretation. Thus a word stem that is shared by a plurality of objects in the vocabulary module is only stored once and is used to create all of the objects derived from it. The disclosed storage method requires maintaining an object list from a parent node in the vocabulary module tree in order to construct an object list of the child node.

The entries in the logical symbol index table such as that depicted in FIGURE 7 need not be single characters - arbitrary sequences may occupy a single entry. For example, the kana sequence " 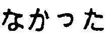 " might be added to the third object " 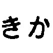 " from the old object list to form the word " 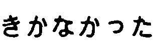 ". In this manner, the length of an entered keystroke sequence does not necessarily directly correspond to the length of an associated object. A sequence of characters stored at an entry in the symbol index table would allow a vocabulary object to be identified by an arbitrary key sequence, i.e., stored at an arbitrary location within the vocabulary module tree.

An object type field may also be included in each instruction 558 of FIGURE 8B to specify additional information about the object being constructed. The object type field may contain a code to specify whether the generated object is a word, a word stem, or any other object. The object type field therefore allows different types of objects to be mixed within a given vocabulary module. Moreover, the object type field may also include information regarding the part of speech of the word, or information needed to construct various inflections and endings. A reduced keyboard disambiguating system using a vocabulary module having the part of speech information may use the additional information to implement syntactical analysis to improve the disambiguation process. The object type field may also contain a unique code to allow transmission of text in a compressed form. The unique code would be transmitted to a remote terminal instead of transmitting the entered keystroke sequence or the associated disambiguated characters.

One of the key features of the preferred vocabulary module tree data structure is that the objects associated with each node are stored in the node data structure 400 according to their frequency of use. That is, the object constructed by the first instruction in the packet of instructions 406 has a higher frequency of use than that constructed by the second instruction (if present) in 406, which has a higher frequency of use than the third instruction (if present). In this manner, the objects are automatically placed in the object list so that they are sorted according to decreasing frequency of use. For purposes of this description, frequency of use of a word object refers to the likelihood of using a given word within a representative corpus of use, which is proportional to the number of times that each word occurs in the corpus. In the case of word stem objects, frequency of use is determined by summing the frequencies of all words which share the stem.

Storing frequency of use or other rank information at each node avoids the need to determine and sort on the rank of each object when the system is in use. This has important implications in the word object vocabulary, since the stored objects may include shared stems common to a very large number of longer words. Determining the relative rank of these stems dynamically would require traversing the entire tree of children nodes and accumulate information about each stem, adding significant processing overhead for a portable computing device. Determining this information in advance and storing it in the vocabulary data thus reduces the processing overhead. Moreover, when the frequency of use or rank of the objects that are created by a node is represented implicitly by the ordering of the instructions 406 that create them, no additional storage space is required for this information.

While preferably the objects are stored within the node data structure 400 in order according to their frequency of use, it will be appreciated that a frequency of use field could also be associated with each instruction. The frequency of use field would contain a representative number that corresponds with the frequency of use of the associated object. The frequency of use between different objects would be determined by comparing the frequency of use field of each object. One advantage of using the latter construction that associates a frequency of use field with each object packet is that the frequency of use field could be changed by the disambiguating system. For example, the system could change a frequency of use field to reflect the frequency with which a user used certain objects within the vocabulary module during representative text entry.

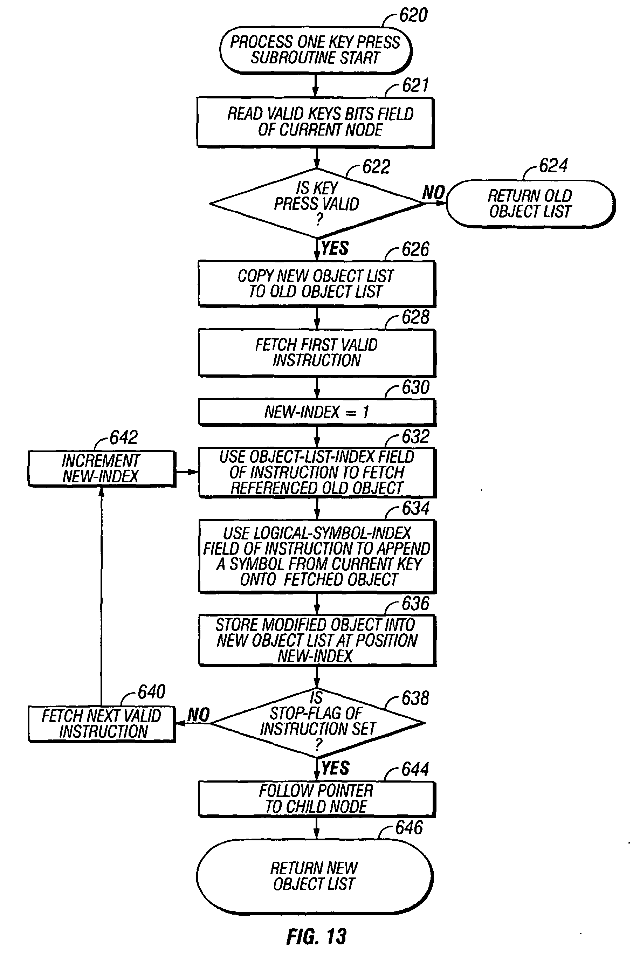

FIGURE 12 is a flow chart of a subroutine 600 for analyzing the received keystroke sequence to identify corresponding objects in a particular vocabulary module tree. The subroutine 600 constructs an object list for a particular keystroke sequence. Block 602 clears the new object list. Block 604 initiates the traversal of the tree 1010 of FIGURE 10 at its root node 1011. Block 606 gets the first key press. Blocks 608 to 612 form a loop to process all available key presses. Block 608 calls subroutine 620 in FIGURE 13. Decision block 610 determines whether all available key presses have been processed. If any key presses remain unprocessed, block 612 advances to the next available one. If all key presses have been processed, block 614 returns the completed object list. It will be appreciated that if the main routine calls subroutine 600 repeatedly with new keystroke sequences, each with one more key than the last, and all keys but the last being the same as in the previous invocation, then the initialization blocks 602 and 604 may be bypassed if subroutine 620 is called directly to process only the most recent key press.

FIGURE 13 is a flowchart of a subroutine 620 called from subroutine 600. As noted above, to construct a new object list the disambiguating system starts with a copy of the old object list. At block 626, the object list from the prior node is therefore stored so that it may be used to construct the new object list.

In the main routine shown in FIGURE 3, a keystroke was detected by the system at block 150. The receipt of a new keystroke causes a downward traversal in the vocabulary module tree, if a valid path exists to a child corresponding to the keystroke. At a block 621 in FIGURE 13, the valid keys bits field of the node 400 data structure is therefore examined to determine if valid instructions and a pointer correspond to the received keystroke. At a decision block 622, a test is made of the valid keys bits field to determine if a valid packet 408 consisting of instructions 406 and a pointer field such as 404a exists corresponding to the entered keystroke. If no valid packet corresponds to the keystroke, at a block 624 the old object list is returned to the main routine to generate the selection list. Since the received keystroke is part of an invalid keystroke sequence that does not correspond to any object within the vocabulary module, the keystroke is ignored and the current object list is returned to the main routine as being the object list from the vocabulary module. The branch of the subroutine 620 that comprises blocks 622 and 624 therefore ignores any invalid keystroke sequences and returns the object list generated at the parent node for possible inclusion in the selection list generated by the disambiguating system.

If a valid packet exists corresponding to the received keystroke at decision block 622, the subroutine proceeds to a block 626 where the new object list is copied to the old object list. Block 628 fetches the first valid instruction associated with the given key. Block 630 initializes the iterator NEW-INDEX to 1 so that the first instruction will generate the first item in the new object list. The subroutine then enters the loop comprised of blocks 632 through 642 to construct the object list associated with the valid instructions. At block 632 the OBJECT-LIST-INDEX field 556 is examined and the corresponding object loaded from the old object list. At block 634, the LOGICAL-SYMBOL-INDEX field 555 is examined and the appropriate symbol (associated with the received keystroke through a logical symbol index table like 550 of FIGURE 7) is appended to the end of the identified object. It will be appreciated that more than one character may be appended to the identified object at block 634 if the entry in the symbol table 550 at the given key 551 and logical symbol index 552 holds a character sequence. At a block 636, the combined object and symbol are stored as a new object in the new object list. At a block 638, a test is made to determine if the subroutine has processed the last valid instruction associated with the given key at the given node. If the last valid instruction has not been processed, at block 640 the next valid instruction is fetched. At block 642 NEW-INDEX is incremented.

If the test at decision block 638 indicates that all of the objects have been constructed for the node, the subroutine proceeds to a block 644 and follows the associated pointer to a child node. At block 646 the new object list is returned to the main routine in order to generate the selection list. It will be appreciated that the subroutine 600 in FIGURE 12 for generating the object list associated with each node is performed for each keystroke received from the user. No "searching" of the vocabulary modules is performed as the user enters a new keystroke sequence, since each keystroke merely advances the subroutine one additional level within the vocabulary module tree. Since a search is not performed for each keystroke, the vocabulary module returns the list of objects associated with each node with minimal processing overhead.

Inherent in the combination of the keystroke to object identification software process of subroutine 620, depicted in FIGURE 13 operating on the tree data structure 1010 depicted in FIGURE 10, lie several novel means to retrieve a larger vocabulary of objects while using less storage for the vocabulary module without increasing the processing time of subroutine 620.

By ordering the symbols in each row of the logical symbol index table 550 (FIGURE 7) of a given vocabulary module according to their frequency of use in the input lexicon, a large majority of the instructions 558 (FIGURE 8B) of all nodes 400 in the tree data structure 1010 can be made to have their LOGICAL-SYMBOL-INDEX fields 555 equal to one. Similarly, by ordering the instructions 558 of all instruction packets 406 in all nodes 400 so that the stem and word objects are generated in the object list 440 (FIGURE 11) in decreasing order of their use in the language, a large majority of the instructions 558 of all nodes 400 in the tree structure 1010 can be made to have their OBJECT-LIST-INDEX fields 556 equal to one. Thus, much of the data in the tree 1010 are redundant. Systematically identifying the redundancies and eliminating them by redirecting the paths linking parent nodes to child nodes and deleting child nodes no longer referenced, leads to a highly folded or wrapped data structure containing far fewer nodes, far fewer instructions, and far fewer links than the original tree, yet which still retrieves every object retrievable from the original tree. Furthermore, distinct instances of paths through the original tree whose instructions generate similar objects in the object list 440 are merged into common paths in the folded tree which hence forth function as generalized (as opposed to specific) object constructing rules, enabling the reduced structure to generate far more objects than were originally used to define the tree 1010 of a given vocabulary module. For example, an unfolded vocabulary tree generated from a list of 30,000 English words might contain over 78,000 instructions in a preferred embodiment. After folding by a preferred embodiment of the folding process as described above, the modified tree might contain fewer than 29,000 instructions, a number less than the number of word objects the structure is capable of retrieving, given the ambiguous keystroke sequences and the retrieval process embodied in a preferred manner in the flow chart of FIGURE 12. A remarkable and novel result, since each instruction only alters one object in the object list 430 of FIGURE 11 by appending a single symbol in response to a key press. This is a consequence of the folded tree and software retrieval process re-using common sequences of instructions as general object construction rules. A further aspect of the modified tree structure is the automatic identification of generalized rules for associating objects with keystroke sequences. Using such rules, the vocabulary module can, with a high probability of success, associate keystroke sequences with word and word stem objects which were not initially used in creating it. For example, an input word list to build a vocabulary module might include the words "sun", "run", and "running", but not the word "sunning", but the folded tree structure created by the algorithm would still create the word "sunning" as one of the objects in the selection list for the corresponding key sequence.

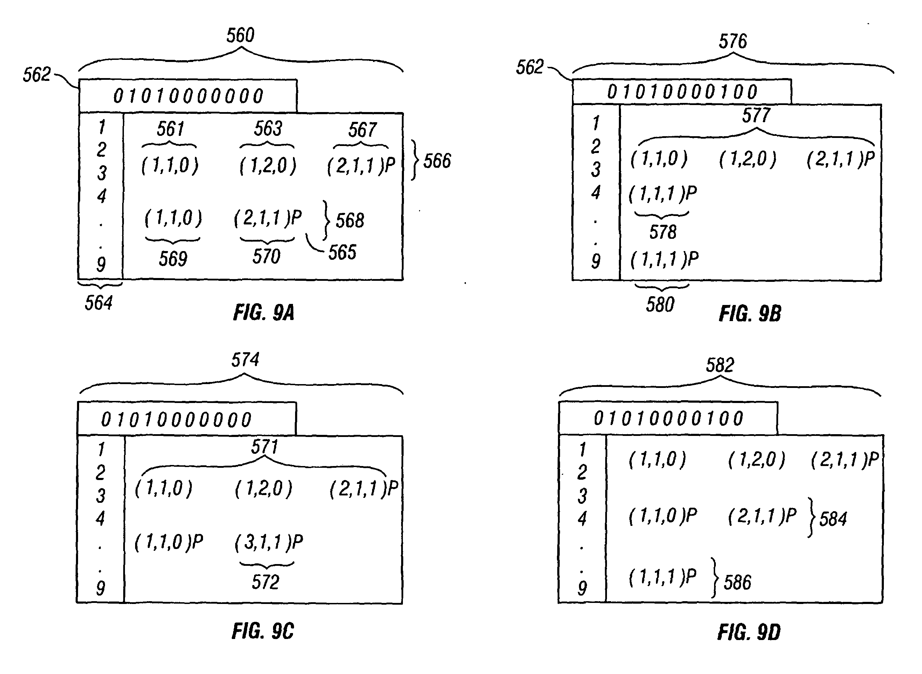

The nodes depicted in FIGURE 9 are examples. Node 560 has two valid keys as indicated by the "1 "s in its valid keys field 562 "01010000000". In a preferred embodiment the positions of the "1 "s indicate that the 2^{nd} and 4^{th} keys are valid paths and have packets of instructions and pointers to child nodes associated with them 566 and 568, respectively. Packet 566 contains three instructions "(1,1,0)", "(1,2,0)", and "(2,1,1)" followed by a pointer "P" linking 560 to a child node. If subroutine 600 of FIGURE 12 has processed a list of key strokes leading to node 560, then subroutine 620 of FIGURE 13 were called to process a "2" key, which is the 2 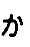 key in a preferred embodiment, the following would happen. Instruction 561 would append the 1^{st} logical symbol of key 2 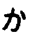 (" 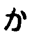 ") to the old object at index 1 to build the new object at index 1. The third field of 561, "0", is the false value of the STOP-FLAG 557 (FIGURE 8B), indicating that this is not the last instruction of the current packet, so the next instruction 563 is interpreted. Instruction 563 would append the 1^{st} logical symbol of key 2 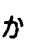 (" 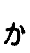 " in FIGURE 7) to the old object at index 2 to build the new object at index 2. The index of the new object will be 2 because the indices of the new objects being built are implicit in the order of the instructions themselves, e.g. the 2^{nd} instruction always builds the 2^{nd} object. The third field of instruction 563, "0", is the false value of the STOP-FLAG 557, so the next instruction 567 is interpreted. Instruction 567 would append the 2^{nd} logical symbol of key 2 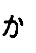 ("<" in FIGURE 7) to the old object at index 1 to build the new object at index 3. The third field of instruction 567, "1", is the true value of the STOP-FLAG 557, indicating that this is the last instruction of the current packet, so execution of subroutine 620 (FIGURE 13) would pass from block 638 to block 644.

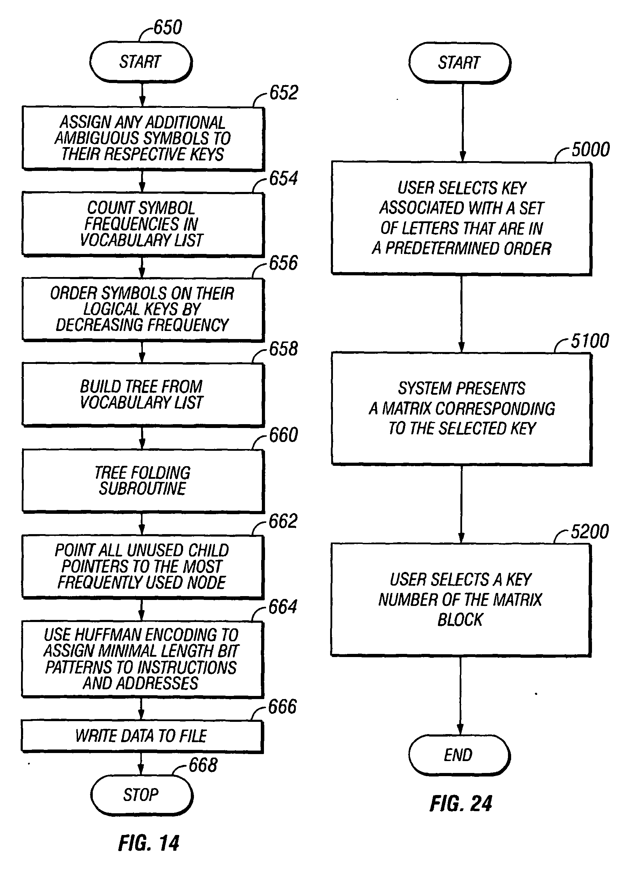

It is possible to combine two or more nodes containing different instruction packets 408 into a single node which can serve the same purpose as the multiple nodes separately, which means that certain nodes in a vocabulary tree 1010 are redundant in a novel sense. For the purpose of this invention the word "redundant" is used with respect to two nodes in the sense that one node can be dispensed with by the operations of the software processes which will be described below in reference to a preferred embodiment depicted in FIGURES 14-17.

For example, compare node 560 to node 574 in FIGURE 9. The instruction packets 566 and 571 on key 2 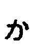 agree exactly, but instruction 570 on key 4 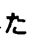 of node 560 conflicts with instruction 572 on key 4 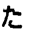 of node 574, so neither can do the work of the other, nor can the two nodes be combined into one which would do the work of both. Compare node 560 to node 576. The instruction packets 566 and 577 associated with key 2 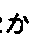 on each node agree exactly. Instructions 569 and 578 are different in the settings of their STOP-FLAG fields 557, but that difference does not cause them to conflict. The essential result of the object retrieval process of subroutine 620 in FIGURE 13 is the new object list created by executing the set of instructions at a node for a given key. Additional objects can be appended to the end of an object list without detriment to the correct processing of any of that node's children. Thus, no errors would be caused in the processing of the children of node 576 by the execution of an additional instruction after 578. The essence of the process would be disturbed only if the wrong instruction were to execute or if too few instructions were to execute. Similarly, the presence of a valid key on key 95 of node 576 does not conflict with the absence of a valid 95 key in node 560. Therefore, nodes 560 and 576 are redundant and can be merged into a new node 582 which achieves the net effect of both, and functions correctly as a parent node of the children of both. It will be appreciated that the pointers also play a role in defining redundancy. At the last keystroke of sequences in the tree associated with words which do not continue to form the stems of longer words, the pointers in the valid key packets 408 have a special value, NULL, in a preferred embodiment to indicate that there are no further children. Such nodes are called "terminal nodes." For two nodes with child nodes on valid keys in common to both nodes, the respective child nodes must be redundant for their parent nodes to be redundant, and so on to the nodes descending from the children, until terminal nodes are reached, or until there are no more descendants on valid keys sequences common to the nodes being compared.

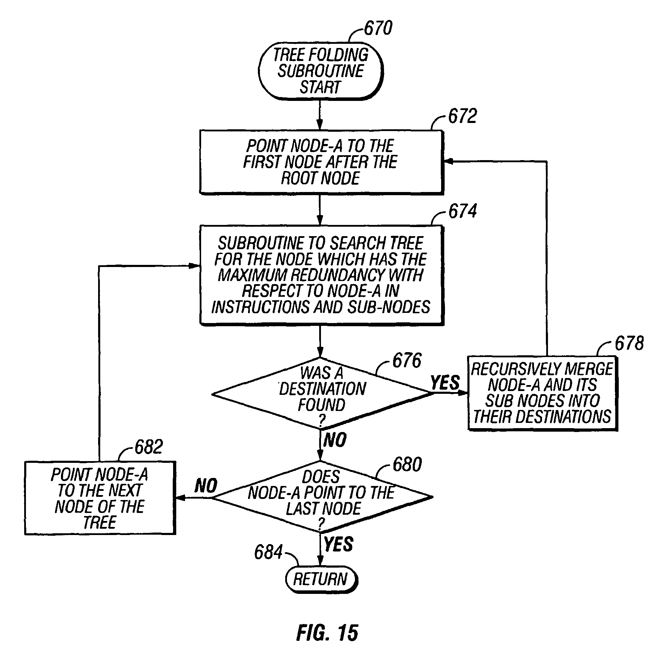

FIGURES 14 to 17 depict flow charts of preferred embodiments of software processes for the compression and folding of vocabulary module trees similar to 1010. FIGURE 14 is a flowchart of preferred embodiment of a software process to build a compressed vocabulary module. In block 652 a lexicon is scanned to identify any necessary additional ambiguous symbols other than those appearing on the physical keys, such as in FIGURE 6 for a Japanese vocabulary module. In blocks 654-656 the symbols are assigned their logical indices on their respective keys in decreasing order of their frequency of use in the input lexicon, as in the example of FIGURE 7. Given a lexicon of objects with frequencies, it will be obvious to someone skilled in the art how block 658 builds a vocabulary tree of the form 1010. In block 660, redundant nodes are identified and merged together to minimize duplication of data and, hence, turn isolated instruction sequences associated with single objects into generalized rules for retrieving multiple objects. This process is shown in detail in FIGURE 15. Block 662 identifies all the remaining NULL pointers from terminal nodes and changes them to point to the node with the largest number of parents, thus increasing the number of rules in the module. It will be appreciated that other rules could apply to assigning child nodes to the NULL pointers, and that such rules could be applied dynamically at the time of object retrieval, based on factors related to the keystrokes being processed. In block 664, the remaining instances of each unique instruction 558 (FIGURE 8B) and pointer 404a (FIGURE 8A) are counted so that they may be encoded as unique patterns of bits with shorter bit patterns being assigned to higher frequency instructions and addresses to conserve space. A preferred embodiment is Huffman coding as known in the art. Furthermore, nodes which are child nodes of multiple parent nodes may be stored in special orderings to facilitate their rapid retrieval and minimize the number of bits required to address them.

In choosing instructions 558 to describe objects to be stored while building the tree at block 658, it will be appreciated that when objects are words or stems of words, their character sequences contain additional data which may be used advantageously to increase the redundancy of the nodes in tree 1010. For example, not all pairs of kana in the Japanese language are equally common, e.g. " 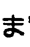 " is commonly followed by " 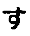 ". The statistics of kana pairs, or bigrams, can be used to predict the most likely next kana in an object from the preceding kana. With such predictions the logical ordering of the ambiguous symbols in the logical symbol index table 550 of FIGURE 7 can be dynamically altered to further optimize the use of the first position. The predictions can be extended to kana triplets, trigrams, and generally to n-grams.

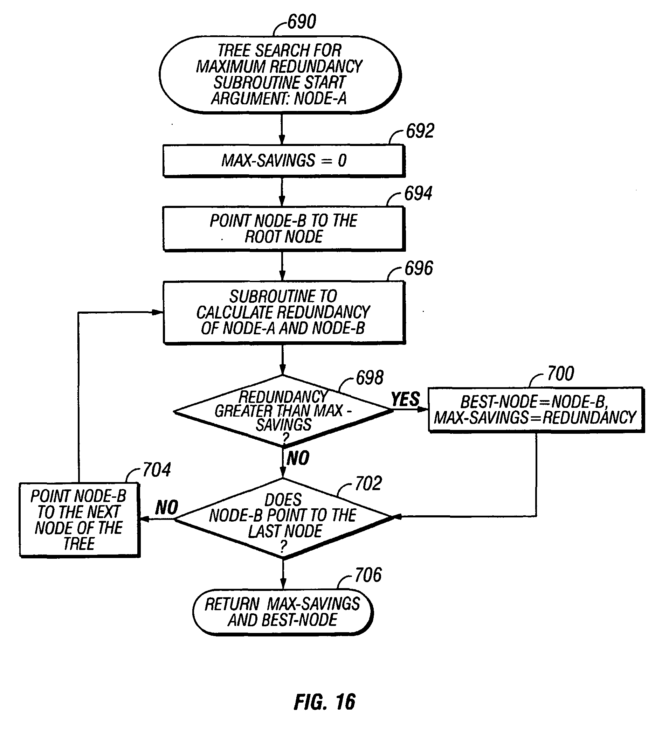

FIGURE 15 is a flowchart of a preferred embodiment of a software process to fold the tree 1010 of a vocabulary module. Block 670 is entered from block 660 of the flowchart of FIGURE 14. Block 672 initializes the process to begin with the first node of 1010 of FIGURE 10 after the root node 1011. Block 674 calls subroutine 690 depicted in a preferred embodiment in the flowchart of FIGURE 16 to locate a node, if any, which is maximally redundant with the current node. If a destination node is found, decision block 676 directs the process to block 678 where the redundant node(s) are merged together, eliminating duplicate data from the tree subsuming multiple, individual instances of instructions into shared sequences, which are general rules for associating keystroke sequences to objects. If decision block 676 fails, then decision block 680 tests whether the process is done. If there are more nodes to process, the flow advances to block 682 to identify another node.

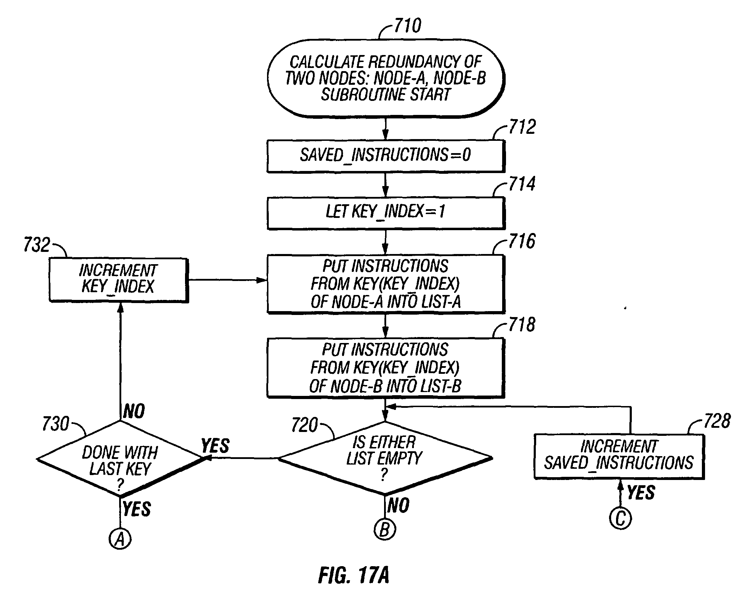

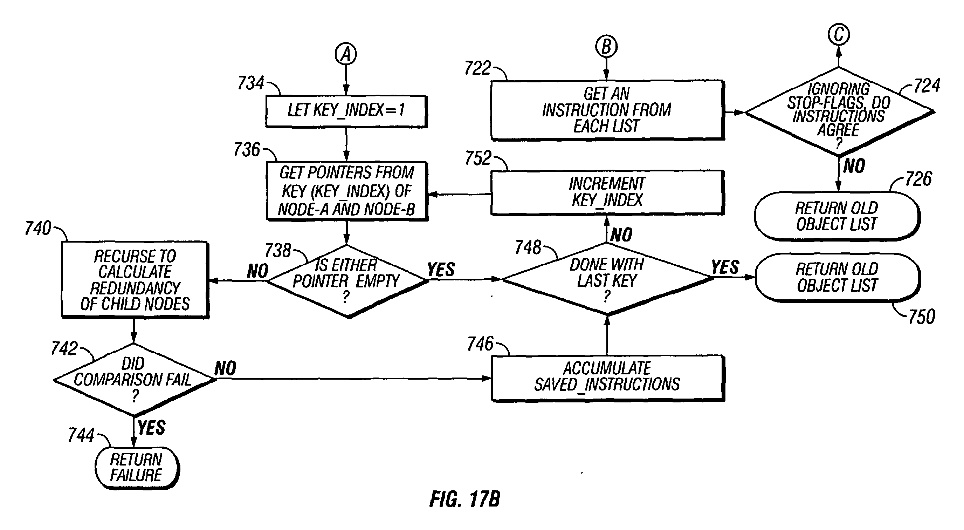

FIGURE 16 is a flowchart of a preferred embodiment of a software process to find in a tree 1010 a node with the highest degree of redundancy with respect to a given node. Block 690 is entered from block 674 of the flowchart of FIGURE 15. Block 692 initializes a placeholder MAX-SAVINGS for the measured redundancy. Block 694 initializes the process to start at the root node 1011 of tree 1010 of FIGURE 10. Block 696 calls subroutine 710 depicted in a flow chart of a preferred embodiment in FIGURE 17 to compute the redundancy of the given node with respect to the current node. Decision block 698 tests whether a degree of redundancy greater than MAX-SAVINGS was reported. If so, block 700 records the identity BEST-NODE of the node provisionally found to be most redundant with respect to the given node and the reported measure of redundancy as MAX-SAVINGS. Decision block 702 tests whether all nodes have been evaluated. If not, flow continues to block 704, which advances from the current node to the next node. From block 704, flow returns to block 696. If the result of the test at decision block 702 is that the last node has been evaluated, then block 706 returns the identity of the node most redundant, if at all, to the given node to block 674 of subroutine 670 of FIGURE 15.

FIGURE 17 is a flowchart of a preferred embodiment of a software process to compute the numerical redundancy between two specified nodes. Block 710 is entered from block 696 of the flowchart of subroutine 690 of FIGURE 16. Block 712 initializes a count of duplicate instructions. Block 714 initializes KEY-INDEX to 1. Block 716 reads the instruction packets 406 associated with key KEY-INDEX from the first of two nodes 400 specified as parameters to the subroutine and puts them in a temporary list, LIST-A. If key KEY-INDEX is not a valid key, no instructions are read. Block 718 reads the instruction packets 406 associated with key KEY-INDEX from the second of two nodes 400 specified as parameters to the subroutine and puts them in a temporary list, LIST-B. If key KEY-INDEX is not a valid key, no instructions are read. Decision block 720 determines whether either LIST-A or LIST-B is empty. If not, block 722 fetches one instruction from both LIST-A and LIST-B, reducing the number of instructions remaining in each by one. Decision block 724 tests whether the instructions are the same in their LOGICAL-SYMBOL-INDEX and OBJECT-LIST-INDEX fields. If not, a failure code for no redundancy is returned to block 696 of subroutine 690 in FIGURE 16. If the decision of block 724 is yes, then block 728 increments the count SAVED INSTRUCTIONS. Control passes again to block 720. If the decision block 720 tests TRUE, control passes to decision block 730, which tests whether the two nodes have been compared with respect to all possible keys. If not, block 732 increments KEY-INDEX, and control passes to block 716. If the decision at block 730 is yes, control passes to block 734 to reset KEY-INDEX to 1. Block 736 examines the pointers associated with key KEY-INDEX of the two nodes. Decision block 738 tests whether either pointer is empty (NULL), which would be the case for a pointer in a terminal node or for any key which is not valid. If neither pointer is empty, control passes to block 740, which uses subroutine 710 recursively to test whether the child nodes pointed to by the two non-empty pointers are redundant. The result of block 740 is tested at decision block 742. If the two child nodes were found not to be redundant, a failure code is returned. Otherwise, the two children are found to be redundant with a certain numerical score which is accumulated by block 746. Decision block 748 tests whether the pointers associated with the last key (key 9 in the preferred embodiment) have been tested. If not, block 752 increments KEY-INDEX and passes control to block 736. If the test at block 748 determines that all pointers have been checked, then the accumulated numerical measure of redundancy of the two nodes originally identified when the subroutine was entered at block 710 is returned.

It will be appreciated that the calculation of numerical values of redundancy may be weighted to take into account additional factors such as the number of branches present at each node and the number of parents which point to a node as a child. It will be appreciated that if two nodes are not redundant because of the ordering of instructions associated with a certain key, the order of instructions associated with low frequency words in the input lexicon could be reordered without impacting the priority of instructions associated with higher frequency objects, thus increasing the redundancy of the tree.

The method disclosed above for reducing the size of the tree by eliminating redundant nodes has been described with respect to a tree composed of primary instructions. Associating each primary instruction with a list of zero or more secondary instructions increases the complexity of the objects to be merged, but the procedure disclosed can still be used to identify and eliminate redundancy in a tree including both primary and secondary instructions. Furthermore, it is not necessary that both the primary and secondary instructions are stored in the same physical tree in memory. The two sets of instructions can be primary and secondary instructions are stored in the same physical tree in memory. The two sets of instructions are preferably stored in separate trees as long as the sequence of primary instructions in a node of the primary instruction tree corresponds to the sequence of sets of secondary instructions in the corresponding node of the secondary instruction tree. Similarly, when the primary and secondary instructions are stored in the same physical tree in memory, they may be intermingled such that each primary instruction is immediately followed by a sequence of the (zero or more) associated secondary instructions. Alternatively, all of the primary instructions in a node may be stored in sequence in a contiguous block, followed by a second sequence of contiguous blocks in the same order as the primary instructions, each block containing the (zero or more) associated secondary instructions. In this alternative format, nodes which are redundant in terms of their primary instructions may be merged, and two or more separate sets of associated secondary instructions may be merged. Then at each parent node which jumps to the merged node, it is only necessary to add a small amount of additional information to specify which of the alternate sets of secondary instructions is to be executed.

Furthermore, in yet another aspect of the invention, greater efficiencies in database compression are achieved by storing each kanji character only once in the database structure for any particular associated reading. In general, a database may include a number of different instances of the same kanji with the same reading, e.g. the kanji 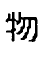 (read as 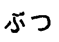 ) in 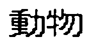 ( 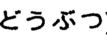 ) and 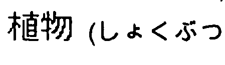 ). To facilitate the entry of various unusual combinations of kanji characters, such as in unusual names or words not explicitly included in the database, e.g. 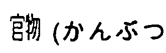 ) , each kanji should be able to be specified by entering only the desired associated reading. Thus, in one preferred embodiment, starting immediately from the root of the tree structure, each reading of a given kanji is included in the database, with a secondary instruction which includes a specification of the code for the associated kanji. This instruction is stored in the secondary instruction list in an order determined by relative frequency of occurrence of that particular kanji with respect to the other text objects associated with the same reading and specified by other instructions in the same secondary instruction list. In all such cases, the corresponding secondary instruction appends the kanji to a null text object, since the node sequence that builds the associated reading starts at the root of the database tree. Thus, all secondary instructions which append a kanji to a null text object can have a distinctive format, wherein no index is required to specify an index of a previous Midashigo, and the number of bits used to specify the kanji character code can be sufficient to encompass and distinguish between the large number of valid kanji characters represented in the database.

Correspondingly, when a kanji character appears in a word or phrase of the database anywhere other than as the first character of the word or phrase, the associated secondary instruction is appending the kanji to an existing Midashigo text object that has previously been added to the secondary object list for the corresponding Yomikata in the primary object list of the immediately preceding node. Thus, in this case, the instruction format must include a field in which the secondary object index of the Midashigo text object is specified. Likewise, when an existing Midashigo must be "preserved" so that a kanji can be appended in a later node, or when the kana (specified in the primary instruction) must be appended, a secondary object index field must be included in the instruction. Thus, to minimize the size of the database, the formats of these two types of secondary instructions, one with no secondary object index and the other with such an index, should be distinguished.

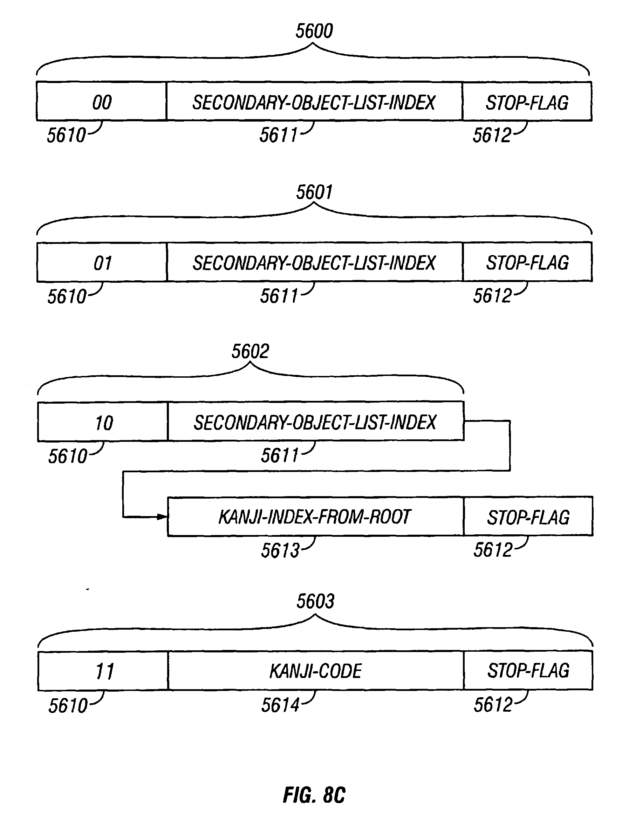

In the latter case, i.e. when the secondary object index in the instruction is non-zero and a kanji is to be appended to the Midashigo, the reading associated with the kanji to be appended can be determined by the system, because the system keeps track of which syllables have been appended to the associated reading in the primary object list since a character was last appended to the Midashigo text object specified by the index in the instruction. As described above, each reading of each kanji character is stored in the database starting at the root of the tree, where the code for the kanji character is fully specified in the associated instruction. Thus, in an instruction where a kanji character is to be appended to a previously existing Midashigo, the kanji is specified by storing an index which corresponds to the position of the fully specified kanji character which appears in the secondary object list of the determined reading starting from the root of the tree structure. This approach enables a large majority of the occurrences of kanji characters in the database to be specified with far fewer bits than is normally required, since the index stored will fall within a very limited range of values which can be determined at the time that the database is created. For example, in a database in which approximately 89,000 words are encoded, approximately 89% of the occurrences of kanji characters are preferably stored in this manner. In one preferred embodiment, as shown in FIGURE 8C, there are four types of secondary instructions, each beginning with a two-bit format field set to one of four distinct values, for example:

| | |
|---|---|
| 00 | PRESERVE instruction 5600: Preserve the Midashigo from the previous list specified by SECONDARY-OBJECT-LIST-INDEX in the list created by the current node (the kana appended by the primary instruction will be part of the Yomikata used to identify the next kanji element to be appended to this Midashigo) |
| 01 | KANA instruction 5601: Add the kana appended by the primary instruction (as a literal kana) to the previous Midashigo specified by SECONDARY-OBJECT-LIST-INDEX, and add this modified Midashigo to the current list |
| 10 | INDIRECT KANJI instruction 5602: The kana appended by the primary instruction completes the Yomikata for a kanji to be appended to the previous Midashigo specified by SECONDARY-OBJECT-LIST-INDEX; a separate N-bit field KANJI-INDEX-FROM-ROOT contains the list index where the kanji to be appended is found as fully-specified Midashigo in the node reached by tracing the completed Yomikata starting from root node. Note: one or more of these N-bit codes may be reserved to represent other specific special objects (such as the kanji repeat character or an escape sequence preceding a larger data item) to be appended to the previous Midashigo specified by SECONDARY-OBJECT-LIST-INDEX. |
| 11 | DIRECT KANJI instruction 5603: The following *N*-bit field KANJI-CODE fully specifies the encoding of kanji (as the first element of a Midashigo), such that the reading associated with the kanji includes all of the kana appended to the Yomikata from the root node up to and including the kana appended by the associated primary instruction. |

Thus, as shown in FIGURE 8C, instructions 5600-5602 with format field codes 5610 set to 00, 01 and 10 all include a field 5611 SECONDARY-OBJECT-LIST-INDEX specifying the index of a previously existing Midashigo in the list created by the immediately preceding node. In a PRESERVE instruction 5600, the indexed Midashigo is the one that is preserved in the list so that it is modified by one or more instructions in subsequent nodes. In a KANA instruction 5601, the indexed Midashigo is modified by appending the kana specified by the associated primary instruction. In an INDIRECT KANJI instruction 5602, the kana reading for the kanji to be appended is determined from the preceding sequence of instructions together with the primary instruction with which the instruction 5602 is associated. The kanji to be appended is specified by the KANJI-INDEX-FROM-ROOT field 5613, which is the index of the instruction in the secondary instruction list associated with the primary instruction which appends the final kana of the determined reading in a sequence starting from the root node 1011. In a DIRECT KANJI instruction 5603, a larger KANJI-CODE bit field 5614 is included which contains enough information to recover the full encoding of a given kanji. All of the instruction formats 5600-5603 also include a STOP-FLAG field 5612 which serves to distinguish the last instruction of a group associated with a given primary instruction.

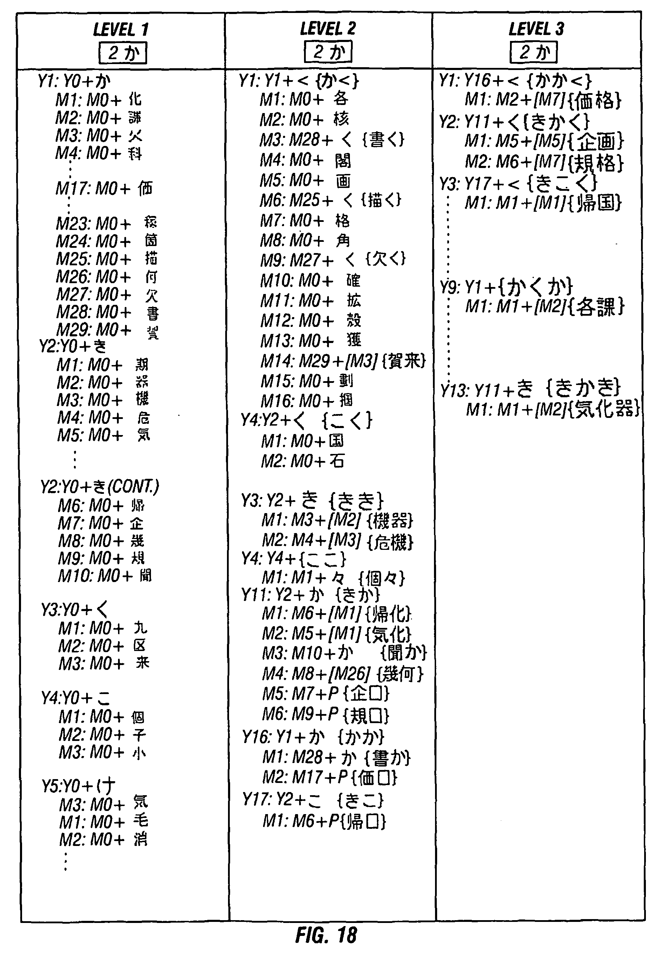

Examples of these various cases are illustrated in FIGURE 18 which shows a representation of some possible instruction lists in three nodes of a database tree structure. Note that for purposes of illustration, FIGURE 18 shows the primary instructions in a "decoded" form, showing the actual kana to append rather than the Logical Symbol Index (as in FIGURE 7) that would actually be stored in a database instruction. Also for purposes of illustration, the list object created by each instruction is shown in curly brackets to the right of the instruction. FIGURE 18 shows partial listings of both primary and secondary instruction lists of the nodes for three successive activations of the 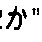 "2" key (e.g. key 122 of FIGURE 1d). The left hand column shows instructions for the first level node (i.e. starting from the root of the tree structure), representing the text objects created as a result of the first activation of the key in the sequence. The next two columns show the instructions for the second and third activations of the key. Each primary instruction in a list is labeled as Y1,...,Yn (where "Y" stands for "Yomikata"), and each primary instruction is shown with its associated list of secondary instructions, each labeled as M1,...,Mn ("M" for "Midashigo"). In FIGURE 18, Y0 and M0 represent "null" text objects. Thus, as would be expected, at the root level (level 1) all of the primary instructions specify Y0 and all of the secondary instructions specify M0. Thus, the secondary instructions represented at this level are DIRECT KANJI instructions (i.e. no SECONDARY-OBJECT-LIST-INDEX field is included), and the character code for each kanji character "X" shown in FIGURE 18 as "M0 + X" is fully specified in the KANJI-CODE field of the instruction. Since DIRECT KANJI instructions are only used to specify a kanji which appears as the first character of a Midashigo, even when such an instruction appears below the first level of the tree, no preceding PRESERVE instruction is required. Thus, no instructions of the form "M0 + P" appear in level 1 since they can be inferred, and there is no need to preserve a "null" text object. For example, in the middle column (level 2), primary instruction Y1 appends the kana < to the Yomikata Y1 of the preceding level (i.e. 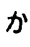 ), thus creating a Yomikata object 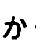 < at the second level. The fifth secondary instruction M5 is a DIRECT KANJI instruction, and thus corresponds to the complete reading 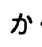 < which includes all kana appended from the root node down to the current level. The instruction also contains enough information to determine the correct output code for the character 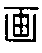 . This same kanji character is also part of the Midashigo created by the secondary instruction M1 associated with the primary instruction Y2 at level 3. The primary instruction Y2 appends the kana < to the Yomikata Y11 of the preceding level (i.e. 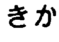 ), thus creating a Yomikata object 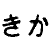 < at the third level. The secondary instruction M1 associated with this primary instruction Y2 is shown as "M5 + [M5]". This instruction is an INDIRECT KANJI instruction, and thus includes a SECONDARY-OBJECT-LIST-INDEX field which specifies a value of 5 (indicated in FIGURE 18 as "M5 + "). This refers to the fifth Midashigo object associated with Y11 (referenced by the OBJECT-LIST-INDEX field of the primary instruction) at the preceding level 2. This Midashigo object at level 2 is created by the primary instruction Y11: "Y2 + 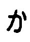 " and its associated secondary instruction M5: "M7 + P" (a PRESERVE instruction, indicating that the Midashigo object 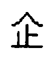 created and fully specified by instruction M7 associated with Yomikata Y2 of the preceding level (level 1) is to be duplicated (preserved) as the fifth Midashigo object in the list at the current level (level 2). This "preserve" instruction serves as a placeholder, and indicates that the kana added at this level ( 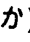 ) is the start of the reading of a kanji to be appended by a later instruction. This occurs at the level 3 INDIRECT KANJI instruction, Y2:M1: "M5 + [M5]", where the reading associated with the indexed kanji [M5] is known to be the preserved 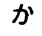 plus the < added by Y2 at level 3 ( 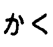 ). Looking up this reading 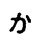 < starting from the root leads to Y1 at level 2, where the index [M5] leads to the fully-specified kanji 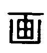 . Appending this to the preserved Midashigo from level 1 creates the fully specified Midashigo 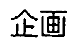 .

In another preferred embodiment, an alternate method is used to implement the function provided by the "preserve" instruction (format code 00 in the embodiment described above). In this alternate embodiment, as shown in FIGURE 8D, alternate instruction format 5604 with format code 00 is similar to instruction format 5602 in that it specifies both a KANJI-INDEX-FROM-ROOT field 5613 and the SECONDARY-OBJECT-LIST-INDEX field 5611 specifying the index of a previously existing Midashigo. However, in this alternate embodiment, the SECONDARY-OBJECT-LIST-INDEX refers not to the immediately preceding node, but to a node that precedes the current node by one more node than the number of nodes specified by the NUMBER-OF-KANA field 5615. The reading corresponding to the kanji to be appended is determined by tracing back through the chain of primary instructions from the referenced node up to the associated primary instruction in the current node. The advantage of this approach is that no separate PRESERVE instructions are required at the intervening nodes, so the database can be made more compact. The disadvantage is that multiple object lists from previous nodes must be maintained in processing keystroke sequences, rather than just one list from the preceding node. Similarly, in the alternate form of the KANA instruction 5605, the SECONDARY-OBJECT-LIST-INDEX refers to a node that precedes the current node by the number of nodes specified by the NUMBER-OF-KANA field 5615. The sequence of one or more kana to be appended is determined by tracing back through the chain of primary instructions from the referenced node up to the associated primary instruction in the current node. The same advantages and disadvantages apply as for the alternate PRESERVE instruction. As will be evident to one of ordinary skill in the art, the FORMAT CODE field (5610), the SECONDARY-OBJECT-LIST-INDEX field (5611), and the NUMBER-OF-KANA field (5615) may be combined in various ways, for example, by using Huffman encoding, to achieve greater compression in the stored instructions.

In another preferred embodiment of the present invention, further compression of the database is achieved without a substantial additional processing burden through the following mechanism. In many cases, the reading associated with a given kanji changes when it appears in a non-initial position in a word. In the vast majority of such cases, this phonetic change is a result of co-articulation effects of the pronunciation of the preceding kanji, and causes the initial consonant of the non-initial kanji to change from unvoiced to voiced, or from a fricative to a plosive. This corresponds to the addition of dakuten or handakuten to the first kana of the reading of the non-initial kanji. In the data storage and retrieval scheme disclosed above, this would require that an additional entry be made to the database to store the fully-encoded kanji associated with the alternate reading (with dakuten or handakuten) stored in a sequence of nodes starting at the root of the tree. In this preferred embodiment, when a kanji appears in a non-initial position with such an alternate reading, an INDIRECT KANJI instruction is used to specify the desired kanji in reference to the alternate reading. To reduce the size of the database, the referenced kanji is not stored from the root in association with the alternate reading, but only in association with its standard reading (without dakuten or handakuten). In order to identify the intended kanji, the value stored in the SECONDARY-OBJECT-LIST-INDEX field of the INDIRECT KANJI instruction is modified in the following manner: let N represent the number of kanji that are stored from the root in association with the alternate reading, and let X represent the SECONDARY-OBJECT-LIST-INDEX value that corresponds to the position of the intended kanji where it is stored from the root in association with its standard reading (without dakuten or handakuten). Then the SECONDARY-OBJECT-LIST-INDEX field of the INDIRECT KANJI instruction is set to the value (N + X). In processing the INDIRECT KANJI instruction, the system first searches the kanji stored from the root in association with the alternate reading, and determines that there are only N kanji stored there, which is less than the field value (N + X). Determining that the associated reading begins with a kana with dakuten or handakuten, the corresponding standard reading is generated, the determined number of kanji N is subtracted from the field value (N + X), and the intended kanji is found under the determined standard reading at the determined index position X.

### V. Representative System Operation Using Ambiguous Keystrokes

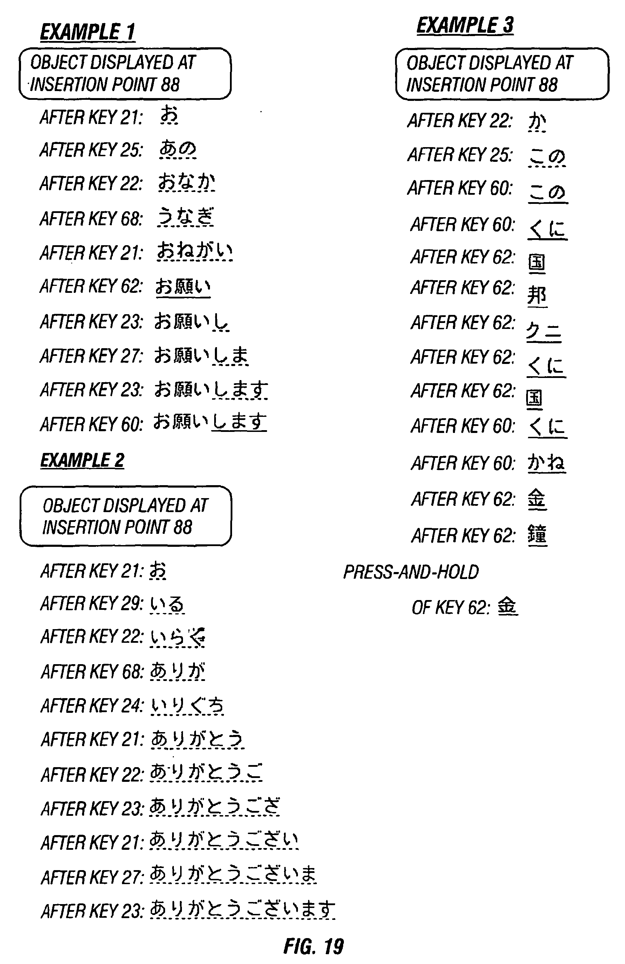

FIGURE 19 illustrates three representative examples of the operation of the system shown in FIGURE 1a. These examples illustrate the operation of the system and the nature of the feedback provided in an embodiment including the use of the data keys 21-30, Select key 60, Convert key 62, and Diacritic key 68. The examples show the text that would appear in the text area 66, including the special formatting of the object at the insertion point 88 (dotted underline or solid underline), as a result of each keystroke. Each keystroke is identified by the numeric label of the key shown in FIGURE 1a.

Example 1 in FIGURE 19 illustrates how the phrase 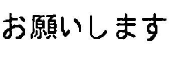 is input in one preferred embodiment of the system of FIGURE 1 a. After each of the first three keystrokes on keys 21, 25 and 22, the most frequent Yomikata is displayed, each corresponding to a word of length one, two and three kana, respectively. The fourth keystroke on the Diacritic key 68 specifies that the kana of the preceding keystroke on key 22 corresponds to a kana with dakuten, and the displayed Yomikata changes to the most common three-kana Yomikata matching the key sequence 21, 25, 22, and having a kana with dakuten in the third position ( 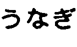 ). After the fifth keystroke on key 21, the most common Yomikata is 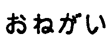 which corresponds to the first word of the desired input phrase. The following keystroke on the Convert key 62 changes the displayed text to the most common Midashigo corresponding to the displayed Yomikata, which in this case also corresponds to the first word of the desired input phrase. The next keystroke is on data key 23, which starts the input of a new keystroke sequence to be disambiguated since it follows one or more activations of either the Select key 60 or the Convert key 62 (in this case, one activation of the Convert key 62). Following this keystroke on key 23, and the next two keystrokes on keys 27 and again on 23, as always the most frequent Yomikata are displayed. In this case also, the word displayed after these keystrokes corresponds to the desired word 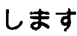 of the input phrase. A final keystroke on the Select key 60 indicates that the keystroke sequence of the current word object is finished, so that a next keystroke on a data key 21-30 would start a new input sequence.

Example 2 in FIGURE 19 shows the display during the input of the phrase 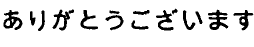 which is included in the database. Following the seventh keystroke (on key 22), the only object in the database that matches the input key sequence is the desired input phrase itself. Thus, even though the sequence at that point does not correspond to a completed word or phrase, the most frequent matching stem ( 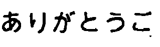 in this case) is displayed. Furthermore, since there is only one potentially matching object in the database, and the kana in the current position of this object includes dakuten, the kana is displayed with the dakuten even though the Diacritic key 68 has not been activated. Thus, in this case, activating the Diacritic key 68 is optional, and Example 2 shows the generation of the phrase without activating the Diacritic key 68 for either the 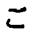 or the 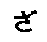 kana. A stem is displayed for the seventh through the tenth keystrokes of the sequence, until the input phrase is completed by the eleventh keystroke.

Example 3 illustrates various functions associated with the Select key 60 and the Convert key 62 in an embodiment. After the first two keystrokes on key 22 and key 25, the most frequent matching Yomikata is determined to be 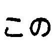 . The next keystroke on the Select key 60 signals the end of the data key sequence for the current word object, and is indicated by the dotted underline changing to a solid underline. A second press of the Select key 60 selects the second most common Yomikata 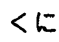 . The following keystroke on the Convert key 62 selects the most common Midashigo corresponding to the selected and displayed Yomikata < 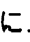 . The following two keystrokes on the Convert key 62 cycle through a less common Midashigo which is a single kanji character, and the last Midashigo in the sequence which shows the selected Yomikata in the form of katakana. The following keystroke on the Convert key 62 cycles back to the originally displayed hiragana as the first textual interpretation in the sequence of Midashigo which is identical to this Yomikata. An additional keystroke on the Convert key 62 repeats the cycle, again showing the most common kanji interpretation. Following that, a press of the Select key 60 reverts to the display of the currently selected Yomikata 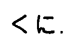 . A second press of the Select key 60 advances to the next (third most frequent) Yomikata 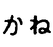 . The following two keystrokes on the Convert key 62 cycle through the first two (most common) Midashigo associated with this Yomikata, each of which is a single kanji character. A final press-and-hold of the Convert key 62 cycles backward in the Midashigo list to re-select the previously displayed kanji.

The reduced keyboard Japanese text input system disclosed herein reduces the size of the computer or other device that incorporates the system. The reduced number of keys allows a device to be constructed to be held by the user in one hand, while being operated with the other hand. The disclosed system is particularly advantageous for use with cellular phones, PDAs, two-way pagers, or other small electronic devices that benefit from accurate, highspeed text entry. The system can provide both efficiency and simplicity when implemented on a touchscreen based device or a device with a limited number of mechanical keys that may also have limited display screen area. The system of the present invention generates input in the form of the kana comprising the Japanese phonetic syllabary, and integrates the process of converting the input kana into the intended kanji or other textual interpretation corresponding to the kana reading. Furthermore, the system of the present invention provides a method for storing the information required for the system's operation in a database that is extremely compact, and that requires only minimal processing overhead in execution.

### AN EXEMPLARY EXPLICIT CHARACTER FILTERING OF AMBIGUOUS TEXT ENTRY

The present invention relates to a method and apparatus for explicit filtering in ambiguous text entry. The invention provides embodiments including various explicit text entry methodologies, such as 2-key and long pressing. The invention also provides means for matching words in a database using build around methodology, stem locking methodology, word completion methodology, and n-gram searches.

More specifically, the present invention relates to a method and apparatus for explicit filtering in an ambiguous text entry mode, for extending and interpreting objects, words, word stems, and the like, and for stem-locking. One specific embodiment of explicit filtering for reducing ambiguity uses a variety of explicit entry means, including a 2-key explicit entry feature, wherein a key depression in combination with a matrix display are used. An extending and interpreting methodology is provided wherein complex phrases are allowed to be typed in. Predetermined sets of characters are "built around" as anchors for the end or beginning of new words or word stems. Reasonable guesses are offered for extending words by "n-gram" analysis of preceding explicit letters. Specifically, three specific embodiments using stem-locking are provided, wherein the first embodiment uses a combination of the n letters of a desired object, such as a word, and a next key. The second embodiment locks in the stem portion of the object and resolves the unlocked portion of the object. The third embodiment uses n-gram searches.

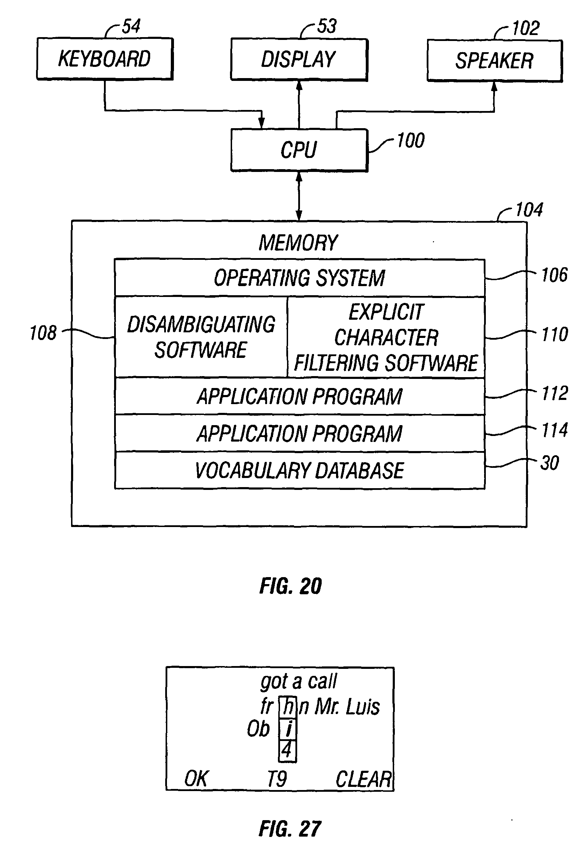

A block diagram of a preferred embodiment of the reduced keyboard disambiguating system hardware is provided in Fig. 20. The keyboard 54 and the display 53 are coupled to a processor 100 through appropriate interfacing circuitry. Optionally, a speaker 102 is also coupled to the processor. The processor 100 receives input from the keyboard, and manages all output to the display and speaker. Processor 100 is coupled to a memory 104. The memory includes a combination of temporary storage media, such as random access memory (RAM), and permanent storage media, such as read-only memory (ROM), floppy disks, hard disks, or CD-ROMs. Memory 104 contains all software routines to govern system operation. Preferably, the memory contains an operating system 106, disambiguating software 108, and associated explicit character filtering in ambiguous text entry software and/or extending and interpreting software 110 that is discussed in additional detail below. The memory also includes a vocabulary database 30. Optionally, the memory may contain one or more application programs 112, 114. Examples of application programs include word processors, software dictionaries, and foreign language translators. Speech synthesis software may also be provided as an application program, allowing the reduced keyboard disambiguating system to function as a communication aid. Therefore, the output, in this case, might be vocally output from the speaker.

It should be appreciated and understood by one of ordinary skill in the art that the discussion applies to symbols and sequences of symbols, which, when combined make an object or part of an object. A typical example of a symbol is a character in any language, such as a letter, digit, punctuation mark, or any other symbol from a language. A typical example of an object or part of an object is a word or part of a word. However, the discussion herein equally applies to Japanese kana and Korean jamos. Also, it should be noted that the objects don't have to be linguistic, as the claimed disambiguating system herein can be used to look up icons, phone numbers, or inventory records, as long as a type of symbolic string representation is present. Therefore, it should be appreciated that use of the terms such as letter, word, word stem, and the like are not limited to only those applications, and are used to facilitate ease of reading and understanding the discussion herein.

### Explicit Entry

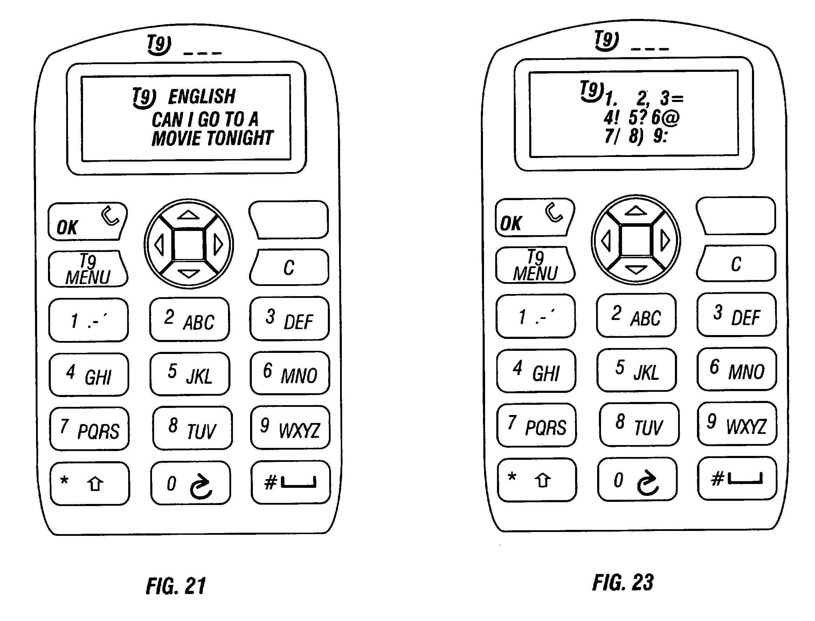

One preferred embodiment of generating an explicit character for the purpose of filtering word choices according to the invention provides a 2-key explicit entry feature. In many languages, such as English, all the letters associated with a key are printed on the key, such as depicted in Fig. 21, where Fig. 21 is a picture of an example wireless handheld device showing each letter of the English alphabet associated with a key according to the invention.

However, other languages, such as French, include many more letters than can visually fit on a key, such as the cell phone key. Fig. 22 is an example chart of European letters and some special symbols shown on the 0-9 keys and their respective Shift keys. For example, if a user presses the 5 key, then a matrix display with the alphanumeric characters j, k, I, and 5 appear. Fig. 23 is a sample screenshot of one 2-key matrix input method according to the invention. After the first key has been pressed, the matrix of choices is displayed on the device panel. It should be appreciated that other labels printed on keys are possible, such as, for example, each key including a subset of predetermined sets of associated letters, such as displaying the first and last character of predetermined sets of associated letters.

Fig. 24 is a flow chart of 2-key explicit entry for the explicit character filtering in ambiguous text entry system of Fig. 20. According to a preferred embodiment of the invention, for a user to explicitly select one of many letters assigned to a key, as in the case of the French language, the user selects, such as by depression, the associated key (5000). The selection, e.g. depression, of the desired key causes the system to presents a second set of letters, such as in matrix form, that corresponds to the selected key (5100). Each block in the matrix includes a letter from the set of letters associated with the just selected/depressed key. Fig. 23 shows an example of what is displayed as a result of depressing the 1 key. All that is required at this point is for the user to select the key number of the matrix block that includes the desired character (5200). This explicit selection process only requires at maximum 2 key selections/depressions for the selection of a letter.

It should be readily apparent to one of ordinary skill in the art that the 2-key explicit entry method for the purpose of filtering can be extended to any other language. It should also be apparent to one of ordinary skill in the art that alternate configurations are possible, such as, for example, a scrolling list. According to an alternate configuration, the user selects a key by way of a long-press to display and cycle through the character sequence on that key. As shown in Fig. 27, some or all of the characters may scroll past in a preview window as long as the key is being pressed. When the key is released, the last highlighted character is accepted.

In yet another configuration, after the character sequence is presented by way of the long-press on the key, the character appears or is highlighted each additional time the key is pressed. The presentation of each explicit character may end when a sufficient time elapses between one key press and the next or when a different key is pressed.

In yet another configuration, after the character sequence is presented by way of the long-press on the key, the character appears or is highlighted each additional time a navigation key is pressed, where a navigation key is, for example, an arrow key or a scrolling wheel.

Following is a list of other explicit entry means for filtering. It should be appreciated that the list is meant by example only, and is not exhaustive:
- long pressing on a key to enter a number/digit explicitly;
- changing to a numbers mode and pressing a key to enter a number/digit explicitly (and then returning to ambiguous entry mode for filtering);
- changing to a multi-tap mode and pressing a key repeatedly to enter a character explicitly (and then returning to ambiguous entry mode for filtering);
- interpreting ambiguous mode key presses as an explicit character, either by grouping each pair of key presses as a 2-key explicit entry, or by grouping repeated presses of the same key as a multi-tap entry;
- using multi-switch keys, such as a 5-way rocker, which permits ambiguous entry on a simple press and an explicit character entry on a different kind of press; and
- by "chording," which means by pressing more than one key simultaneously, with a primary key indicating an ambiguous set of characters and a secondary key indicating which character in the set to select (e.g., on a video game controller).

Another means of explicit entry for filtering is when any character assigned to a key is offered to the user through a secondary means, e.g., displayed on the label of a programmable key, or "softkey", which if chosen would be entered explicitly. The softkey mechanism allows correction of the last keystroke entered, e.g., if the user is extending a word with additional characters or wishes to correct the displayed interpretation before the entire word is entered. The additional character offered would be based on an analysis of the most likely character associated with the preceding keystroke, or based on the words in the current word candidate list. Assuming the most likely character was already displayed in the ambiguous word choice, then the second most likely character would be offered. For instance, if the user wants to type "ram" and enters the key sequence 726, the word "ran" appears. The most likely letter for that position in the word candidate list associated with 726 is "m", then "m" could be offered on the softkey. When the user presses the softkey, the "m" replaces the "n" in the word "ran".

### Explicit Character Filtering in Ambiguous Mode

Explicit character filtering in ambiguous mode is when a character is explicitly entered during entry of a sequence of ambiguous entries. One embodiment of explicit entry already discussed is the 2-key explicit entry method using a matrix as described above. According to another preferred embodiment of the invention, explicit entry of a character is accomplished by a long depression of the associated key. When one or more characters in a sequence of characters is explicitly entered, only stored words with that explicitly selected character(s) in the corresponding position(s) are retrieved.

One way of retrieving the desired word according to one embodiment of the invention is when an explicit character is entered in ambiguous entry mode, then the disambiguating filtering system continues to match database words against the ambiguous and explicit letters as long as possible, rather than accepting the default word upon the first explicit letter. If there is no match, the last ambiguous word selected is accepted and a new letter is appended to it.

As an example, suppose a user wants to enter the word "home" in English T9. The user long presses the 6 key in the 3^{rd} position to explicitly select "m," resulting in only "home," and, in addition, word stems "imme" and "gome" after 4 keystrokes.

Another example is using a mixed alphanumeric word like "cu2night", which could be stored in a database. If the user long presses on the 2 key, then explicitly enters a "2," words such as "cub" are thus filtered out from the word candidate list.

Explicit filtering is another way to quickly offer word completions. If "cu2night" was in a database, and "cu" was entered ambiguously followed by "2" explicitly, all ambiguous interpretations of the keystroke sequence "282" will be filtered out, leaving "cu2night" as a more likely choice to be offered through word completion.

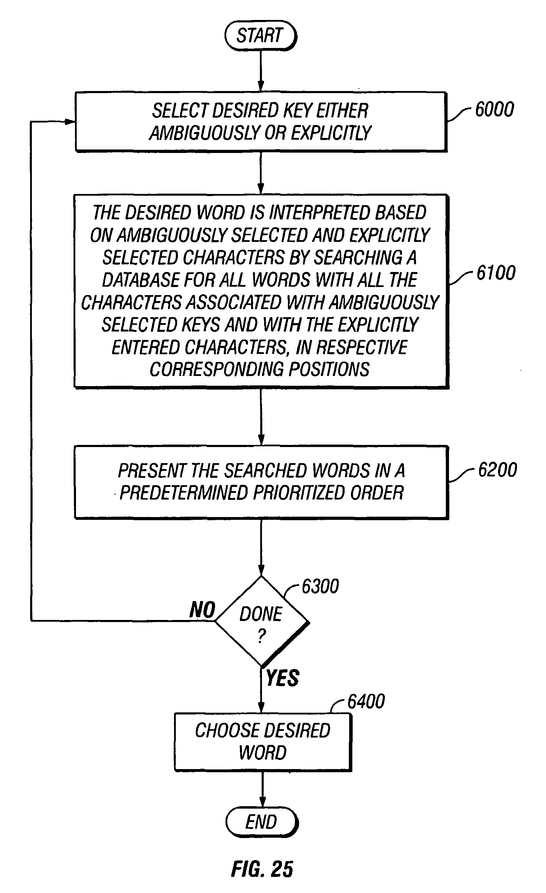

Fig. 25 is a flow chart for explicitly filtering in ambiguous mode according to a preferred embodiment of the invention. A character is desired and its associated key is entered either ambiguously or explicitly (6000). The desired word is then interpreted based on the sequence of ambiguously selected keys (i.e. their associated characters) and the explicitly selected characters. The database is searched for words with the characters associated with ambiguously selected entries, e.g. keys, and with the explicitly entered characters, in their respective corresponding positions (6100). The searched words are then presented or displayed in a predetermined prioritized order (6200), such as a most frequently used order. If the desired word is among the set of presented searched words (6300), then the desired word is chosen (6400) and the process ends. Otherwise, the process is not over and steps are repeated from selecting a desired key (6000).

### Build Around

In another aspect of the disambiguating filtering system, words from the database can be "built around" explicitly or ambiguously entered characters, or, additionally characters from a predetermined set of characters. According to one interpretation, the matching words, if any, include the explicit character for a particular sequence. However, additional interpretations of the sequence may include: one or more words that match the ambiguous keys that precede and/or end with the explicit character; one or more matching words that begin with the explicit character if any; and one or more words that match the ambiguous keys that follow the explicit character. For example, if the key sequence for "gifts4less" is entered, with the digit "4" entered explicitly, the words "gifts" matches the ambiguous key sequence preceding the explicit character and "less" matches the key sequence following it, even if "gifts4less", "gifts4", and "4less" are not found in the database. Similarly, "mobile.com" may be typed as one word automatically constructed from the database entries "mobile" and ".com", or from the entries "mobile" and "." and "com" if there is a key for ambiguous punctuation; in either of those cases the period may not need be explicitly entered.

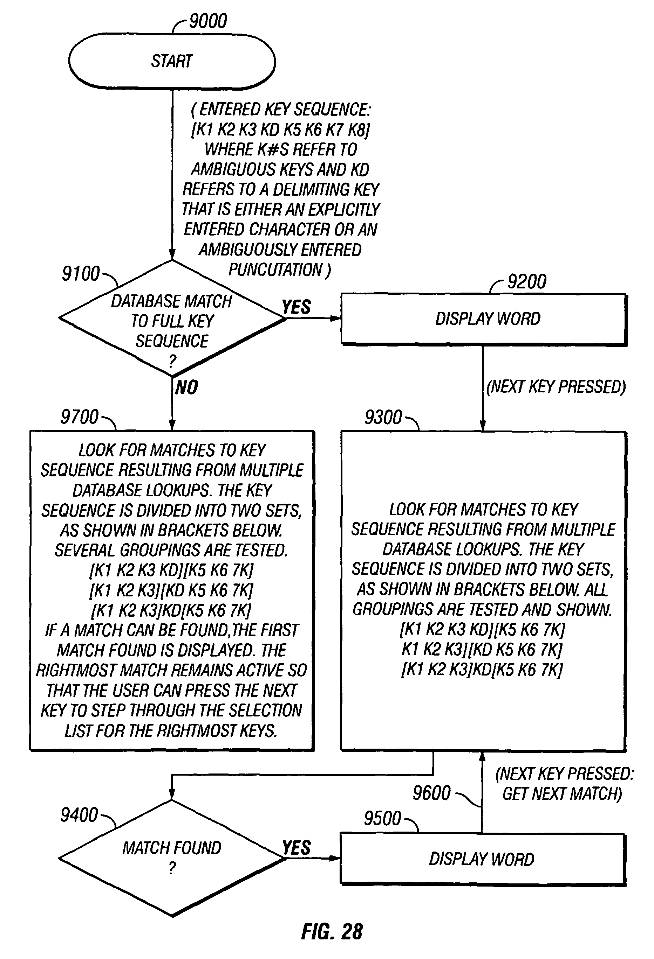

One embodiment of the build around concept can be described with reference to Fig. 28, a flow chart depicting a build around example. The build around method starts (9000) with a key sequence being entered, e.g., [k1 k2 k3 kd k5 k6 k7 k8]. The k#'s refer to ambiguously entered keys and kd refers to a delimiting key that can be either an explicitly entered character an ambiguously entered punctuation character. The method then determines if the database found a match (9100). If yes, a word is displayed (9200). If the user desires to proceed to the next choice in the list of words found by the database, the user presses a next key to request further lookups by the database (9300). Specifically, the database is multiply searched for matches to key sequences. A key sequence is divided into two sets on either side of a delimiter. An example of various groupings of two sets of sequences divided by a delimiter follows:
- [k1 k2 k3 kd] [k5 k6 k7 k8];
- [k1 k2 k3] [kd k5 k6 k7 k8]; and
- [k1 k2 k3] kd [k5 k6 k7 k8].

If a match is found among any of the groups (9400), then the desired word is chosen and displayed (9500). If the user desires to build around this sequence, the user can press a next key to obtain the next set of results from multiple searches to the database (9600).

If the database did not find an initial match (9100), then the database is multiply searched for matches to key sequences (9700), wherein a key sequence is divided into two sets on either side of a delimiter, description of which and examples of which are presented above.

**Stem-locking**

In the preferred embodiment of the invention, stem-locking is locking one or more subsequences or substrings of characters within a sequence. For example, the first n-numbers of sequence of characters of a word can be locked in. The way stem-locking works is that only words with those locked in characters are searched. For instance, suppose a user selects the 4 and then the 6 key of a wireless cell phone using T9 technology. The word "go" is presented in the display. If "go" is locked in, then upon subsequent key selections, only words with "go" in the first two positions are selected.

The locking of letters can be performed in a number of different ways. For example, two such ways are by a "full next locking" mechanism and an "unbounded" methodology by moving a cursor over characters to select. As an example of implementing "full next locking," a "next" key is used. That is, according to one embodiment of the invention, selecting a "next" key locks in a previously presented series of characters, thereby eliminating the possibility of the system re-interpreting the object by re-interpreting the locked in series of characters. The selected series of characters are now marked as explicitly entered. An example of moving the cursor over characters (unbounded) according to one embodiment of the invention, the cursor is moved to the beginning of a series and by the user selecting a right-arrow key (or a left-arrow key, for example, in the Hebrew language), all the characters that the cursor moved over are locked in.

Another aspect of full next locking is locking a previously presented series of characters when likely word boundaries are identified. Such boundaries can be identified based on certain sequences of interactions, such as, for example, when the user "nexts" and then selects a symbol or punctuation character; or, when the user "nexts" and then enters an explicit number.

It should be appreciated that other methods to "lock" include, but are by no means limited to:
- pressing a key assigned to the "lock" function, such as an OK or Select key; and
- pressing an appropriate arrow key to "lock" in a word completion being offered.

Stem locking approaches, such as those discussed above, can be related to "build around" as described herein above. That is, once a sequence has been locked in, it can be "built around."

### Japanese Kana Example

Another example of the disambiguating filtering methodology is in the Japanese language. Sub-phrases in kana (phonetic) character form can be converted to kanji (Yomikata), and those converted sub-phrases may in turn filter interpretations of the remaining ambiguous kana preceding or following the converted sub-phrases, excluding interpretations that can't be used to construct valid phrases.

In another embodiment of the invention, a hierarchy of locks mechanism is used. For example, a right arrow key can lock in all characters to the left of the cursor. Therefore, in this implementation, a right-arrow key locks in a first-choice stem, while a "next" key locks in a not-first-choice stem.

Another implementation is using a "select" key instead of a right-arrow key in combination with a "next" key. For example, the "select" key can be used at the end of each ambiguous key sequence for either selecting and accepting the default choice (the select key is pressed once) or for selecting an alternative choice (the select key is pressed more than once until the desired choice appears or is highlighted). In this case, the "select" key is used to stem lock either the first or alternate choices, rather than using the right-arrow key for the first choice and the "next" key for other choices (or vice-versa, as the choice of keys is arbitrary, yet predetermined).

### Word Extension and Completion

Another aspect of the invention is the system automatically starting a new word at a lock position. For example, the user enters "car" and locks it, and then enters the keys for "pet". "Carpet" is shown because it is a complete word in the database. The word "carset" is also shown because it is "car" + "set", which is another example of the "build around" concept, where an ambiguous sequence may follow an explicit character entry, causing one interpretation to be the beginning of a new ambiguous word.

Alternatively, when one or more previously-accepted characters precedes (is adjacent to, without spaces) the current and active ambiguous key sequence. The system uses the preceding characters to match words and phrases (e.g., in the user database) that begin with those characters and that match an ambiguous key sequence following those characters. Optionally, one or more word completions is offered. An example follows. A user enters and locks in (accepts) the characters, "con." Then, the user types ambiguous keys for "stan" and is offered "constantinople" as a word completion. In this example, the user could have used a left-/right-arrow key to accept "con" to be used to filter and to suggest word completions that begin with the accepted chars and are immediately adjacent to an ambiguous key sequence. Hebrew and other languages go the other direction, hence right-side-only is not assumed.

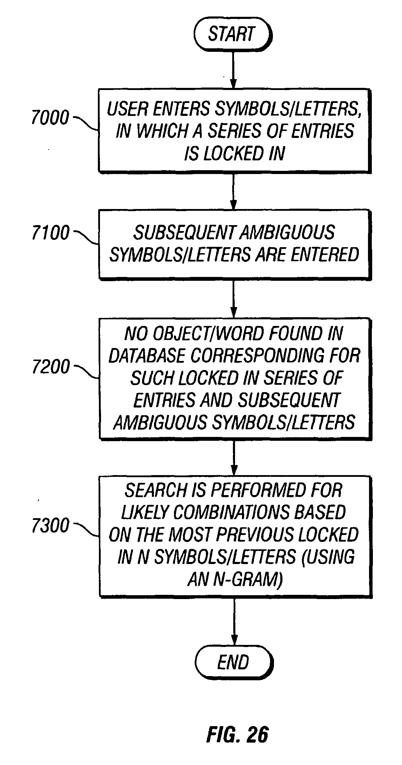

Fig. 26 is a flow chart of a method for generating words not stored in the database according to the invention. That is, in an equally preferred alternate embodiment, if a series of entries is locked in (7000) and subsequent ambiguous characters entered (7100) and a corresponding stored word is not found in the database (7200), then searches are performed for likely combinations based on the previous n locked in characters (7300). In one preferred embodiment of the invention, an n-gram is used to find stored words. This is contrary to using the entire set of locked in letters. For example, suppose a user has entered and explicitly selected the word "flight", but the user, however, wants to enter the word "flightplan" which is not in the database. In this embodiment of the invention, the user then explicitly locks in the letter "p" and "I" after "flight". The system then searches for words using the last explicitly entered bigram (p and I). Thus, words that are not stored in the database are generated.

Accordingly, the invention should only be limited by the Claims included below.

## Claims

1. An apparatus for filtering of ambiguous text entry based on at least one explicitly entered character in said ambiguous text entry, said apparatus comprising:
a keyboard (54) and a display (53) each coupled to a processor (100) through appropriate interfacing circuitry, wherein said processor (100) receives the text entry from said keyboard (54) and manages output words to said display (53), wherein, responsive to said text entry, various keystroke interpretations are displayed to aid a user in resolving any ambiguity;
a memory (104) coupled to said processor (100), wherein said memory (104) comprises:
an operating system (106);
disambiguating software (108);
explicit character filtering in ambiguous text entry software (110); and
a word database,
wherein the ambiguous text entry comprises a key stroke sequence representing a sequence of letters, wherein ambiguous letters in the sequence of letters are based on strokes of keys having multiple meanings and wherein an explicit letter in the sequence of letters is explicitly entered at a specific position in the sequence of letters by means for entering an explicit letter;
**characterized in that**:
only stored words from said word database having said explicitly entered letter in the specific position are retrieved for display, wherein said means for entering an explicit letter is configured to enter an explicit letter by any of :
2-key explicit entry comprising presenting a set of letters corresponding to a key upon selection of the key by a user and selection of a desired letter from the presented set of letters by the user;
long pressing a key to display and cycle through a letter sequence;
changing to a multi-tap mode and pressing a key repeatedly to enter a letter explicitly;
using a multi-switch key that is depressible in multiple ways, thereby permitting ambiguous entry on a first type of press and an explicit letter entry on a different kind of press;
chording by pressing more than one key simultaneously, with a primary key indicating an ambiguous set of letters and a secondary key indicating which letter in the set to select; and
using a programmable soft key configured for offering a letter assigned to a key based on analysis of most likely letter associated with a preceding keystroke.

2. The apparatus of Claim 1, further comprising speech synthesis software and a speaker as a communication aid.

3. The apparatus of Claim 1, wherein said 2-key explicit entry uses any of:
a matrix display;
a label including a subset of predetermined sets of associated letters; and
a scrolling list.

4. The apparatus of Claim 1, said long pressing further comprising, after said letter sequence is displayed, either of:
a next letter in said letter sequence is highlighted each additional time said key is pressed, ending after a sufficient time elapses between one key press and the next or when a different key is pressed; and
a next letter in said letter sequence is highlighted each time one of an arrow key and a scrolling wheel is activated.

5. The apparatus of Claim 1, said explicit character filtering software further comprising:
means for matching said words in said database against explicitly entered letters and ambiguously entered letters ,rather than accepting a default word upon a first explicitly-entered letter.

6. The apparatus of Claim 1, wherein said retrieved, stored words are ordered for display according to a predetermined priority.

7. The apparatus of Claim 1, said explicit character-filtering software further comprising means for building at least one word around at least one delimiting letter, wherein said at least one delimiting letter is an explicitly or ambiguously entered letter, or a letter from a predetermined set of letters.

8. The apparatus of Claim 7. wherein said means for building at least one word around said at least one delimiting letter further comprises any of or any combination of:
means for interpreting by matching words which include explicitly entered letters for a particular sequence;
means for interpreting by matching words which include one or more words that match ambiguous keys that precede said at least one delimiting letter,
means for interpreting by matching words which include one or more words that match ambiguous keys that end with said at least one delimiting letter;
means for interpreting by matching words which include one or more words that begin with said at least one delimiting letter; and
means for interpreting by matching words which include one or more words that follow said at least one delimiting letter.

9. The apparatus of Claim 7, wherein said means for building at least one word around said at least one delimiting character is actuated by pressing a next key to obtain a next set of results from multiple searches in said word database.

10. The apparatus of Claim 1, said explicit character filtering software further comprising means for stem locking, wherein said stem locking comprises marking one or more substrings within a character sequence as explicitly entered so that re-interpreting said one or more substrings is rendered unnecessary.

11. The apparatus of Claim 10, said means for stem locking further comprising any one of or any combination of:
a full next locking mechanism, wherein a next key locks one of said one or more series of letters;
unbounded locking by moving cursor over one of said one or more series of letters by using an arrow key;
means for using previously explicitly entered letters preceding a current ambiguous key sequence by matching words in said database, wherein said words begin with said explicitly entered letters and match said ambiguously entered key sequence;
means for suggesting word completions ;
means for allowing pressing a key to be assigned to a locking in function, such as an OK or Select key;
means for allowing pressing an appropriate arrow key to lock in a word completion being offered;
- a mechanism for a hierarchy of locks, wherein activation of a first control locks a first-choice stem and activation of a second control locks stems subsequent to said first-choice stem; and
means for generating words not stored in said word database, wherein one or more likely matches are found for at least one subset of an entered stem, at least a portion of said entered stem having been locked and wherein a selection from said one or more likely matches is combined with said locked portion of said stem to generate a word not stored in said word database.

12. The apparatus of Claim 11, said full next locking mechanism further comprising means for identifying and using at least one word boundary to lock a stem, wherein said at least one word boundary is inferred from one or more actions indicating a word termination and wherein a character sequence preceding an identified word boundary is locked.

13. A method for filtering of ambiguous text entry based on at least one explicitly-entered character in said ambiguous text entry, said method comprising:
providing a keyboard (54) and a display (53) each coupled to a processor (100) through appropriate interfacing circuitry, wherein said processor (100) receives the text entry from said keyboard (54) and manages output words to said display (53),wherein, responsive to said text entry, various keystroke combinations are displayed to aid a user in resolving any ambiguity; and
providing a memory (104) coupled to said processor (100), wherein said memory (104) comprises:
an operating system (106);
disambiguating software (108);
explicit character filtering in ambiguous text entry software (110): and
a word database, wherein the ambiguous text entry comprises a key stroke sequence representing a sequence of letters, wherein ambiguous letters in the sequence of letters are based on strokes of keys having multiple meanings;
said method **characterized in that**:
wherein an explicit letter in the sequence of letters is explicitly entered at a specific position in the sequence of letters, wherein only stored words from said word database having said explicitly entered letter in the specific position are retrieved for display, further comprising entering a single explicit letter by any of :
2-key explicit entry comprising presenting a set of letters corresponding to a key upon selection of the key by a user, 2-key explicit entry comprising presenting a set of letters corresponding to a key upon selection of the key by a user and selection of a desired letter from the presented set of letters by the user;
long pressing a key to display and cycle through a letter sequence;
changing to a multi-tap mode and pressing a key repeatedly to enter a letter explicitly;
using multi-switch keys, thereby permitting ambiguous entry on a simple press and an explicit letter entry on a different kind of press;
chording by pressing more than one key simultaneously, with a primary key indicating an ambiguous set of letters and a secondary key indicating which letter in the set to select; and
using a programmable soft key as a secondary means for offering a letter assigned to a key based on analysis of most likely letter associated with a preceding keystroke.

14. The method of Claim 13, further comprising providing speech synthesis software and a speaker as a communication aid.

15. The method of Claim 13, wherein said 2-key explicit entry uses any of:
a matrix display;
a label including a subset of predetermined sets of associated letters; and
a scrolling list.

16. The method of Claim 13, said long pressing further comprising, after said letter sequence is displayed, either of:
highlighting a next letter in said letter sequence each additional time said key is pressed, ending after a sufficient time elapses between one key press and the next or when a different key is pressed; and
highlighting a next letter in said letter sequence each time one of an arrow key and a scrolling wheel is activated.

17. The method of Claim 13, said explicit character filtering software further comprising:
matching said words in said database against explicitly-entered letters and ambiguously entered letters, rather than accepting a default word upon a first explicitly entered letter.

18. The method of Claim 13, wherein said retrieved, stored words are ordered for display according to a predetermined priority.

19. The method of Claim 13, said explicit character filtering software further comprising building at least one word around at least one delimiting letter, wherein said at least one delimiting letter is an explicitly or ambiguously entered letter, or a letter from a predetermined set of letters.

20. The method of Claim 19, wherein said building at least one word around said at least one delimiting letter further comprises any of or any combination of:
interpreting by matching words which include explicitly entered letters for a particular sequence;
interpreting by matching words which include one or more words that match ambiguous keys that precede said at least one delimiting letter;
interpreting by matching words which include one or more words that match ambiguous keys that end with said at least one delimiting letter;
interpreting by matching words which include one or more words that begin with said at least one delimiting letter; and
interpreting by matching words which include one or more words that follow said at least one delimiting letter.

21. The method of Claim 19, wherein said-building at least one word around said at least one delimiting letter is actuated by pressing a next key to obtain a next set of results from multiple searches in said word database.

22. The method of Claim 13, said explicit character filtering software further comprising stem locking, wherein said stem-locking comprises marking one or more substrings within a character sequence as explicitly entered so that re-interpreting said one or more substrings is rendered unnecessary .

23. The method of Claim 22, said stem-locking further comprising any one of or any combination of:
providing a full next locking mechanism, wherein a next key locks one of said one or more series of letters;
providing unbounded locking by moving cursor over one of said one or more series of letters by using an arrow key;
using previously explicitly entered letters preceding a current ambiguous key sequence by matching words in said database, wherein said words begin with said explicitly entered letters and match said ambiguously entered key sequence;
suggesting word completions;
allowing pressing a key to be assigned to a locking in function, such as an OK or Select key;
allowing pressing an appropriate arrow key to lock in a word completion being offered;
providing a mechanism for a hierarchy of locks, wherein activation of a first lock locks a first-choice stem and activation of a second lock locks stems subsequent to said first-choice stem; and
generating words not stored in said word database, wherein one or more likely matches are found for a locked stem and wherein a selection from said one or more likely matches is combined with a second keystroke sequence to generate a word not stored in said word database.

24. The method of Claim 23, said full next locking mechanism further comprising identifying and using at least one word boundary to lock a stem, wherein said at least one word boundary is inferred from one or more interactions indicating a word termination and wherein a stem preceding an identified word boundary is locked.

## Patentansprüche

1. Ein Vorrichtung zum Filtern einer mehrdeutigen Texteingabe basierend auf zumindest einem explizit eingegebenen Schriftzeichen in der mehrdeutigen Texteingabe, wobei die Vorrichtung folgende Merkmale aufweist:
eine Tastatur (54) und eine Anzeige (53), die jeweils mit einem Prozessor (100) durch eine geeignete Schnittstellenschaltungsanordnung gekoppelt sind, wobei der Prozessor (100) die Texteingabe von der Tastatur (54) empfängt und ausgegebene Wörter zu der Anzeige (53) bringt, wobei ansprechend auf die Texteingabe verschiedene Tastenanschlaginterpretationen angezeigt werden, um einem Benutzer beim Auflösen jeglicher Mehrdeutigkeit zu helfen;
einen Speicher (104), der mit dem Prozessor (100) gekoppelt ist, wobei der Speicher (104) folgende Merkmale aufweist:
ein Betriebssystem (106);
eine Vereindeutigungssoftware (108);
Explizit-Schriftzeichen-Filterung in einer Mehrdeutige-Texteingabe-Software (110); und
eine Wortdatenbank,
wobei die mehrdeutige Texteingabe eine Tastenanschlagsequenz aufweist, die eine Sequenz aus Buchstaben darstellt, wobei mehrdeutige Buchstaben in der Sequenz aus Buchstaben auf Anschlägen von Tasten, die mehrere Bedeutungen aufweisen, basieren und wobei ein expliziter Buchstabe in der Sequenz aus Buchstaben an einer spezifischen Position in der Sequenz aus Buchstaben anhand einer Einrichtung zum Eingeben eines expliziten Buchstabens explizit eingegeben wird;
**dadurch gekennzeichnet, dass**:
nur gespeicherte Wörter aus der Wortdatenbank, die den explizit eingegebenen Buchstaben an der spezifischen Position aufweisen, zur Anzeige wiedergewonnen werden, wobei die Einrichtung zum Eingeben eines expliziten Buchstabens dazu konfiguriert ist, einen expliziten Buchstaben einzugeben durch eines der Folgenden:
2-Tasten-Expliziteingabe, die das Darstellen eines Satzes aus Buchstaben aufweist, die einer Taste entsprechen, nach Auswahl der Taste durch einen Benutzer und Auswahl eines gewünschten Buchstabens aus dem präsentierten Satz aus Buchstaben durch den Benutzer;
Langes Drücken einer Taste zum Anzeigen und zyklischen Durchlaufen einer Buchstabensequenz;
Wechseln in einen Mehrfachantipp-Modus und wiederholtes Drücken einer Taste, um einen Buchstaben explizit einzugeben;
Verwenden einer Multischaltertaste, die auf mehrere Weisen drückbar ist, wodurch eine mehrdeutige Eingabe bei einer ersten Art von Drücken und eine explizite Buchstabeneingabe bei einer anderen Art von Drücken ermöglicht wird;
Mehrtastenbetätigung durch gleichzeitiges Drücken von mehr als einer Taste, wobei eine primäre Taste einen mehrdeutigen Satz aus Buchstaben anzeigt und eine sekundäre Taste anzeigt, welcher Buchstabe in dem Satz ausgewählt werden soll; und
Verwenden einer programmierbaren, frei belegbaren Taste, die zum Anbieten eines Buchstabens konfiguriert ist, der einer Taste zugewiesen ist, basierend auf einer Analyse des wahrscheinlichsten Buchstabens, der einem vorangehenden Tastenanschlag zugeordnet ist.

2. Die Vorrichtung gemäß Anspruch 1, die ferner eine Sprachsynthesesoftware und einen Lautsprecher als Kommunikationsunterstützung aufweist.

3. Die Vorrichtung gemäß Anspruch 1, bei der die 2-Tasten-Expliziteingabe eines der Folgenden verwendet:
eine Matrixanzeige;
ein Etikett, das einen Teilsatz von vorbestimmten Sätzen aus zugeordneten Buchstaben umfasst; und
eine Scroll-Liste.

4. Die Vorrichtung gemäß Anspruch 1, bei der das lange Drücken, nachdem die Buchstabensequenz angezeigt ist, ferner eines der Folgenden aufweist:
ein nächster Buchstabe in der Buchstabensequenz wird jedes zusätzliche Mal, wenn die Taste gedrückt wird, hervorgehoben, was endet, nachdem ausreichend Zeit zwischen einem Tastendruck und dem nächsten verstrichen ist oder wenn eine andere Taste gedrückt wird; und
ein nächster Buchstabe in der Buchstabensequenz wird jedes Mal, wenn eine Pfeiltaste oder ein Scrollrad aktiviert wird, hervorgehoben.

5. Die Vorrichtung gemäß Anspruch 1, wobei die Explizit-Schriftzeichen-Filtersoftware ferner Folgendes aufweist:
eine Einrichtung zum Abgleichen der Wörter in der Datenbank mit explizit eingegebenen Buchstaben und mehrdeutig eingegebenen Buchstaben statt eines Akzeptierens eines Standardworts nach einem ersten explizit eingegebenen Buchstaben.

6. Die Vorrichtung gemäß Anspruch 1, bei der die wiedergewonnenen, gespeicherten Wörter zur Anzeige gemäß einer vorbestimmten Priorität geordnet sind.

7. Die Vorrichtung gemäß Anspruch 1, wobei die Explizit-Schriftzeichen-Filtersoftware ferner eine Einrichtung zum Aufbauen zumindest eines Worts um zumindest einen Begrenzungsbuchstaben aufweist, wobei der zumindest eine Begrenzungsbuchstabe ein explizit oder mehrdeutig eingegebener Buchstabe oder ein Buchstabe aus einem vorbestimmten Satz aus Buchstaben ist.

8. Die Vorrichtung gemäß Anspruch 7, bei der die Einrichtung zum Aufbauen zumindest eines Wortes um den zumindest einen Begrenzungsbuchstaben ferner eines oder eine beliebige Kombination aus Folgenden aufweist:
einer Einrichtung zum Interpretieren durch Abgleichen von Wörtern, die explizit eingegebene Buchstaben umfassen, für eine bestimmte Sequenz;
einer Einrichtung zum Interpretieren durch Abgleichen von Wörtern, die ein oder mehrere Wörter umfassen, die mit mehrdeutigen Tasten übereinstimmen, die dem zumindest einen Begrenzungsbuchstaben vorangehen;
einer Einrichtung zum Interpretieren durch Abgleichen von Wörtern, die ein oder mehrere Wörter umfassen, die mit mehrdeutigen Tasten übereinstimmen, die mit dem zumindest einen Begrenzungsbuchstaben enden;
einer Einrichtung zum Interpretieren zum Abgleichen von Wörtern, die ein oder mehrere Wörter umfassen, die mit dem zumindest einen Begrenzungsbuchstaben beginnen; und
einer Einrichtung zum Interpretieren durch Abgleichen von Wörtern, die ein oder mehrere Wörter umfassen, die auf den zumindest einen Begrenzungsbuchstaben folgen.

9. Die Vorrichtung gemäß Anspruch 7, bei der die Einrichtung zum Aufbauen zumindest eines Wortes um das zumindest eine Begrenzungsschriftzeichen betätigt wird, indem eine nächste Taste gedrückt wird, um einen nächsten Satz aus Ergebnissen aus mehreren Suchvorgängen in der Wortdatenbank zu erhalten.

10. Die Vorrichtung gemäß Anspruch 1, wobei die Explizit-Schriftzeichen-Filtersoftware ferner eine Einrichtung zum Stamm-Verriegeln aufweist, wobei das Stamm-Verriegeln ein Markieren einer oder mehrerer Teilzeichenfolgen innerhalb einer Schriftzeichensequenz als explizit eingegeben aufweist, so dass ein Neuinterpretieren der einen oder mehreren Teilzeichenfolgen unnötig wird.

11. Die Vorrichtung gemäß Anspruch 10, wobei die Einrichtung zum Stamm-Verriegeln ferner eines oder eine beliebige Kombination aus Folgenden aufweist:
einem Voll-Nächstes-Verriegelungsmechanismus, bei dem eine nächste Taste eine der einen oder mehreren Buchstabenserien verriegelt;
einer unbegrenzten Verriegelung durch Bewegen des Cursors über eine der einen oder mehreren Buchstabenserien durch Verwenden einer Pfeiltaste;
einer Einrichtung zum Verwenden von vorangehend explizit eingegebenen Buchstaben, die einer aktuellen mehrdeutigen Tastensequenz vorangehen, durch Abgleichen von Wörtern in der Datenbank, wobei die Wörter mit den explizit eingegebenen Buchstaben beginnen und mit der mehrdeutig eingegebenen Tastensequenz übereinstimmen;
einer Einrichtung zum Vorschlagen von Wortvervollständigungen;
einer Einrichtung zum Ermöglichen, dass eine Taste gedrückt wird, die einem Funktionsverriegeln zuzuweisen ist, wie zum Beispiel eine OK- oder Auswahl-Taste;
einer Einrichtung zum Ermöglichen, dass eine entsprechende Pfeiltaste gedrückt wird, um eine angebotene Wortvervollständigung zu verriegeln;
einem Mechanismus für eine Hierarchie aus Verriegelungen, wobei eine Aktivierung einer ersten Steuerung einen Stamm erster Wahl verriegelt und eine Aktivierung einer zweiten Steuerung Stämme verriegelt, die auf den Stamm erster Wahl folgen; und
einer Einrichtung zum Erzeugen von Wörtern, die nicht in der Wortdatenbank gespeichert sind, wobei eine oder mehrere wahrscheinliche Übereinstimmungen für zumindest einen Teilsatz eines eingegebenen Stamms gefunden werden, wobei zumindest ein Teil des eingegebenen Stamms verriegelt wurde und wobei eine Auswahl aus der einen oder den mehreren wahrscheinlichen Übereinstimmungen mit dem verriegelten Teil des Stamms kombiniert wird, um ein Wort zu erzeugen, dass nicht in der Wortdatenbank gespeichert ist.

12. Die Vorrichtung gemäß Anspruch 11, bei der der Voll-Nächstes-Vernegelungsmechanismus ferner eine Einrichtung zum Identifizieren und Verwenden zumindest einer Wortgrenze, um einen Stamm zu verriegeln, aufweist, wobei die zumindest eine Wortgrenze aus einer oder mehreren Aktionen abgeleitet wird, die ein Wortende anzeigen, und wobei eine Schriftzeichensequenz, die einer identifizierten Wortgrenze vorangeht, verriegelt wird.

13. Ein Verfahren zum Filtern einer mehrdeutigen Texteingabe basierend auf zumindest einem explizit eingegebenen Schriftzeichen in der mehrdeutigen Texteingabe, wobei das Verfahren folgende Schritte aufweist:
Bereitstellen einer Tastatur (54) und einer Anzeige (53), die jeweils mit einem Prozessor (100) durch eine geeignete Schnittstellenschaltungsanordnung gekoppelt sind, wobei der Prozessor (100) die Texteingabe von der Tastatur (54) empfängt und ausgegebene Wörter zu der Anzeige (53) bringt, wobei ansprechend auf die Texteingabe verschiedene Tastenanschlaginterpretationen angezeigt werden, um einem Benutzer beim Auflösen jeglicher Mehrdeutigkeit zu helfen; und
Bereitstellen eines Speichers (104), der mit dem Prozessor (100) gekoppelt ist, wobei der Speicher (104) folgende Merkmale aufweist:
ein Betriebssystem (106);
eine Vereindeutigungssoftware (108);
Explizit-Schriftzeichen-Filterung in einer Mehrdeutige-Texteingabe-Software (110); und
eine Wortdatenbank, wobei die mehrdeutige Texteingabe eine Tastenanschlagsequenz aufweist, die eine Sequenz aus Buchstaben darstellt, wobei mehrdeutige Buchstaben in der Sequenz aus Buchstaben auf Anschlägen von Tasten, die mehrere Bedeutungen aufweisen, basieren;
wobei das Verfahren **dadurch gekennzeichnet ist, dass**:
ein expliziter Buchstabe in der Sequenz aus Buchstaben explizit an einer spezifischen Position in der Sequenz aus Buchstaben durch Eingeben eines expliziten Buchstabens eingegeben wird, wobei nur gespeicherte Wörter aus der Wortdatenbank, die den explizit eingegebenen Buchstaben an der spezifischen Position aufweisen, zur Anzeige wiedergewonnen werden, wobei das Verfahren ferner ein Eingeben eines einzelnen expliziten Buchstabens durch eines der Folgenden aufweist:
2-Tasten-Expliziteingabe, die das Darstellen eines Satzes aus Buchstaben aufweist, die einer Taste entsprechen, nach Auswahl der Taste durch einen Benutzer, wobei eine 2-Tasten-Expliziteingabe ein Präsentieren eines Satzes aus Buchstaben, die einer Taste entsprechen, nach Auswahl der Taste durch einen Nutzer sowie eine Auswahl eines gewünschten Buchstabens aus dem präsentierten Satz aus Buchstaben durch den Benutzer aufweist;
Langes Drücken einer Taste zum Anzeigen und zyklischen Durchlaufen einer Buchstabensequenz;
Wechseln in einen Mehrfachantipp-Modus und wiederholtes Drücken einer Taste, um einen Buchstaben explizit einzugeben;
Verwenden von Multischaltertasten, wodurch eine mehrdeutige Eingabe bei einem einfachen Drücken und eine explizite Buchstabeneingabe bei einer anderen Art von Drücken ermöglicht wird;
Mehrtastenbetätigung durch gleichzeitiges Drücken von mehr als einer Taste, wobei eine primäre Taste einen mehrdeutigen Satz aus Buchstaben anzeigt und eine sekundäre Taste anzeigt, welcher Buchstabe in dem Satz ausgewählt werden soll; und
Verwenden einer programmierbaren, frei belegbaren Taste als sekundäres Mittel zum Anbieten eines Buchstabens, der einer Taste zugewiesen ist, basierend auf einer Analyse des wahrscheinlichsten Buchstabens, der einem vorangehenden Tastenanschlag zugeordnet ist.

14. Das Verfahren gemäß Anspruch 13, das ferner ein Bereitstellen einer Sprachsynthesesoftware und eines Lautsprecher als Kommunikationsunterstützung umfasst.

15. Das Verfahren gemäß Anspruch 13, bei dem die 2-Tasten-Expliziteingabe eines der Folgenden verwendet:
eine Matrixanzeige;
ein Etikett, das einen Teilsatz von vorbestimmten Sätzen aus zugeordneten Buchstaben umfasst; und
eine Scroll-Liste.

16. Das Verfahren gemäß Anspruch 13, bei dem das lange Drücken, nachdem die Buchstabensequenz angezeigt ist, ferner eines der Folgenden aufweist:
Hervorheben eines nächsten Buchstaben in der Buchstabensequenz jedes zusätzliche Mal, wenn die Taste gedrückt wird, was endet, nachdem ausreichend Zeit zwischen einem Tastendruck und dem nächsten verstrichen ist oder wenn eine andere Taste gedrückt wird; und
Hervorheben eines nächsten Buchstaben in der Buchstabensequenz jedes Mal, wenn eine Pfeiltaste oder ein Scrollrad aktiviert wird.

17. Das Verfahren gemäß Anspruch 13, wobei die Explizit-Schriftzeichen-Filtersoftware ferner Folgendes aufweist:
Abgleichen der Wörter in der Datenbank mit explizit eingegebenen Buchstaben und mehrdeutig eingegebenen Buchstaben statt eines Akzeptierens eines Standardworts nach einem ersten explizit eingegebenen Buchstaben.

18. Das Verfahren gemäß Anspruch 13, bei dem die wiedergewonnenen, gespeicherten Wörter zur Anzeige gemäß einer vorbestimmten Priorität geordnet sind.

19. Das Verfahren gemäß Anspruch 13, wobei die Explizit-Schriftzeichen-Filtersoftware ferner ein Aufbauen zumindest eines Worts um zumindest einen Begrenzungsbuchstaben aufweist, wobei der zumindest eine Begrenzungsbuchstabe ein explizit oder mehrdeutig eingegebener Buchstabe oder ein Buchstabe aus einem vorbestimmten Satz aus Buchstaben ist.

20. Das Verfahren gemäß Anspruch 19, bei dem das Aufbauen zumindest eines Wortes um den zumindest einen Begrenzungsbuchstaben ferner eines oder eine beliebige Kombination aus Folgenden aufweist:
Interpretieren durch Abgleichen von Wörtern, die explizit eingegebene Buchstaben umfassen, für eine bestimmte Sequenz;
Interpretieren durch Abgleichen von Wörtern, die ein oder mehrere Wörter umfassen, die mit mehrdeutigen Tasten übereinstimmen, die dem zumindest einen Begrenzungsbuchstaben vorangehen;
Interpretieren durch Abgleichen von Wörtern, die ein oder mehrere Wörter umfassen, die mit mehrdeutigen Tasten übereinstimmen, die mit dem zumindest einen Begrenzungsbuchstaben enden;
Interpretieren zum Abgleichen von Wörtern, die ein oder mehrere Wörter umfassen, die mit dem zumindest einen Begrenzungsbuchstaben beginnen; und
Interpretieren durch Abgleichen von Wörtern, die ein oder mehrere Wörter umfassen, die auf den zumindest einen Begrenzungsbuchstaben folgen.

21. Das Verfahren gemäß Anspruch 19, bei dem das Aufbauen zumindest eines Wortes um das zumindest eine Begrenzungsschriftzeichen betätigt wird, indem eine nächste Taste gedrückt wird, um einen nächsten Satz aus Ergebnissen aus mehreren Suchvorgängen in der Wortdatenbank zu erhalten.

22. Das Verfahren gemäß Anspruch 13, wobei die Explizit-Schriftzeichen-Filtersoftware ferner ein Stamm-Verriegeln aufweist, wobei das Stamm-Verriegeln ein Markieren einer oder mehrerer Teilzeichenfolgen innerhalb einer Schriftzeichensequenz als explizit eingegeben aufweist, so dass ein Neuinterpretieren der einen oder mehreren Teilzeichenfolgen unnötig wird.

23. Das Verfahren gemäß Anspruch 22, wobei das Stamm-Verriegeln ferner eines oder eine beliebige Kombination aus Folgenden aufweist:
Bereitstellen eines Voll-Nächstes-Verriegelungsmechanismus, bei dem eine nächste Taste eine der einen oder mehreren Buchstabenserien verriegelt;
Bereitstellen einer unbegrenzten Verriegelung durch Bewegen des Cursors über eine der einen oder mehreren Buchstabenserien durch Verwenden einer Pfeiltaste;
Verwenden von vorangehend explizit eingegebenen Buchstaben, die einer aktuellen mehrdeutigen Tastensequenz vorangehen, durch Abgleichen von Wörtern in der Datenbank, wobei die Wörter mit den explizit eingegebenen Buchstaben beginnen und mit der mehrdeutig eingegebenen Tastensequenz übereinstimmen;
Vorschlagen von Wortvervollständigungen;
Ermöglichen, dass eine Taste gedrückt wird, die einem Funktionsverriegeln zuzuweisen ist, wie zum Beispiel eine OK- oder Auswahl-Taste;
Ermöglichen, dass eine entsprechende Pfeiltaste gedrückt wird, um eine angebotene Wortvervollständigung zu verriegeln;
Bereitstellen eines Mechanismus für eine Hierarchie aus Verriegelungen, wobei eine Aktivierung einer ersten Verriegelung einen Stamm erster Wahl verriegelt und eine Aktivierung einer zweiten Verriegelung Stämme verriegelt, die auf den Stamm erster Wahl folgen; und
Erzeugen von Wörtern, die nicht in der Wortdatenbank gespeichert sind, wobei eine oder mehrere wahrscheinliche Übereinstimmungen für einen verriegelten Stamm gefunden werden, und wobei eine Auswahl aus der einen oder den mehreren wahrscheinlichen Übereinstimmungen mit einer zweiten Tastenanschlagsequenz kombiniert wird, um ein Wort zu erzeugen, dass nicht in der Wortdatenbank gespeichert ist.

24. Das Verfahren gemäß Anspruch 23, wobei der Voll-Nächstes-Verriegelungsmechanismus ferner ein Identifizieren und Verwenden zumindest einer Wortgrenze, um einen Stamm zu verriegeln, aufweist, wobei die zumindest eine Wortgrenze aus einer oder mehreren Interaktionen abgeleitet wird, die ein Wortende anzeigen, und wobei ein Stamm, der einer identifizierten Wortgrenze vorangeht, verriegelt wird.

## Revendications

1. Appareil de filtrage d'une entrée de texte ambigüe sur base d'au moins un caractère entré explicitement dans ladite entrée de texte ambigüe, ledit appareil comprenant:
un clavier (54) et un écran d'affichage (53) couplés, chacun, à un processeur (100) au moyen de circuits d'interface appropriés, où ledit processeur (100) reçoit l'entrée de texte dudit clavier (54) et gère les mots de sortie vers ledit écran d'affichage (53), où, en réponse à ladite entrée de texte, différentes interprétations de frappe sur une touche sont affichées pour aider un utilisateur à résoudre toute ambigüité;
une mémoire (104) couplée audit processeur (100), où ladite mémoire (104) comprend:
un système d'exploitation (106);
un logiciel d'élimination d'ambigüité (108);
un logiciel de filtrage de caractère explicite dans une entrée de texte ambigüe (110); et
une base de données de mots,
où l'entrée de texte ambigüe comprend une séquence de frappes sur une touche représentant une séquence de lettres, où les lettres ambigües dans la séquence de lettres sont basées sur des frappes sur des touches ayant de multiples significations et où une lettre explicite dans la séquence de lettres est explicitement entrée à une position spécifique dans la séquence de lettres par un moyen pour entrer une lettre explicite;
**caractérisé par le fait que**:
seuls des mots mémorisés de ladite base de données de mots présentant ladite lettre entrée explicitement à la position spécifique sont rappelées pour affichage, où ledit moyen pour entrer une lettre explicite est configuré pour entrer une lettre explicite par l'un ou l'autre parmi:
une entrée explicite à deux touches comprenant le fait de présenter un ensemble de lettres correspondant à une touche après sélection de la touche par un utilisateur et sélection d'une lettre désirée de l'ensemble de lettres présenté par l'utilisateur;
une pression longue sur une touche, pour afficher et parcourir une séquence de lettres;
changer à un mode de frappe multiple et appuyer de manière répétée sur une touche, pour entrer une lettre explicitement;
utiliser une touche de commutation multiple qui peut être enfoncée de multiples manières, permettant ainsi une entrée ambigüe à un premier type de pression et une entrée de lettre explicite à un type différent de pression;
accorder en appuyant simultanément sur plus d'une touche, avec une touche primaire indiquant un ensemble de lettres ambigu et une touche secondaire indiquant la lettre dans l'ensemble qu'il y a lieu de sélectionner; et
utiliser une touche douce programmable configurée pour offrir une lettre attribuée à une touche sur base de l'analyse de la lettre la plus probable associée à une frappe sur une touche précédente.

2. Appareil selon la revendication 1, comprenant par ailleurs un logiciel de synthèse de parole et un haut-parleur comme assistant de communication.

3. Appareil selon la revendication 1, dans lequel ladite entrée explicite à deux touches utilise l'un ou l'autre parmi:
un affichage en matrice;
une étiquette comportant un sous-ensemble d'ensembles prédéterminés de lettres associées; et
une liste défilante.

4. Appareil selon la revendication 1, ladite pression longue comprenant par ailleurs, après que soit affichée ladite séquence de lettres, l'un ou l'autre parmi:
une lettre suivante dans ladite séquence de lettres est mise en évidence chaque fois additionnel qu'il est appuyé sur ladite touche, en se terminant après que soit écoulé un temps suffisant entre un appui sur une touche et le suivant ou lorsqu'il est appuyé sur une touche différente; et
une lettre suivante dans ladite séquence de lettres est mise en évidence chaque fois qu'est activée l'une parmi une touche à flèche et une roue de défilement.

5. Appareil selon la revendication 1, ledit logiciel de filtrage de caractère explicite comprenant par ailleurs:
un moyen pour mettre en correspondance lesdits mots dans ladite base de données avec des lettres entrées explicitement et des lettres entrées de manière ambigüe plutôt que d'accepter un mot par défaut à une première lettre entrée explicitement.

6. Appareil selon la revendication 1, dans lequel lesdits mots mémorisés rappelés sont ordonnés pour affichage selon une priorité prédéterminée.

7. Appareil selon la revendication 1, ledit logiciel de filtrage de caractère explicite comprenant par ailleurs un moyen pour construire au moins un mot autour d'au moins une lettre de délimitation, où ladite au moins une lettre de délimitation est une lettre entrée explicitement ou de manière ambigüe, ou une lettre d'un ensemble prédéterminé de lettres.

8. Appareil selon la revendication 7, dans lequel ledit moyen pour construire au moins un mot autour d'au moins une lettre de délimitation comprend par ailleurs l'un ou l'autre parmi ou toute combinaison de:
un moyen pour interpréter en mettant en correspondance des mots qui incluent des lettres entrées explicitement pour une séquence particulière;
un moyen pour interpréter en mettant en correspondance des mots qui incluent un ou plusieurs mots qui coïncident avec des touches ambigües qui précèdent ladite au moins une lettre de délimitation;
un moyen pour interpréter en mettant en correspondance des mots qui incluent un ou plusieurs mots qui coïncident avec des touches ambigües qui se terminent par ladite au moins une lettre de délimitation;
un moyen pour interpréter en mettant en correspondance des mots qui incluent un ou plusieurs mots qui commencent par ladite au moins une lettre de délimitation; et
un moyen pour interpréter en mettant en correspondance des mots qui incluent un ou plusieurs mots qui suivent ladite au moins une lettre de délimitation.

9. Appareil selon la revendication 7, dans lequel ledit moyen pour construire au moins un mot autour d'au moins un caractère de délimitation est actionné en appuyant sur une touche suivante, pour obtenir un ensemble suivant de résultats de multiples recherches dans ladite base de données de mots.

10. Appareil selon la revendication 1, ledit logiciel de filtrage de caractère explicite comprenant par ailleurs un moyen pour bloquer des souches, dans lequel ledit blocage de souches comprend le fait de marquer un ou plusieurs sous-ensembles dans une séquence de caractères entré explicitement de sorte qu'une réinterprétation desdits un ou plusieurs sous-ensembles soit rendu non nécessaire.

11. Appareil selon la revendication 10, ledit moyen pour bloquer des souches comprenant par ailleurs l'un ou l'autre parmi ou toute combinaison de:
un mécanisme de blocage suivant complet, où une touche suivante bloque l'une desdites une ou plusieurs séries de lettres;
blocage illimité en déplaçant le curseur sur l'une desdites une ou plusieurs séries de lettres à l'aide d'une touche à flèche;
un moyen pour utiliser des lettres entrées explicitement auparavant précédant une séquence de touches ambigües actuelle en mettant en correspondance des mots dans ladite base de données, où lesdits mots commencent par lesdites lettres entrées explicitement et coïncident avec ladite séquence de touches entrée de manière ambigüe;
un moyen de suggestion de complétion de mot;
un moyen pour permettre d'appuyer sur une touche à attribuer à un blocage en fonctionnement, telle qu'une touche OK ou Select;
un moyen pour permettre d'appuyer sur une touche à flèche appropriée pour bloquer une complétion de mot proposée;
un mécanisme pour une hiérarchie de blocages, où l'activation d'une première commande bloque une souche de premier choix et l'activation d'une deuxième commande bloque des souches après ladite souche de premier choix; et
un moyen pour générer des mots non mémorisés dans ladite base de données de mots, où une ou plusieurs coïncidences probables sont trouvées pour au moins un sous-ensemble d'une souche entrée, au moins une partie de ladite souche entrée ayant été bloquée et où une sélection parmi lesdites une ou plusieurs coïncidences possibles est combinée avec ladite partie bloquée de ladite souche, pour générer un mot non mémorisé dans ladite base de données de mots.

12. Appareil selon la revendication 11, ledit mécanisme de blocage suivant complet comprenant par ailleurs un moyen pour identifier et utiliser au moins une limite de mot pour bloquer une souche, où ladite au moins une limite de mot est inférée d'une ou plusieurs actions indiquant une fin de mot et où une séquence de caractères précédant une limite de mot identifiée est bloquée.

13. Procédé pour filtrer une entrée de texte ambigüe sur base d'au moins un caractère entré explicitement dans ladite entrée de texte ambigüe, ledit procédé comprenant:
prévoir un clavier (54) et un écran d'affichage (53) couplés, chacun, à un processeur (100) au moyen de circuits d'interface appropriés, où ledit processeur (100) reçoit l'entrée de texte dudit clavier (54) et gère les mots de sortie vers ledit écran d'affichage (53), où, en réponse à ladite entrée de texte, différentes combinaisons de frappe sur une touche sont affichées pour aider un utilisateur à résoudre toute ambigüité; et
prévoir une mémoire (104) couplée audit processeur (100), où ladite mémoire (104) comprend:
un système d'exploitation (106);
un logiciel d'élimination d'ambigüité (108);
un logiciel de filtrage de caractère explicite dans une entrée de texte ambigüe (110); et
une base de données de mots, où l'entrée de texte ambigüe comprend une séquence de frappes sur une touche représentant une séquence de lettres, où les lettres ambigües dans la séquence de lettres sont basées sur des frappes sur des touches ayant de multiples significations;
ledit procédé étant **caractérisé par le fait que**:
une lettre explicite dans la séquence de lettres est explicitement entrée à une position spécifique dans la séquence de lettres, où seuls des mots mémorisés de ladite base de données de mots présentant ladite lettre entrée explicitement à la position spécifique sont rappelées pour affichage, comprenant par ailleurs le fait d'entrer une seule lettre explicite par l'un ou l'autre parmi:
une entrée explicite par deux touches comprenant le fait de présenter un ensemble de lettres correspondant à une touche après sélection de la touche par un utilisateur, une entrée explicite par deux touches comprenant le fait de présenter un ensemble de lettres correspondant à une touche après sélection de la touche par un utilisateur et sélection d'une lettre désirée de l'ensemble de lettres présenté par l'utilisateur;
une pression longue sur une touche, pour afficher et parcourir une séquence de lettres;
changer à un mode de frappe multiple et appuyer de manière répétée sur une touche, pour entrer une lettre explicitement;
utiliser des touches de commutation multiple, permettant ainsi une entrée ambigüe à une pression simple et une entrée de lettre explicite à un type différent de pression;
accorder en appuyant simultanément sur plus d'une touche, avec une touche primaire indiquant un ensemble de lettres ambigu et une touche secondaire indiquant la lettre dans l'ensemble qu'il y a lieu de sélectionner; et
utiliser une touche douce programmable comme moyen secondaire pour offrir une lettre attribuée à une touche sur base de l'analyse de la lettre la plus probable associée à une frappe sur une touche précédente.

14. Procédé selon la revendication 13, comprenant par ailleurs le fait de prévoir un logiciel de synthèse de parole et un haut-parleur comme assistant de communication.

15. Procédé selon la revendication 13, dans lequel l'entrée à deux touches utilise l'un ou l'autre parmi:
un affichage en matrice;
une étiquette comportant un sous-ensemble d'ensembles prédéterminés de lettres associées; et
une liste défilante.

16. Procédé selon la revendication 13, ledit appui long comprenant par ailleurs, après que soit affichée ladite séquence de lettres, l'un ou l'autre parmi:
mettre en évidence une lettre suivante dans ladite séquence de lettres chaque fois additionnelle qu'il est appuyé sur ladite touche, se terminant après que soit écoulé un temps suffisant entre un appui sur la touche et le suivant ou lorsqu'on appuie sur une touche différente; et
mettre en évidence une lettre suivante dans ladite séquence de lettres chaque fois qu'est activée l'une parmi une touche à flèche et une roue de défilement.

17. Procédé selon la revendication 13, ledit logiciel de filtrage de caractère explicite comprenant par ailleurs:
mettre en correspondance lesdits mots dans ladite base de données avec les lettres entrées explicitement et les lettres entrées de manière ambigüe, plutôt que d'accepter un mot par défaut à une première lettre entrée explicitement.

18. Procédé selon la revendication 13, dans lequel lesdits mots mémorisés rappelés sont ordonnés pour affichage selon une priorité prédéterminée.

19. Procédé selon la revendication 13, ledit logiciel de filtrage de caractère explicite comprenant par ailleurs le fait de construire au moins un mot autour d'au moins une lettre de délimitation, où ladite au moins une lettre de délimitation est une lettre entrée explicitement ou de manière ambigüe, ou une lettre d'un ensemble prédéterminé de lettres.

20. Procédé selon la revendication 19, dans lequel ladite construction d'au moins un mot autour d'au moins une lettre de délimitation comprend par ailleurs l'un ou l'autre parmi ou toute combinaison de:
interpréter en mettant en correspondance des mots qui incluent des lettres entrées explicitement pour une séquence particulière;
interpréter en mettant en correspondance des mots qui incluent un ou plusieurs mots qui coïncident avec des touches ambigües qui précèdent ladite au moins une lettre de délimitation;
interpréter en mettant en correspondance des mots qui incluent un ou plusieurs mots qui coïncident av4ec des touches ambigües qui se terminent par ladite au moins une lettre de délimitation;
interpréter en mettant en correspondance des mots qui incluent un ou plusieurs mots qui commencent par ladite au moins une lettre de délimitation; et
interpréter en mettant en correspondance des mots qui incluent un ou plusieurs mots qui suivent ladite au moins une lettre de délimitation.

21. Procédé selon la revendication 19, dans lequel ladite construction d'au moins un mot autour d'au moins un caractère de délimitation est actionné en appuyant sur une touche suivante, pour obtenir un ensemble suivant de résultats de multiples recherches dans ladite base de données de mots.

22. Procédé selon la revendication 13, ledit logiciel de filtrage de caractère explicite comprenant par ailleurs le blocage de souches, dans lequel ledit blocage de souches comprend le fait de marquer un ou plusieurs sous-ensembles dans une séquence de caractères entré explicitement de sorte qu'une réinterprétation desdits un ou plusieurs sous-ensembles soit rendu non nécessaire.

23. Procédé selon la revendication 22, ledit blocage de souches comprenant par ailleurs l'un ou l'autre parmi ou toute combinaison de:
prévoir un mécanisme de blocage suivant complet, où la touche suivante bloque l'une desdites une ou plusieurs séries de lettres;
prévoir le blocage illimité en déplaçant le curseur sur l'une desdites une ou plusieurs séries de lettres à l'aide d'une touche à flèche;
utiliser des lettres entrées explicitement auparavant précédant une séquence de touches ambigües actuelle en mettant en correspondance des mots dans ladite base de données, où lesdits mots commencent par lesdites lettres entrées explicitement et coïncident avec ladite séquence de touches entrée de manière ambigüe;
suggérer des complétions de mot;
permettre d'appuyer sur une touche à attribuer à un blocage en fonctionnement, telle qu'une touche OK ou Select;
permettre d'appuyer sur une touche à flèche appropriée pour bloquer une complétion de mot proposée;
prévoir un mécanisme pour une hiérarchie de blocages, où l'activation d'un premier blocage bloque une souche de premier choix et l'activation d'un deuxième blocage bloque des souches après ladite souche de premier choix; et
générer des mots non mémorisés dans ladite base de données de mots, où une ou plusieurs coïncidences probables sont trouvées pour une souche bloquée et où une sélection parmi lesdites une ou plusieurs coïncidences possibles est combinée avec une deuxième séquence de frappes sur une touche, pour générer un mot non mémorisé dans ladite base de données de mots.

24. Procédé selon la revendication 23, ledit mécanisme de blocage suivant complet comprenant par ailleurs l'identification et l'utilisation d'au moins une limite de mot pour bloquer une souche, où ladite au moins une limite de mot est inférée d'une ou plusieurs interactions indiquant une fin de mot et où une souche précédant une limite de mot identifiée est bloquée.
